# EUROPEAN PATENT SPECIFICATION

(11) **EP 4 092 704 B1**
(45) Date of publication and mention of the grant of the patent: **09.07.2025**
(21) Application number: 22174183.8
(22) Date of filing: 18.05.2022
(51) Int. Cl.: H01G 9/20, H10K 71/15, H10K 30/86, H10K 71/40

(54) **PHOTOELECTRIC CONVERSION ELEMENT AND METHOD FOR PRODUCING PHOTOELECTRIC CONVERSION ELEMENT, PHOTOELECTRIC CONVERSION MODULE, AND ELECTRONIC DEVICE**
FOTOELEKTRISCHES UMWANDLUNGSELEMENT UND VERFAHREN ZUM PRODUZIEREN EINES FOTOELEKTRISCHEN UMWANDLUNGSELEMENTS, FOTOELEKTRISCHES UMWANDLUNGSMODUL UND ELEKTRONISCHE VORRICHTUNG
ÉLÉMENT DE CONVERSION PHOTOÉLECTRIQUE ET PROCÉDÉ DE FABRICATION D'ÉLÉMENT DE CONVERSION PHOTOÉLECTRIQUE, MODULE DE CONVERSION PHOTOÉLECTRIQUE, ET DISPOSITIF ÉLECTRONIQUE

(30) Priority: 20.05.2021 JP 2021085065; 31.03.2022 JP 2022059246
(43) Date of publication of application: 23.11.2022
(73) Proprietor: Ricoh Company, Ltd., Tokyo 143-8555 (JP)
(72) Inventor: TAMOTO, Nozomu, Tokyo 143-8555 (JP); TANAKA, Yuuji, Tokyo 143-8555 (JP); KANEI, Naomichi, Tokyo 143-8555 (JP); TANAKA, Masato, Tokyo 143-8555 (JP)
(74) Representative: Marks & Clerk LLP

(56) References cited:
- WO-A1-2020/158876
- JP-A- 2013 020 830
- US-A1- 2018 198 083
- TADAS MALINAUSKAS ET AL: "Enhancing Thermal Stability and Lifetime of Solid-State Dye-Sensitized Solar Cells via Molecular Engineering of the Hole-Transporting Material Spiro-OMeTAD", APPLIED MATERIALS & INTERFACES, vol. 7, no. 21, 8 May 2015 (2015-05-08), US, pages 11107 - 11116, XP055500952, ISSN: 1944-8244, DOI: 10.1021/am5090385

## Description

### BACKGROUND OF THE INVENTION

### Field of the Invention

The present disclosure relates to a photoelectric conversion element and a method for producing a photoelectric conversion element, a photoelectric conversion module, and an electronic device.

### Description of the Related Art

In recent years, solar battery cells that can efficiently generate electric power with low intensity of illumination have been attracted attention. Solar battery cells are expected to be widely used as self-harvesting power supplies that do not require replacement of batteries or installation of power supply wiring, as well as application thereof regardless of installation locations.

As photoelectric conversion elements for indoor use, for example, amorphous silicon-based solar battery cells and organic solar battery cells have been known. Among the organic solar battery cells, dye-sensitized solar battery cells are advantageous because a dye-sensitized solar battery cell are composed of separate layers each having charge generation capability and charge transportation capability, which can realize high output, and such dye-sensitized solar battery cell can be easily produced.

Conventionally, a dye-sensitized solar battery cell encapsulates an electrolytic solution and therefore has a problem of evaporation or leakage of the solution. In recent years, however, solid dye-sensitized solar battery cells using a p-type semiconductor material have been recently developed, and production processes thereof have been simplified even more. Moreover, a perovskite solar battery cell, which is a hybrid of organic and inorganic materials, has a high conversion efficiency similar to that of a silicon-based solar battery cell in the art, and can be easily produced. Therefore, the perovskite solar battery cell has attracted the strong interest in the art.

Photoelectric conversion elements that can be used for solar cells aim at achieving high output in high temperature environments or environments with weak indoor light. For example, proposed is a photoelectric conversion element, which includes a first electrode, an electron-transporting layer including a photosensitization compound, a hole-transporting layer, and a second electrode, where the hole-transporting layer includes a pyridine compound A, and an ionic compound B (see, for example, Japanese Unexamined Patent Application Publication No. 2018-113305). Further reference may be made to disclosures of photoelectric conversion elements and materials in WO 2020/158876 A1, US 2018/198083 A1, JP 2013 020830 A and Tadas Malinauskas et al., Applied Materials & Interfaces, 2015, vol.7, no.21, p11107-11116.

### SUMMARY OF THE INVENTION

According to one aspect of the present disclosure, a photoelectric conversion element includes a first electrode, a photoelectric conversion layer, and a second electrode. The photoelectric conversion layer includes a hole-transporting layer. The hole-transporting layer includes lithium salt having an asymmetric structure, and an amount of a solvent per unit volume of the hole-transporting layer is 5.4 to 30 µg/mm³.

### BRIEF DESCRIPTION OF THE DRAWINGS

FIG. 1 is a schematic view illustrating one example of the photoelectric conversion element of the first embodiment;
FIG. 2 is a schematic view illustrating one example of the photoelectric conversion element of the second embodiment;
FIG. 3 is a schematic view illustrating one example of the photoelectric conversion element of the third embodiment;
FIG. 4 is a schematic view illustrating one example of the photoelectric conversion module of the fourth embodiment;
FIG. 5 is a schematic view illustrating one example of the photoelectric conversion module of the fifth embodiment;
FIG. 6 is a black diagram of a mouse for a personal computer as an example of the electronic device of the present disclosure;
FIG. 7 is a schematic external view illustrating an example of the mouse of FIG. 6;
FIG. 8 is a block diagram of a keyboard for a personal computer as an example of the electronic device of the present disclosure;
FIG. 9 is a schematic external view illustrating an example of the keyboard of FIG. 8;
FIG. 10 is a schematic external view illustrating another example of the keyboard of FIG. 8;
FIG. 11 is a block diagram of a sensor as an example of the electronic device of the present disclosure;
FIG. 12 is a block diagram of a turntable as an example of the electronic device of the present disclosure;
FIG. 13 is a block diagram illustrating an example of the electronic device of the present disclosure;
FIG. 14 is a block diagram illustrating an example of the electronic device of FIG. 13, into which a power supply IC is incorporated;
FIG. 15 is a block diagram illustrating an example of the electronic device of FIG. 14, into which an electricity storage device is further incorporated;
FIG. 16 is a block diagram illustrating an example of the power supply module of the present disclosure;
FIG. 17 is a block diagram illustrating an example of the power supply module of FIG. 16, into which an electricity storage device is further incorporated; and
FIG. 18 is a graph depicting an example of an X-ray absorption fine structure (XAFS) spectrum measured by using the photoelectric conversion module of Example 1.

### DESCRIPTION OF THE EMBODIMENTS

The present disclosure has an object to provide a photoelectric conversion element that can achieve high output with light of low illuminance, and has excellent output retention and durability to light in any temperature environment.

The present disclosure can provide a photoelectric conversion element that can achieve high output with light of low illuminance, and has excellent output retention and durability to light in any temperature environment.

### (Photoelectric conversion element)

The photoelectric conversion element of the present disclosure includes a first electrode, a photoelectric conversion layer including a hole-transporting layer, and a second electrode. The photoelectric conversion element may further include other layers according to the necessity.

In the photoelectric conversion element of the present disclosure, the hole-transporting layer includes lithium salt having an asymmetric structure, and an amount of a solvent per unit volume of the hole-transporting layer is 5.4 to 30 µg/mm³.

The present inventors have found that durability of the photoelectric conversion element to light may be deteriorated when a solvent used for forming a hole-transporting layer of the photoelectric conversion element is remained by more than a certain amount after production of the photoelectric conversion element.

In the present specification, the term "photoelectric conversion element" means an element configured to convert photoenergy into electric energy or an element configured to electric energy into photoenergy. Specific examples thereof include a solar battery cell, and a photodiode.

In the present disclosure, the term "layer" indicates a single film (single layer) as well as a structure where a plurality of films are laminated.

Moreover, the term "laminating direction" means a vertical direction relative to a planar direction of each layer of the photoelectric conversion element. The term "connect" means not only a physical connection, but also an electric connection by which an effect of the present disclosure can be exhibited.

The photoelectric conversion element of the present disclosure includes a first electrode, a photoelectric conversion layer, and a second electrode, where the photoelectric conversion layer includes at least a hole-transporting layer. The photoelectric conversion element may further include other members, such as a first substrate, a second substrate, a hole-blocking layer, and a sealing member, according to the necessity.

### <First substrate>

A shape, structure, and size of the first substrate are not particularly limited, and may be appropriately selected depending on the intended purpose.

A material of the first substrate is not particularly limited as long as the material has transparency and insolation properties, and may be appropriately selected depending on the intended purpose. Examples thereof include a substrate of glass, a plastic film, or ceramic. Among the above-listed examples, a substrate having heat resistance against a firing temperature is preferable when a step for firing is included in the process for forming an electron-transporting layer as described later. Moreover, the first substrate is more preferably a flexible substrate.

The substrate may be disposed at either or both of the outersides of the photoelectric conversion element including the first electrode side of the outerside and the second electrode side of the outerside.

The substrate disposed at the outerside of the photoelectric conversion element where the first electrode side is disposed is referred to as a first substrate, and the substrate disposed at the outerside of the photoelectric conversion element where the second electrode is disposed is referred to as a second substrate.

### <First electrode>

A shape and size of the first electrode are not particularly limited, and may be appropriately selected depending on the intended purpose.

A structure of the first electrode is not particularly limited, and may be appropriately selected depending on the intended purpose. The first electrode may have a single-layer structure, or a structure in which a plurality of materials are laminated.

A material of the first electrode is not particularly limited as long as the material is transparent to visible light and is conductive, and may be appropriately selected depending on the intended purpose. Examples thereof include transparent conductive metal oxide, carbon, and metal.

Examples of the transparent conductive metal oxide include tin-doped indium oxide (referred to as "ITO" hereinafter), fluorine-doped tin oxide (referred to as "FTO" hereinafter), antimony-doped tin oxide (referred to as "ATO" hereinafter), niobium-doped tin oxide (referred to as "NTO" hereinafter), aluminium-doped zinc oxide, indium zinc oxide, and niobium titanium oxide.

Examples of the carbon include carbon black, carbon nanotube, graphene, and fullerene.

Examples of the metal include gold, silver, aluminum, nickel, indium, tantalum, and titanium.

The above-listed examples may be used alone or in combination. Among the above-listed materials, a transparent conductive metal oxide having high transparency is preferable, and ITO, FTO, ATO, and NTO are more preferable.

The average thickness of the first electrode is not particularly limited, and may be appropriately selected depending on the intended purpose. The average thickness of the first electrode is preferably 5 nm or greater but 100 µm or less, and more preferably 50 nm or greater but 10 µm or less. When the material of the first electrode is carbon or metal, the average thickness of the first electrode is preferably the average thickness allowing the first electrode to obtain translucency or transparency.

The first electrode can be formed by any method known in the art, such as sputtering, vapor deposition, and spraying.

Moreover, the first electrode is preferably formed on the first substrate. As the first electrode, a commercially available integrated product in which a first electrode has been formed on a first substrate in advance can be used.

Examples of the commercially available integrated product include FTO-coated glass, ITO-coated glass, zinc oxide:aluminum-coated glass, FTO-coated transparent plastic films, and ITO-coated transparent plastic films. Examples of other commercially available integrated product include: a glass substrate provided with a transparent electrode where tin oxide or indium oxide is doped with a cation or an anion having a different atomic value; and a glass substrate provided with a metal electrode having such a structure that allows light to pass in the shape of a mesh or stripes.

The above-listed examples may be used alone, or two or more of the above-listed examples may be used together or laminated. Moreover, a metal lead wire may be used in combination for the purpose of reducing an electric resistance value of the first electrode.

Examples of a material of the metal lead wire include aluminum, copper, silver, gold, platinum, and nickel.

For example, the metal lead wire can be used in combination by disposing the metal lead wire on the substrate through vapor deposition, sputtering, or pressure bonding, and depositing a layer of ITO or FTO thereon.

### <Photoelectric conversion layer>

The photoelectric conversion layer includes hole-transporting layer, and may further include an electron-transporting layer according to the necessity.

The photoelectric conversion layer is composed of a single layer, or multiple layers where a plurality of layers are laminated.

### <<Hole-transporting layer>>

The hole-transporting layer is a layer capable of transporting holes (positive holes).

An embodiment of the hole-transporting layer is not particularly limited as long as the hole-transporting layer is capable of transporting holes, and may be appropriately selected depending on the intended purpose. Examples thereof include an electrolytic solution in which a redox couple is dissolved in an organic solvent, a gel electrolyte where a polymer matrix is impregnated with a liquid obtained by dissolving a redox couple in an organic solvent, a molten salt including a redox couple, a solid electrolyte, an inorganic hole-transporting material, and an organic hole-transporting material. Among the above-listed examples, a solid electrolyte is preferable, and an organic hole-transporting material is more preferable. The above-listed examples may be used alone or in combination.

The hole-transporting layer preferably includes lithium salt, and an anion in the lithium salt has an asymmetric structure. The asymmetric structure means that the left side and right side of the molecular structure of the anion are difference with the lithium ion positioned at the center. The lithium salt having an asymmetric structure is preferably lithium salt represented by General Formula (1) below.

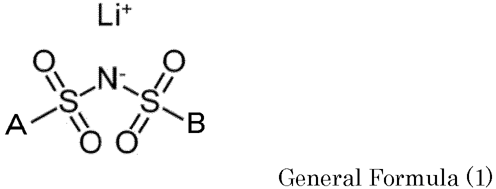

In General Formula (1), A and B are each a substituent selected from F, CF₃, C₂F₅, C₃F₇, and C₄F₉, and the substituent of A and the substituent of B are mutually different.

The present inventors have found that durability of a photoelectric conversion element to light can be significantly improved especially when the lithium salt having an asymmetric structure is included in a hole-transporting layer. The reason why the durability to light is improved is considered that solubility of the lithium salt to a solvent improves due to the asymmetric structure the lithium salt has, and therefore possibility of phase separation occurred in the hole-transporting layer is reduced.

Lithium salt having a symmetric structure contributes to form an anion-rich see-island structure to cause phase separation in the process of evaporating the solvent after forming the hole-transporting layer. The lithium salt is water soluble and has low compatibility with other components for forming a hole-transporting layer. Therefore, it is assumed that anions tend to be unevenly distributed in the hole-transporting layer. Moreover, a further reason of poor durability of a photoelectric conversion element seems to be that an amount of lithium salt added is limited due to low solubility of the lithium salt to a solvent.

The lithium salt having an asymmetric structure for use in the present disclosure has improved solubility to a solvent, and reduces a possibility to cause phase separation in a hole-transporting layer, and therefore a region of low transporting performance is reduced within the hole-transporting layer to stability hole-transporting properties. Moreover, it is considered that an amount of lithium salt to be added can be increased owing to improved solubility of the lithium salt, and therefore a synergetic effect for realizing both high output and high durability can be achieved.

The lithium salt represented by General Formula (1) is involved in transfer of charge, and excellent photoelectric conversion properties can be achieved by adding the lithium salt.

Examples of the lithium salt represented by General Formula (1) include lithium(fluorosulfonyl)(trifluoromethanesulfonyl)imide (Li-FTFSI), lithium(fluorosulfonyl)(pentafluoroethanesulfonyl)imide (Li-FPFSI), lithium(fluorosulfonyl)(nonafluorobutanesulfonyl)imide (Li-FNFSI), lithium (nonafluorobutanesulfonyl)(trifluoromethanesulfonyl)imide (Li-NFTFSI), and lithium(pentafluoroethanesulfonyl)(trifluoromethanesulfonyl)imide (Li-PFTFSI). Among the above-listed examples, lithium(fluorosulfonyl)(trifluoromethanesulfonyl)imide (Li-FTFSI) is particularly preferable.

Specific examples of the structural formulae of the lithium salt are as follows.

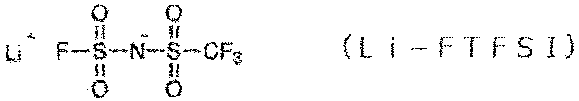

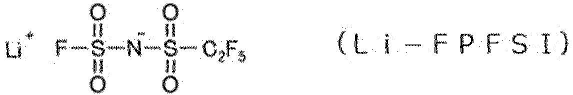

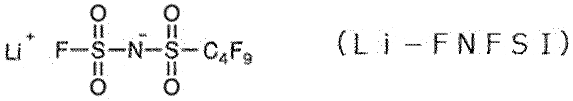

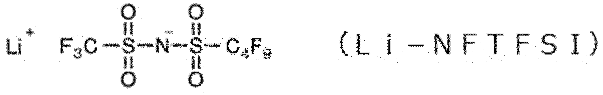

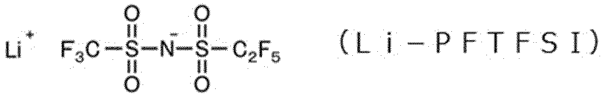

When the hole-transporting layer forming coating liquid including the lithium salt is applied, for example, the lithium salt in the formed film is not necessarily in the state of a salt where an anion and a cation are bonded, and may be in the state where the lithium cation and the anion are separated. Specifically, the present inventors have found that the lithium cations migrate into the electron-transporting layer, when the hole-transporting layer is formed with the hole-transporting layer forming coating liquid including the lithium salt, and the amount of the lithium cations included in the electron-transporting layer is greater than the amount of the lithium cation included in the hole-transporting layer. The present inventors have also found that, although part of the anions migrates, the amount of the anion included in the hole-transporting layer is greater than the amount of the anion included in the electron-transporting layer.

In the present disclosure, it is preferred that the cation and anion of the lithium salt be separated, and the cation and anion form the different distribution states. Since the cation and anion of the lithium salt are included inside the photoelectric conversion layer, a resultant photoelectric conversion element achieves high output with light of low illuminance in various temperature environments, and an excellent output retention effect can be further improved.

In addition to the lithium salt represented by General Formula (1), the hole-transporting layer of the photoelectric conversion layer may further include lithium salt having a different structure. Other than lithium salt described above, the lithium salt may be lithium salt having symmetric anionic species. Examples thereof include lithium bis(fluorosulfonyl)imide (Li-FSI), lithium bis(trifluoromethane sulfonyl)imide (Li-TFSI), lithium bis(pentafluoroethanesulfonyl)imide (Li-BETI), and lithium bis(nonafluorobutanesulfonyl)imide. Moreover, other examples thereof may include cyclic imide, such as lithium (cyclohexafluoropropane)(disulfone)imide.

However, the above-listed lithium salts have low dissolubability due to symmetric anions, and a large amount thereof cannot be added. Evan when any of the above-listed lithium salts is added, therefore, a small amount thereof is preferably added.

An amount of the lithium salt relative to the hole-transporting material is preferably 5 mol% or greater but 50 mol% or less, and more preferably 20 mol% or greater but 35 mol% or less. When the amount of the lithium salt is within the above-mentioned range, high output is achieved with light of low illuminance, the output retention rate is improved, and high durability is achieved at the same time.

An organic solvent included in the hole-transporting layer may be any of solvents known in the art as long as the solvent can dissolve various materials to be included, such as lithium salt, and a below-described hole-transporting material. The organic solvent may be appropriately selected depending on the intended purpose.

Examples of the organic solvent include a ketone solvent, an ester solvent, an ether solvent, an amide solvent, a halogenated hydrocarbon solvent, a nitrile solvent, and a hydrocarbon solvent.

Examples of the ketone solvent include acetone, methyl ethyl ketone, methyl isobutyl ketone, and acetophenone.

Examples of the ester solvent include ethyl formate, ethyl acetate, n-butyl acetate, and methyl benzoate.

Examples of the ether solvent include anisole, diisopropyl ether, dibutyl ether, dimethoxy ethane, diethoxy ethane, ethoxy benzene, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the nitrile solvent include acetonitrile, propionitrile, and methacrylonitrile.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

Among the above-listed solvents, a halogenated hydrocarbon solvent, an ether solvent, and a nitrile solvent are preferable.

A boiling point of the organic solvent is not particularly limited and may be appropriately selected depending on the intended purpose. The boiling point is preferably 70°C or higher but 150°C or lower. When the organic solvent having the boiling point in the above-mentioned range is used, the porous electron-transporting layer tends to be filled with the hole-transporting layer to avoid an excessive amount of the solvent. It is possible to reduce the amount of thel solvent by heating and drying the hole-transporting layer after applying the hole-transporting layer. When the hole-transporting layer is heated and dried at an excessively high temperature or for an excessively long period, however, high output may not be achieved or durability of a resultant photoelectric conversion element may be significantly reduced even through the amount of the solvent can be reduced. Accordingly, the selection of the solvent is also important. In the present disclosure, among the above-listed solvents, chlorobenzene, or a mixed solvent including chlorobenzene is preferably used.

The average thickness of the hole-transporting layer is not particularly limited, and may be appropriately selected depending on the intended purpose. The hole-transporting layer preferably has a structure penetrating into pores of a porous electron-transporting layer, and the average thickness of the hole-transporting layer disposed on the electron-transporting layer is preferably 0.01 µm or greater but 20 µm or less, more preferably 0.1 µm or greater but 10 µm or less, and further more preferably 0.2 µm or greater but 2 µm or less.

The hole-transporting layer can be directly formed on the below-described electron-transporting layer, in which a photosensitization compound is adsorbed.

A production method of the hole-transporting layer is not particularly limited as long as an amount (residual amount) of a solvent is 5.4 to 30 µg/mm³ after formation of the photoelectric conversion element, and may be appropriately selected depending on the intended purpose. Examples of the production method include a method where a thin film is formed in vacuum, such as vacuum vapor deposition, and a wet film forming method. Among the above-listed examples, a wet film forming method is particularly preferable considering a production cost, and a method for applying on an electron-transporting layer is preferable.

When the wet film forming method is used, a coating method is not particularly limited and may be performed according to any of known methods. For example, various methods, such as dip coating, spray coating, wire bar coating, spin coating, roller coating, blade coating, gravure coating, die coating, and as a wet printing method, relief printing, offset printing, gravure printing, intaglio printing, rubber plate printing, and screen printing, may be used.

Moreover, a film of the hole-transporting layer may be formed in a supercritical fluid, or a subcritical fluid having lower temperature and pressure than a critical point. The supercritical fluid is not particularly limited as long as the supercritical fluid exists as a non-condensable high-density fluid in a temperature and pressure region exceeding the limit (critical point) at which gas and liquid can coexist, the supercritical fluid does not condense even when compressed, and the supercritical fluid is a fluid in a state of being equal to or greater than the critical temperature and the critical pressure. The supercritical fluid may be appropriately selected depending on the intended purpose. The supercritical fluid is preferably a supercritical fluid having a low critical temperature.

Examples of the supercritical fluid include carbon monoxide, carbon dioxide, ammonia, nitrogen, water, alcohol solvents, hydrocarbon solvents, halogen solvents, and ether solvents.

Examples of the alcohol solvent include methanol, ethanol, and n-butanol.

Examples of the hydrocarbon solvent include ethane, propane, 2,3-dimethylbutane, benzene, and toluene.

Examples of the halogen solvent include methylene chloride and chlorotrifluoromethane.

Examples of the ether solvent include dimethyl ether.

The above-listed examples may be used alone or in combination.

Among the above-listed examples, carbon dioxide is preferable because carbon dioxide has a critical pressure of 7.3 MPa and a critical temperature of 31°C, and therefore a supercritical state of carbon dioxide can be easily generated, and the supercritical fluid of carbon dioxide is easily handled due to incombustibility thereof.

The subcritical fluid is not particularly limited as long as the subcritical fluid exists as a high-pressure liquid in a temperature and pressure region near the critical point. The subcritical fluid may be appropriately selected depending on the intended purpose. The compounds listed as the supercritical fluid can be suitably used as the subcritical fluid.

The critical temperature and the critical pressure of the subcritical fluid are not particularly limited, and may be appropriately selected depending on the intended purpose. The critical temperature of the subcritical fluid is preferably -273°C or higher but 300°C or lower, and more preferably 0°C or higher but 200°C or lower.

In addition to the supercritical fluid or the subcritical fluid, moreover, an organic solvent or an entrainer may be used in combination. The solubility in the supercritical fluid can be easily adjusted by adding the organic solvent or entrainer.

The organic solvent is not particularly limited, and may be appropriately selected depending on the intended purpose. Examples of the organic solvent include a ketone solvent, an ester solvent, an ether solvent, an amide solvent, a halogenated hydrocarbon solvent, and a hydrocarbon solvent.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diisopropyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

Moreover, a production of the hole-transporting layer is preferably a method where a hole-transporting layer forming material including materials for forming the hole-transporting layer is applied onto an electron-transporting layer on which a photosensitization compound is adsorbed, followed by drying before formation of a second electrode to control. Heating and drying are particularly preferably performed.

The pressure as conditions for the heating and drying is not particularly limited. The heating and drying are preferably performed at ambient pressure.

The temperature as conditions for the heating and dying is preferably 30°C or higher but 130°C or lower, and more preferably 50°C or higher but 100°C or lower.

The processing time as conditions for the heating and drying is preferably 10 minutes or longer but 24 hours or shorter, and more preferably 30 minutes or longer but 2 hours or shorter.

After disposing a layer of the hole-transporting material on the electron-transporting layer on which the photosensitization compound is adsorbed, moreover, a press treatment may be performed. As the press treatment is performed, the hole-transporting material is more closely adhered to the electron-transporting layer that is a porous electrode, and therefore efficiency may be improved.

A method of the press treatment is not particularly limited, and may be appropriately selected depending on the intended purpose. Examples thereof include press molding using a flat plate, such as IR pellet dies, and roll pressing using a roller.

The pressure is preferably 10 kgf/cm² or greater, and more preferably 30 kgf/cm² or greater.

The time of the press treatment is not particularly limited, and may be appropriately selected depending on the intended purpose. The time thereof is preferably 1 hour or shorter. Moreover, heat may be applied during the press treatment. During the press treatment, a release agent may be disposed between a press and the electrode.

Examples of the release agent include fluororesins, such as polyethylene tetrafluoride, polychloroethylene trifluoride, ethylene tetrafluoride-propylene hexafluoride copolymer, a perfluoroalkoxy fluoride resin, polyvinylidene fluoride, ethylene-ethylene tetrafluoride copolymers, an ethylene-chloroethylene trifluoride copolymer, and polyvinyl fluoride. The above-listed examples may be used alone or in combination.

After performing the press treatment but before disposing a second electrode, metal oxide may be disposed between the hole-transporting material and the second electrode.

Examples of the metal oxide include molybdenum oxide, tungsten oxide, vanadium oxide, and nickel oxide. The above-listed examples may be used alone or in combination. Among the above-listed examples, molybdenum oxide is preferable.

A method for disposing the metal oxide on the hole-transporting layer is not particularly limited, and may be appropriately selected depending on the intended purpose. Examples of the method include: a method where a thin film is formed in vacuum, such as sputtering, and vacuum vapor deposition; and a wet film forming method.

The wet film forming method is preferably a method where a paste in which powder or sol of metal oxide is dispersed is prepared, and the paste is applied onto the hole-transporting layer. When the wet film forming method is used, a coating method is not particularly limited and coating may be performed any of methods known in the art. For example, various methods, such as dip coating, spray coating, wire bar coating, spin coating, roller coating, blade coating, gravure coating, die coating, and wet printing methods (e.g., relief printing, offset printing, gravure printing, intaglio printing, rubber plate printing, and screen printing) may be used.

The average thickness of the coated metal oxide is preferably 0.1 nm or greater but 50 nm or less, and more preferably 1 nm or greater but 10 nm or less.

In the photoelectric conversion element of the present disclosure, an amount of the solvent per unit volume of the hole-transporting layer is 5.4 to 30 µg/mm³, preferably 5.4 to 25 µg/mm³, and more preferably 5.4 to 20 µg/mm³. When the amount of the solvent per unit volume of the hole-transporting layer is 5.4 to 30 µg/mm³ durability of the hole-transporting layer to light can be improved.

When lithium salt having a symmetric structure is used, a large amount of a solvent may be used to maintain compatibility, or phase separation may be caused as an amount of a solvent is reduced. Therefore, improvement in durability has not been achieved with lithium salt having a symmetric structure. When the lithium salt having an asymmetric structure for use in the present disclosure is used, conversely, the lithium salt itself has high compatibility, and therefore it is possible to reduce an amount of a solvent, and improvement in durability can be achieved as a result of a synergetic effect with the lithium salt having an asymmetric structure.

A measurement of an amount of the solvent per unit volume of the hole-transporting layer is performed in the following manner.

### [Measuring method of solvent amount]

After immersing the produced photoelectric conversion element in liquid nitrogen, the photoelectric conversion element is finely crushed by a hummer, and the crushed photoelectric conversion element is transferred into a vial.

The sample collected in the vial is heated for 1 hour on a hot plate heated to 150°C, and the gas inside the vial is collected. From the collected gas, 100 µL of the gas is sampled and subjected to an analysis according gas chromatograph mass spectroscopy.

The gas chromatograph mass spectroscopy (GCMS) is performed under the following conditions.

### -Device-

SION-TQ (GCMS), available from BRUKER
UNITY2 (TD), available from MARKES

### -Measuring conditions-

Column: SGE GC column
   SOLGEL-WAX
   L = 30.0 m
   ID = 0.25 mm ID
   Film = 0.25 µm
Heating of column: 40°C (retained for 5 min) to <20°C/min> to 260°C (retained for 5 min) Carrier gas: He
Injector: 200°C
Column Flow: 1.00 mL/min (constant)
Ionization method: electron ionization (EI) (70 eV)
Injection mode: split 1:10
Measuring mode: total ion chromatogram (TIC) (m/z = 33 to 600)
Injected amount: 100 µL (gas)

The same sample is measured at 3 points (N = 3), and the average value thereof is provided as a measured value. The area value of each component is calculated from the specific spectrum. In Example, the measurement is performed with m/z = 112 because chlorobenzene is used as the solvent for the hole-transporting layer.

The measurement value obtained by GCMS is compared with the calibration curves above to determine a quantitative value on the calibration curve, and the quantitative value is converted using the volume of the hole-transporting layer according to the following formula to thereby calculate a quantitative value of chlorobenzene per unit volume of the hole-transporting layer. The hole-transporting layer mentioned above means an area of a film with a thickness, which is independently present as a layer, and the hole-transporting layer does not include a region penetrating the porous layer of the electron-transporting layer. Quantitative value (µg/mm3) = quantitative value on calibration curve (µg)/area of hole-transporting layer × film thickness (mm3)

A solvent for forming calibration curves, which is used for creating calibration curves, is prepared in the following manner.

### -Preparation of solution for forming calibration curves and formation of calibration curves-

Standard chlorobenzene is diluted with methanol.

The obtained solution (1 µL) is transferred into a vial, the vial is heated on a hot plate of 150°C, 100 µL of gas collected from the gas generated in the vial is introduced into the above-described GCMS device, and an amount of chlorobenzene is measured in the same manner as the above-described method.

The hole-transporting layer preferably includes a p-type semiconductor material, a pyridine compound, and an oxidant.

The hole-transporting layer includes a p-type semiconductor material in order to impart a function of transporting holes.

### -P-type semiconductor material-

The p-type semiconductor material is not particularly limited, and may be appropriately selected depending on the intended purpose. Examples thereof include an inorganic p-type semiconductor material, and an organic p-type semiconductor material.

The inorganic p-type semiconductor material is not particularly limited, and may be appropriately selected depending on the intended purpose. Examples thereof include CuSCN, CuI, CuBr, NiO, V₂O₅, and graphene oxide. Among the above-listed examples, an organic p-type semiconductor material is preferable.

The organic p-type semiconductor material is not particularly limited, and may be appropriately selected depending on the intended purpose. For example, any of organic p-type semiconductor materials known in the art can be used.

Examples of the organic p-type semiconductor materials known in the art include an oxadiazole compound, a triphenylmethane compound, a pyrazoline compound, a hydrazine compound, a tetraarylbenzidine compound, a stilbene compound, and a spiro compound. The above-listed examples may be used alone or in combination. Among the above-listed examples, a spiro compound is preferable.

The spiro compound is preferably a compound represented by General Formula (10) below.

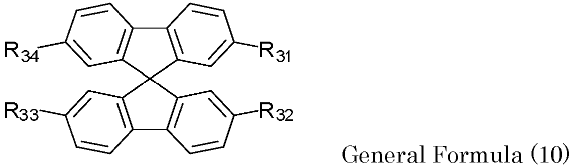

In General Formula (10), R₃₁ to R₃₄ are each independently a substituted amino group, such as a dimethylamino group, a diphenylamino group, and a naphthyl-4-tolylamino group.

Specific examples of the spiro compound include, but not limited to, (D-1) to (D-22) below.

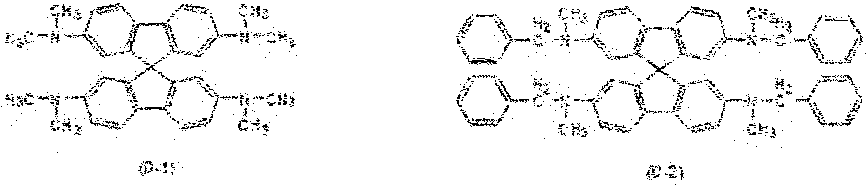

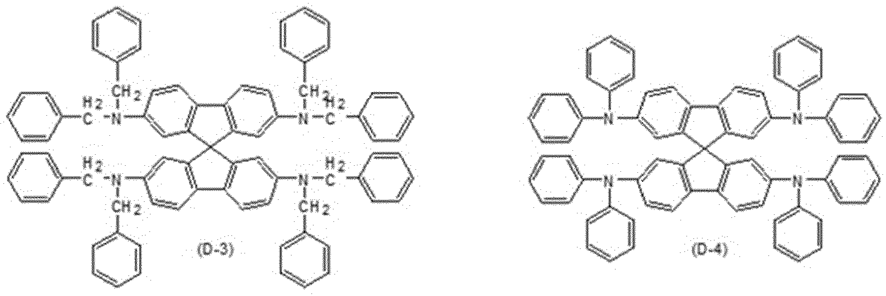

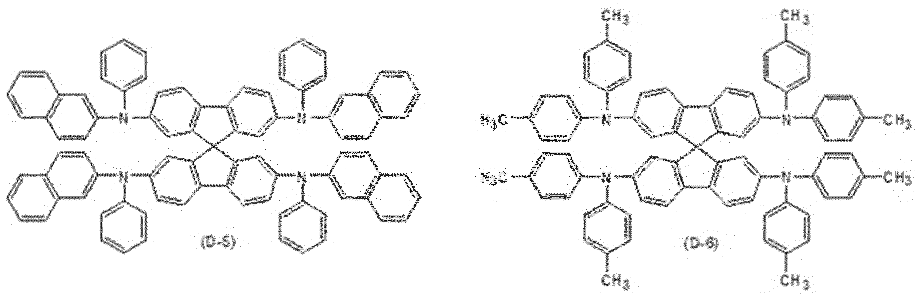

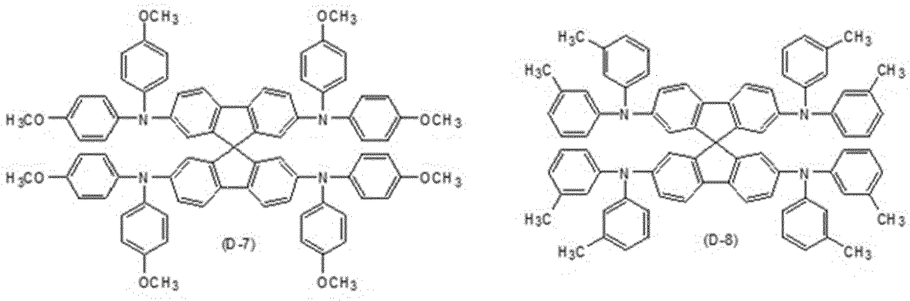

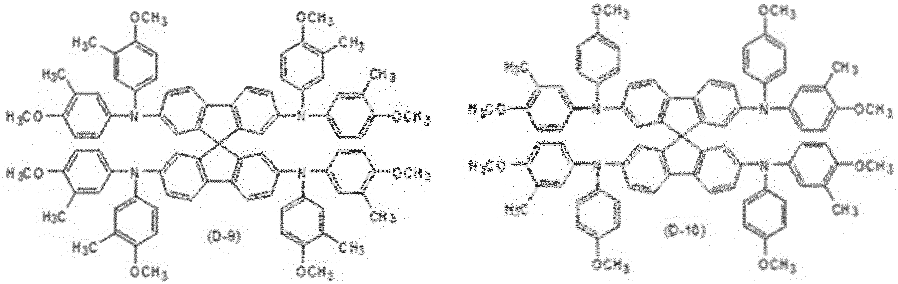

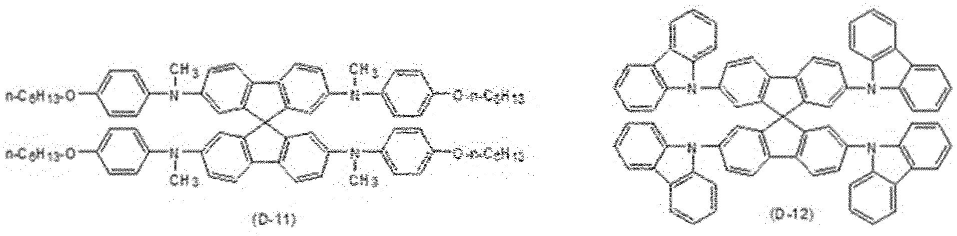

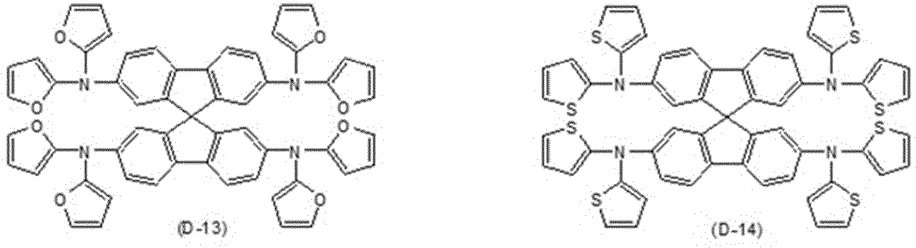

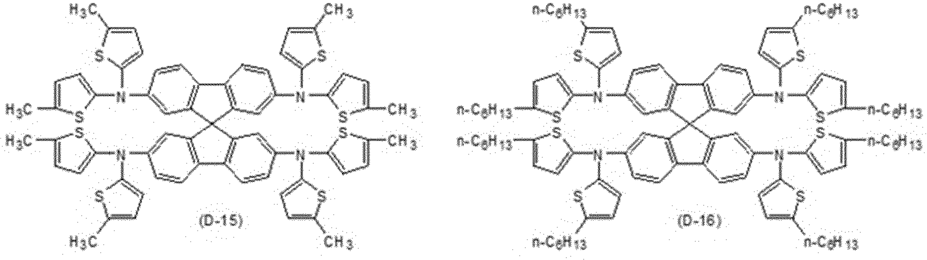

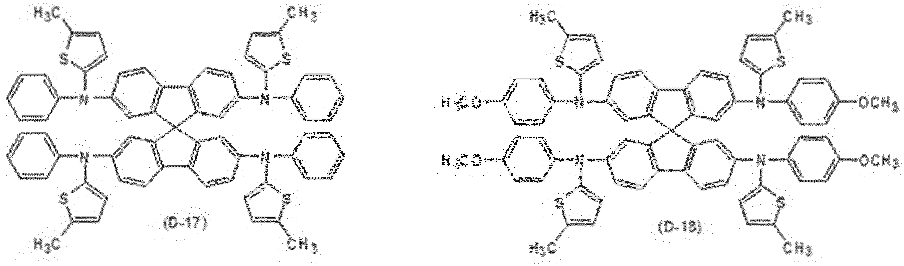

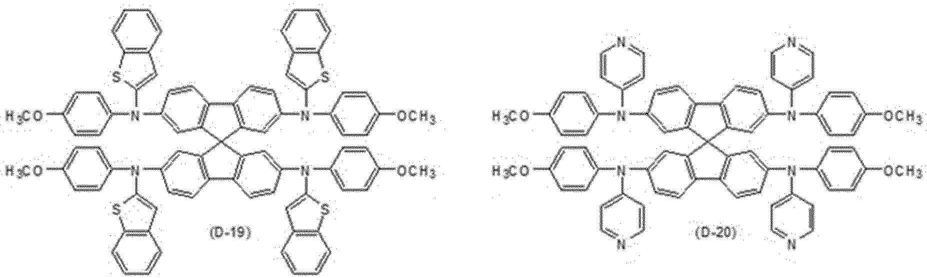

As the spiro compound serving as the hole-transporting material, moreover, a compound represented by General Formula (4) below is particularly suitably used.

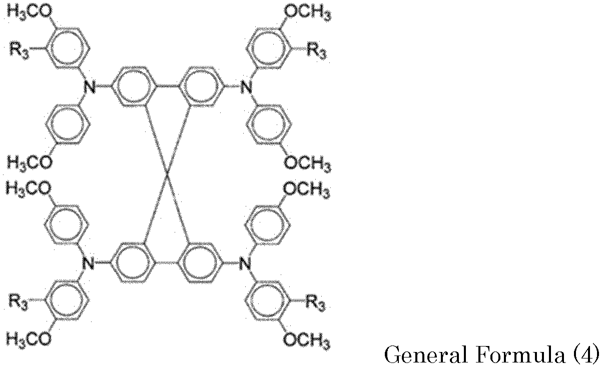

In General Formula (4), R₃ is a hydrogen atom or an alkyl group.

Among (D-1) to (D-20), for example, the compound represented by General Formula (4) is (D-7) or (D-10).

Since the above-listed spiro compounds have high hole mobility and have two benzidine skeleton molecules spirally bonded together, a nearly spherical electron cloud is formed, and excellent photoelectric conversion characteristics are exhibited due to excellent hopping conductivity between molecules. Moreover, the spiro compounds are dissolved in various organic solvents because of high solubility. Since the spiro compounds are amorphous (amorphous substances that do not have a crystal structure), the spiro compounds tend to be densely filled in the porous electron-transporting layer. Furthermore, the spiro compounds do not absorb light of 450 nm or longer, and therefore light is effectively absorbed by the photosensitization compound, which is particularly preferable for a solid dye-sensitized solar battery cell.

When a molar quantity of the lithium salt in the hole-transporting layer is determined as X, and a molar quantity of the organic p-type semiconductor material in the hole-transporting layer is determined as Y, a molar ratio X/Y of the lithium salt to the organic p-type semiconductor material is 0.35 or greater but 0.65 or less, and more preferably 0.5 or greater but 0.6 or less. When the molar ratio X/Y of the lithium salt to the organic p-type semiconductor material is 0.35 or greater but 0.65 or less, durability to light can be improved.

The hole-transporting layer may have a single-layer structure formed of a single material, or a laminate structure including a plurality of compounds. When the hole-transporting layer has a laminate structure, a polymer material is preferably used for a layer close to the below-described second electrode among all the layers in the laminate of the hole-transporting layer. Use of a polymer material having excellent film formability is advantageous because a surface of a porous electron-transporting layer can be leveled, and photoelectric conversion properties can be improved. Since the polymer material easily permeates the porous electron-transporting layer, the polymer material provides excellent coverage over the surface of the porous electron-transporting layer, and therefore an effect of preventing short circuit may be obtained when electrodes are disposed.

The polymer material used for the hole-transporting layer is not particularly limited. Examples thereof include hole-transporting polymer materials known in the art.

Examples of the hole-transporting polymer material include a polythiophene compound, a polyphenylene vinylene compound, a polyfluorene compound, a polyphenylene compound, a polyarylamine compound, and a polythiadiazole compound.

Examples of the polythiophene compound include poly(3-n-hexylthiophene), poly(3-n-octyloxythiophene), poly(9,9'-dioctyl-fluorene-co-bithiophene), poly(3,3‴-didodecyl-quarter thiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthienol3,2-b]thiophene-co-thiophene), and poly(3,6-dioctylthieno[3,2-b]thiophene-co-bithiophene).

Examples of the polyphenylene vinylene compound include poly[2-methoxy-5-(2-ethylhexyloxy)-1,4-phenylenevinylene], poly[2-methoxy-5-(3,7-dimethyloctyloxy)-1,4-phenylenevinylene], and poly[(2-methoxy-5-(2-ethylhexyloxy)-1,4-phenylenevinylene)-co-(4,4'-biphenylene-vinylene)].

Examples of the polyfluorene compound include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Examples of the polyphenylene compound include poly[2,5-dioctyloxy-1,4-phenylene] and poly[2,5-di(2-ethylhexyloxy-1,4-phenylene].

Examples of the polyarylamine compound include poly[(9,9-dioctylfluorenyl-2,7-diyl)-alt-co-(N,N'-diphenyl)-N,N'-di(p-hexylphenyl)-1,4-diaminobenzene], poly[(9,9-dioctylfluorenyl-2,7-diyl)-alt-co-(N,N'-bis(4-octyloxyphenyl)benzidine-N,N'-(1,4-diphenylene)], poly[(N,N'-bis(4-octyloxyphenyl)benzidine-N,N'-(1,4-diphenylene)], poly[(N,N'-bis(4-(2-ethylhexyloxy)phenyl)benzidine-N,N'-(1,4-diphenylene)], poly[phenylimino-1,4-phenylenevinylene-2,5-dioctyloxy-1,4-phenylenevinylene-1,4-phenylene], poly[p-tolylimino-1,4-phenylenevinylene-2,5-di(2-ethylhexyloxy)-1,4-phenylenevinylene-1,4-phenylene], and poly[4-(2-ethylhexyloxy)phenylimino-1,4-biphenylene].

Examples of the polythiadiazole compound include poly[(9,9-dioctylfluorenyl-2,7-diyl)-alt-co-(1,4-benzo(2,1',3)thiadiazole] and poly(3,4-didecylthiophene-co-(1,4-benzo(2,1',3)thiadiazole).

Among the above-listed examples, a polythiophene compound and a polyarylamine compound are preferable considering carrier mobility and ionization potential thereof.

### -Pyridine compound-

It is assumed that the pyridine compound is present near an interface of the electron-transporting layer to prevent reverse electron transfer from the electron-transporting layer (i.e. electron transfer from the electron-transporting layer to the hole-transporting layer).

The pyridine compound is preferably a pyridine compound represented by General Formula (A) or General Formula (B), and is more preferably a tertiary amine compound represented by General Formula (A1) or General Formula (B1). Adding the pyridine compound represented by General Formula (A) or General Formula (B) to the hole-transporting layer is advantageous because high open circuit voltage is obtained and high photoelectric conversion properties are obtained. When the hole-transporting layer includes the tertiary amine compound represented by General Formula (A1) or General Formula (B1), both high photoelectric conversion properties with light of low illuminance and stability over time can be achieved. 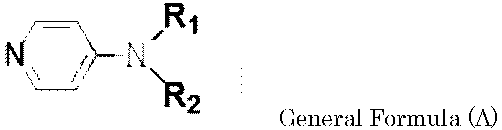 (In General Formula (A), R₁ and R₂ are each independently an alkyl group or an aromatic hydrocarbon group, where R₁ and R₂ are identical groups or different groups, or may be bonded together to form a heterocyclic group including a nitrogen atom.) 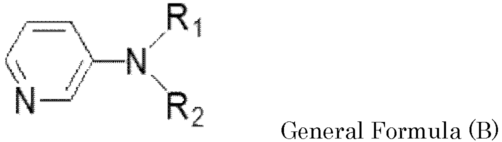 (In General Formula (B), R₁ and R₂ are each independently an alkyl group or an aromatic hydrocarbon group, where R₁ and R₂ are identical groups or different groups, or may be bonded together to form a heterocyclic group including a nitrogen atom.)

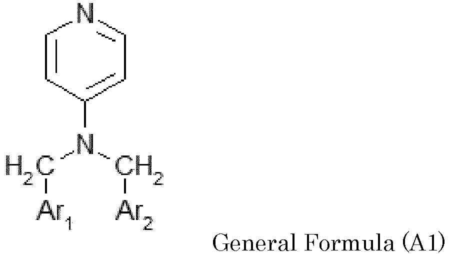

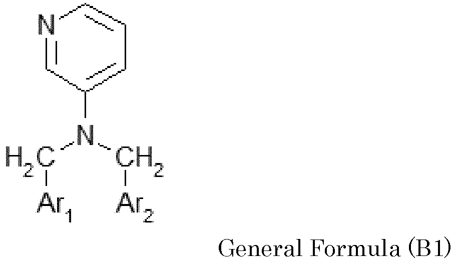

In General Formula (A1) and General Formula (B1), Ar₁ and Ar₂ are each an aryl group that may have a substituent, where Ar₁ and Ar₂ may be identical or different, or may be bonded to together.

Specific exemplary compounds of the pyridine compounds represented by General Formula (A) and General Formula (B) will be listed below, but the pyridine compound for use in the present disclosure is not limited to the following exemplary compounds.

| | | |
|---|---|---|
| Compound No. 1 | Compound No. 2 | Compound No. 3 |
| 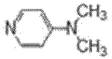 J31. 394C | 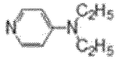 J482.060F | 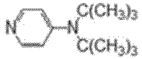 |
| Compound No. 4 | Compound No. 5 | Compound No. 6 |
| 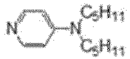 J2. 657. 343 | 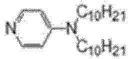 J2. 657. 344K | 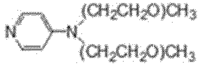 |
| Compound No. 7 | Compound No. 8 | Compound No. 9 |
| 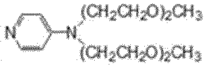 | 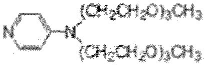 | 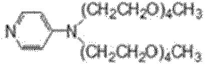 |
| Compound No. 10 | Compound No. 11 | |
| 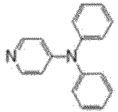 J2. 746. 230C | 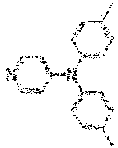 | |
| Compound No. 12 | Compound No. 13 | Compound No. 14 |
| 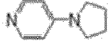 J174K | 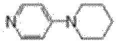 J236. 412C | 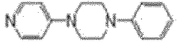 J50. 635D |
| Compound No. 15 | Compound No. 16 | Compound No. 17 |
| 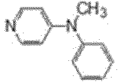 | 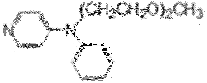 | 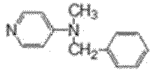 J1. 983. 963J |
| Compound No. 18 | Compound No. 19 | |
| 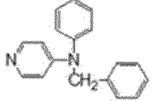 | 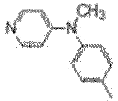 | |
| Compound No. 20 | Compound No. 21 | Compound No. 22 |
| 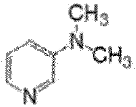 | 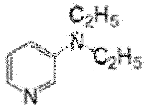 | 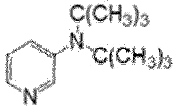 |
| Compound No. 23 | Compound No. 24 | Compound No. 25 |
| 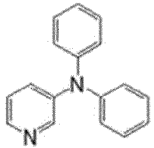 | 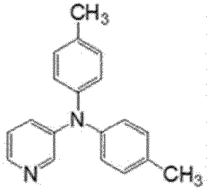 | 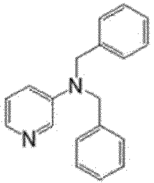 |
| Compound No. 26 | Compound No. 27 | Compound No. 28 |
| 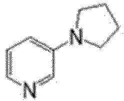 | 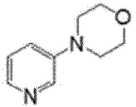 | 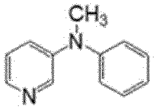 |
| Compound No. 29 | Compound No. 30 | |
| 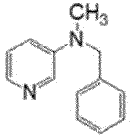 | 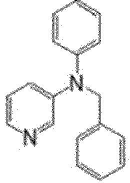 | |

Next, the following exemplary compounds C-1 to C-20 are listed as specific examples of the tertiary amine compounds represented by General Formula (A1) and General Formula (B1), but the tertiary amine compound is not limited to the exemplary compounds C-1 to C-20. The above-listed examples may be used alone or in combination.

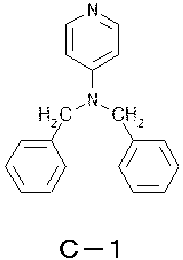

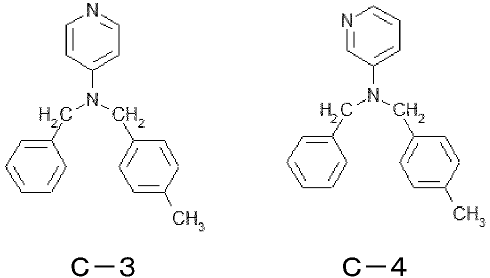

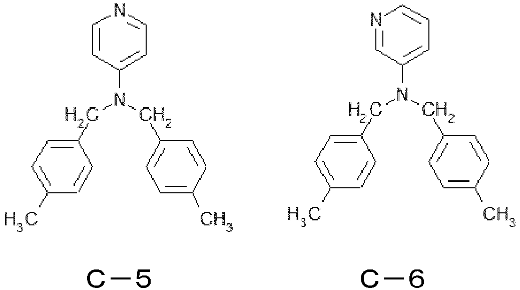

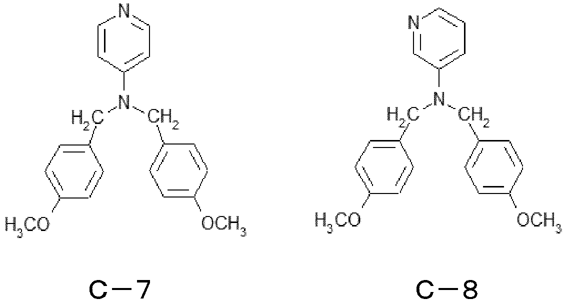

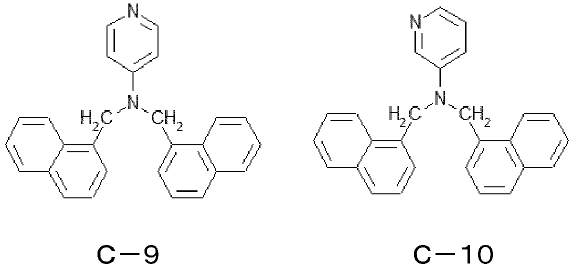

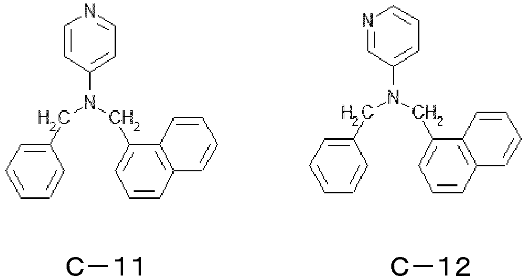

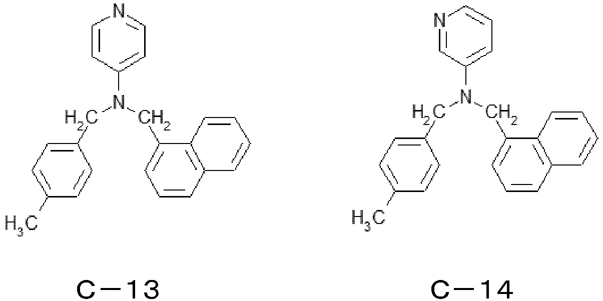

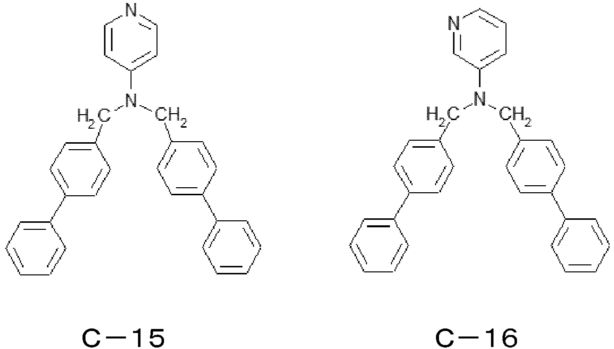

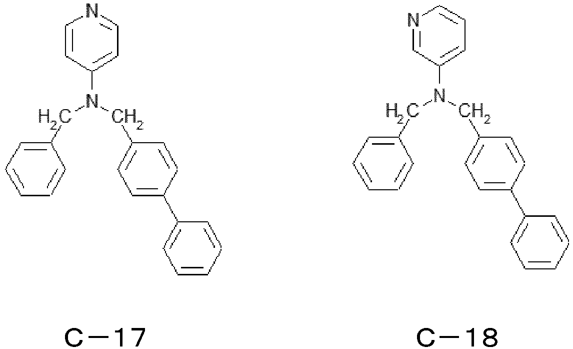

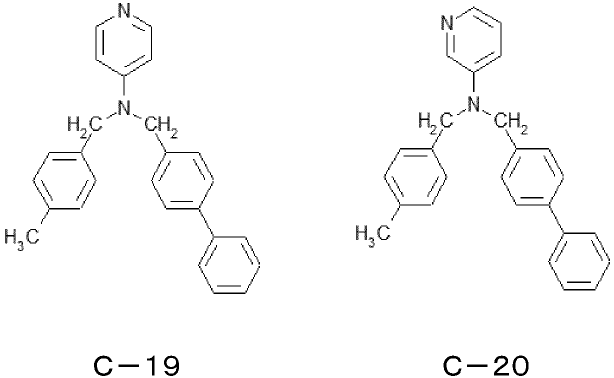

An amount of the pyridine compound in the hole-transporting layer is preferably 20 mol% or greater but 65 mol% or less, and more preferably 35 mol% or greater but 50 mol% or less, relative to the hole-transporting material. When the amount of the pyridine compound is within the above-mentioned preferable range, high open circuit voltage can be maintained, high output can be obtained, and high stability and durability can be obtained even after using for a long period in various environments (especially a low temperature environment).

When a molar quantity of the pyridine compound in the photoelectric conversion layer is determined as a, and a molar quantity of the lithium salt in the photoelectric conversion layer is determined as b, moreover, a molar ratio a/b of the pyridine compound to the lithium salt in the photoelectric conversion layer is preferably 2.0 or less, more preferably 1.8 or less, and even more preferably 1.7 or less.

The molar ratio a/b being 2.0 or less can lead to advantages that high output can be maintained for a longer period when light of low illuminance is emitted in a low temperature environment, and durability of the photoelectric conversion element can be further improved.

A molecular weight of the pyridine compound is preferably 140 g/mol or greater. When the molecular weight of the pyridine compound is 140 g/mol or greater, physical and electrical contact between the electron-transporting layer and the hole-transporting layer can be prevented to further reduce reverse electron transfer owing the presence of the pyridine compound near an interface of the electron-transporting layer, and therefore high photoelectric conversion properties can be exhibited with light of low illuminance.

### -Oxidant-

The hole-transporting layer preferably includes an oxidant. Since the hole-transporting layer includes the oxidant, part of the organic hole-transporting material becomes a radical cation, and therefore conductivity is improved to enhance durability and stability of output characteristics.

Since the organic hole-transporting material is oxidized by the oxidant, the organic hole-transporting material exhibits excellent hole conductivity, and release (reduction) of the oxidized state due to an influence of the surrounding environment of the photoelectric conversion layer can be prevented. Therefore, excellent stability is obtained over time.

The oxidant is not particularly limited, and may be appropriately selected depending on the intended purpose. Examples thereof include tris(4-bromophenyl)aluminium hexachloroantimonate, silver hexafluoroantimonate, nitrosonium tetrafluoroborate, silver nitrate, and a metal complex. The above-listed examples may be used alone or in combination. Among the above-listed examples, a metal complex is preferable.

Examples of the metal complex include a metal complex having a structure composed of a metal cation, a ligand, and an anion.

The metal cation is not particularly limited, and may be appropriately selected depending on the intended purpose. Examples thereof include cations of chromium, manganese, zinc, iron, cobalt, nickel, copper, molybdenum, ruthenium, rhodium, palladium, silver, tungsten, rhenium, osmium, iridium, vanadium, gold, platinum, etc. Among the above-listed examples, cations of manganese, zinc, iron, cobalt, nickel, copper, ruthenium, silver, and vanadium are preferable, and a cobalt complex is more preferable.

The ligand preferably includes a 5-membered heterocycle and/or a 6-membered heterocycle including at least one nitrogen, and may include a substituent. Specific examples thereof include, but are not limited to, the following compounds.

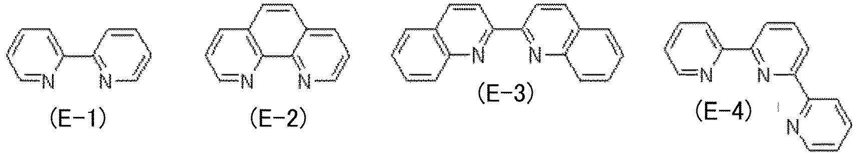

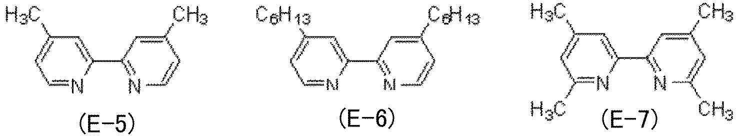

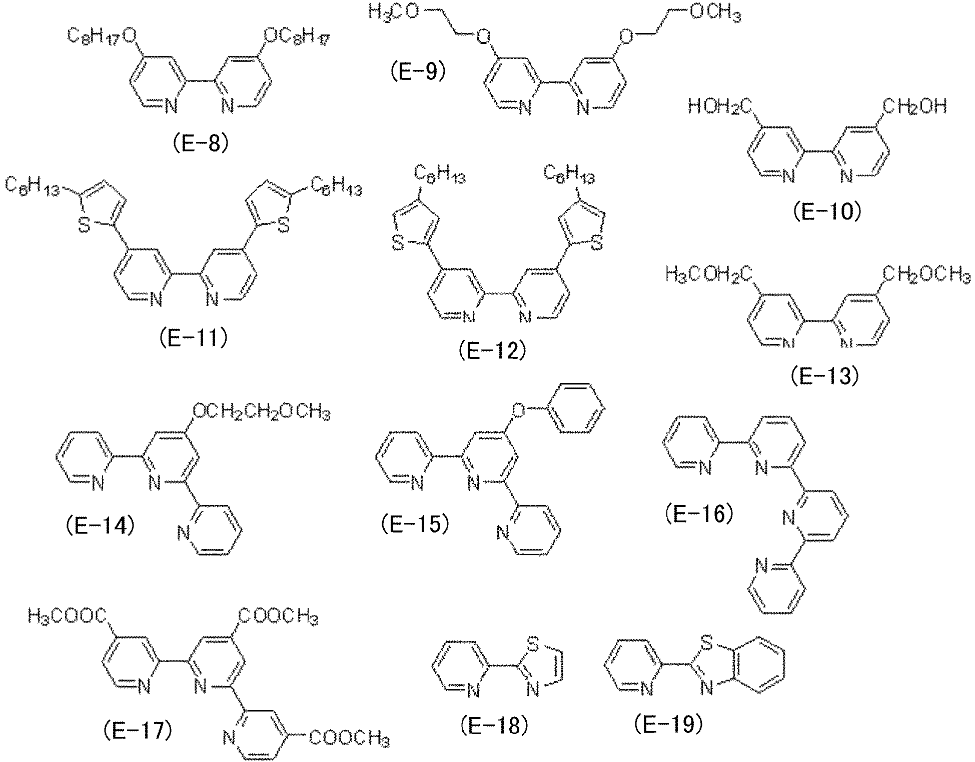

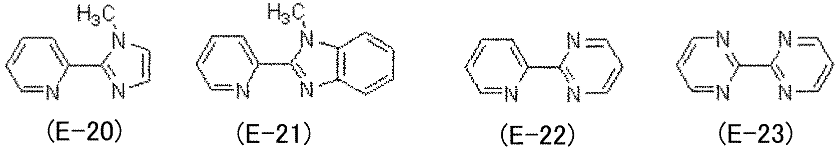

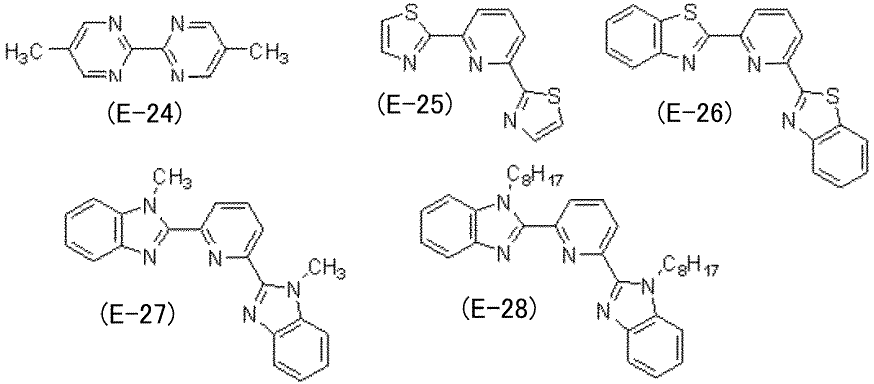

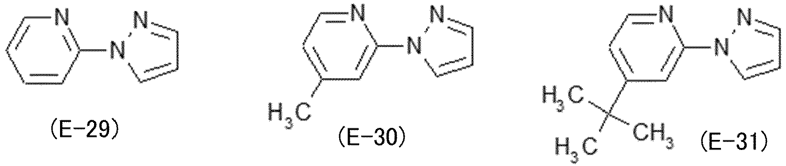

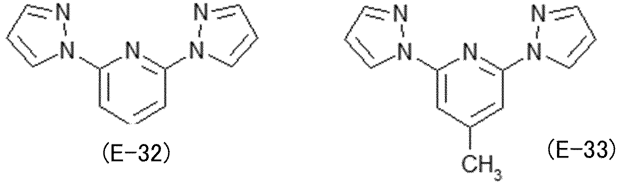

Examples of the anion include a hydride ion (H⁻), a fluoride ion (F⁻), a chloride ion (Cl⁻), a bromide ion (Br⁻), an iodide ion (I⁻), a hydroxide ion (OH⁻), a cyanide ion (CN⁻), a nitric acid ion (NO₃⁻), a nitrous acid ion (NO₂⁻), a hypochlorous acid ion (ClO⁻), a chlorous acid ion (ClO₂⁻), a chloric acid ion (ClO₃⁻), a perchloric acid ion (ClO₄⁻), a permanganic acid ion (MnO₄⁻), an acetic acid ion (CH₃COO⁻), a hydrogen carbonate ion (HCO₃⁻), a dihydrogen phosphate ion (H₂PO₄-), a hydrogen sulfate ion (HSO₄⁻), a hydrogen sulfide ion (HS⁻), a thiocyanic acid ion (SCN⁻), a tetrafluoroboric acid ion (BF₄⁻), a hexafluorophosphate ion (PF₆⁻), a tetracyanoborate ion (B(CN)₄⁻), a dicyanoamine ion (N(CN)₂⁻), a p-toluenesulfonic acid ion (TsO⁻), a trifluoromethyl sulfonate ion (CF₃SO₂⁻), a bis(trifluoromethylsulfonyl)amine ion (N(SO₂CF₃)₂⁻), a tetrahydroxoaluminate ion ([Al(OH)₄]⁻ or [Al(OH)₄(H₂O)₂]⁻), a dicyanoargentate(I) ion ([Ag(CN)₂]⁻), a tetrahydroxochromate(III) ion ([Cr(OH)₄]⁻), a tetrachloroaurate(III) ion ([AuCl₄]⁻), an oxide ion (O²⁻), a sulfide ion (S²⁻), a peroxide ion (O₂²⁻), a sulfuric acid ion (SO₄²⁻), a sulfurous acid ion (SO₃²⁻), a thiosulfuric acid (S₂O₃²⁻), a carbonic acid ion (CO₃²⁻), a chromic acid ion (CrO₄²⁻), a dichromic acid ion (Cr₂O₇²⁻), a monohydrogen phosphate ion (HPO₄²⁻), a tetrahydroxozincate(II) ion ([Zn(OH)₄]²⁻), a tetracyanozincate(II) ion ([Zn(CN)₄]²⁻), a tetrachlorocuprate(II) ion ([CuCl₄]²⁻), a phosphoric acid ion (PO₄³⁻), a hexacyanoferrate(III) ion ([Fe(CN)₆]³⁻), a bis(thiosulfate)argentate(I) ion ([Ag(S₂O₃)₂]³⁻), and a hexacyanoferrate(II) ion ([Fe(CN)₆]⁴⁻). Among the above-listed examples, a tetrafluoroboric acid ion, a hexafluorophosphate ion, a tetracyanoborate ion, a bis(trifluoromethylsulfonyl)amine ion, and a perchloric acid ion are preferable.

As the metal complex, a trivalent cobalt complex is particularly preferably added. When the trivalent cobalt complex is added as the oxidant, the hole-transporting material can be oxidized to stabilize the hole-transporting material, and therefore hole transporting properties can be improved.

In the present disclosure, for example, a trivalent cobalt complex is preferably used as the cobalt complex to be added to the hole-transporting layer forming coating liquid, but the hole-transporting layer of the photoelectric conversion element obtained using the hole-transporting layer forming coating liquid preferably includes a divalent cobalt complex. This is because, the trivalent cobalt complex is mixed with the hole-transporting material to oxidize the hole-transporting material, and therefore the cobalt complex becomes divalent. In other words, in the present disclosure, the photoelectric conversion layer preferably further include a divalent cobalt complex.

It is particularly preferred that the trivalent cobalt complex be hardly remained especially in the hole-transporting layer of the photoelectric conversion element, and almost all of the cobalt complex be turned into a divalent cobalt complex. As a result, hole transporting properties are improved and stabilized, and high output and retention rate of output are improved, and moreover the effects thereof can be exhibited in different temperature environments.

For example, the valence of the cobalt complex included in the hole-transporting layer can be determined by XAFS spectroscopy. The XAFS spectroscopy is abbreviation of X-ray absorption fine structure spectroscopy. For example, a sample is irradiated with X-rays, and the absorption thereof is measured to obtain an XAFS spectrum.

In the XAFS spectrum, the structure near the absorption edge is called S-ray absorption near edge structure (XANES), and a wide range X-ray absorption fine structure appearing at the higher energy side than the absorption edge by about 100 eV or greater is called an extended X-ray absorption fine structure (EXAFS). The information associated with valence of a target atom or structure thereof can be obtained mainly from the former XANES. In this case, for example, an XAFS spectrum of a divalent cobalt complex powder and an XAFS spectrum of a trivalent cobalt complex powder are separately measured. By comparing the XAFS spectrum of the cobalt complex included in the hole-transporting layer with the XAFS spectra of the divalent and trivalent cobalt complex powder samples, the valence of the cobalt complex included in the hole-transporting layer can be determined.

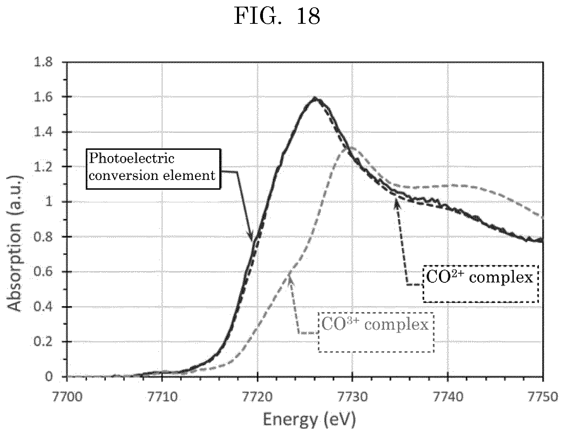

The XAFS spectrum of the photoelectric conversion module (the photoelectric conversion module of Example 1) using an example of the photoelectric conversion element of the present disclosure obtained in the above-described manner is presented in FIG. 18. As illustrated in FIG. 18, the cobalt complex included in the hole-transporting layer of the photoelectric conversion module using an example of the photoelectric conversion element of the present disclosure is matched with the spectrum of the divalent cobalt complex powder well, and does not have a region matched with the spectrum of the trivalent cobalt complex powder. Accordingly, it can be judged that almost all of the cobalt complexes included are divalent cobalt complexes.

The trivalent cobalt complex added to the hole-transporting layer forming coating liquid is preferably a cobalt complex represented by Structural Formula (4) or Structural Formula (5).

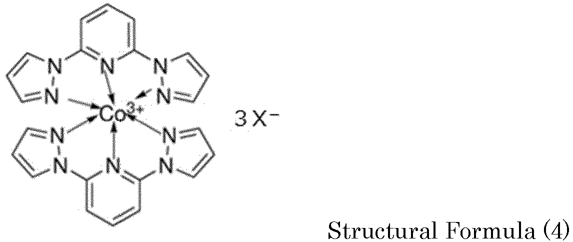

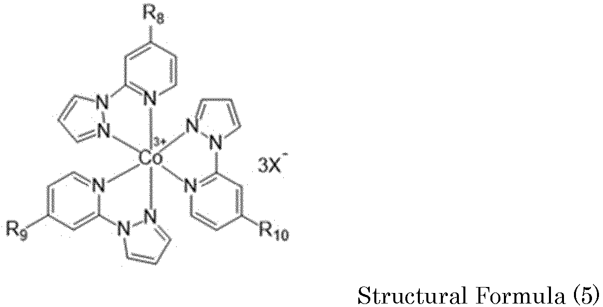

In Structural Formulae (4) and (5), R₈ to R₁₀ are each a hydrogen atom, a methyl group, an ethyl group, a tert-butyl group, or a trifluoromethyl group, and X is any of Structural Formulae (6) to (9).

BF₄ Structural Formula (6)

PF₆ Structural Formula (7)

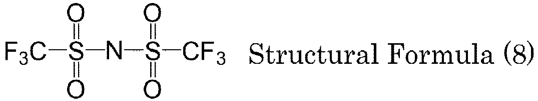

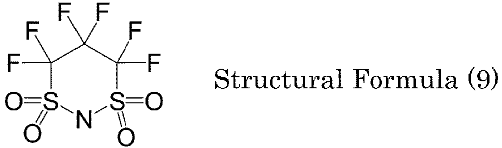

Among the structural formula (6) to (9), X is more preferably Structural Formula (8). X represented by Structural Formula (8) is effective because the hole-transporting material is stably maintained in the oxidized state.

Specific examples of the cobalt complexes above include, but are not limited to, (F-1) to (F-24) below.

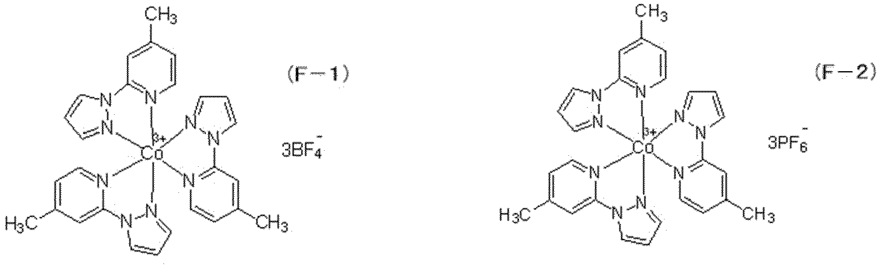

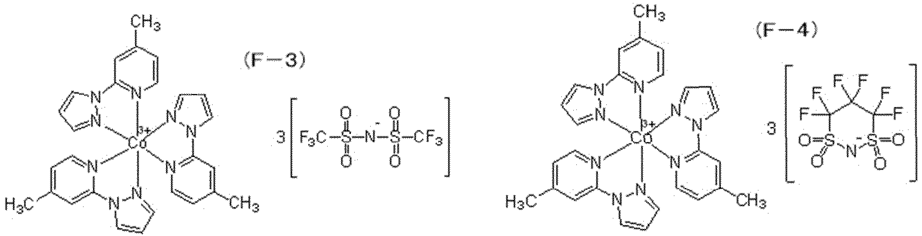

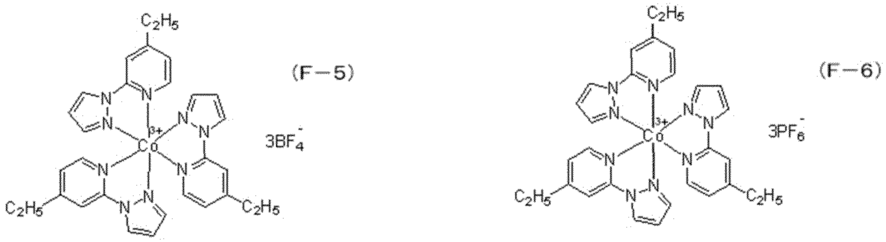

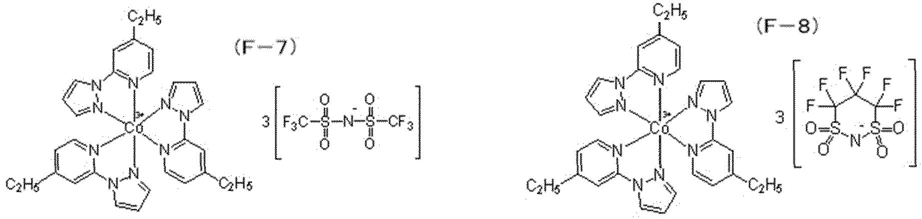

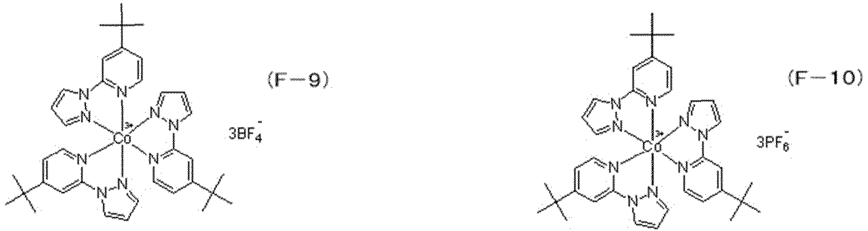

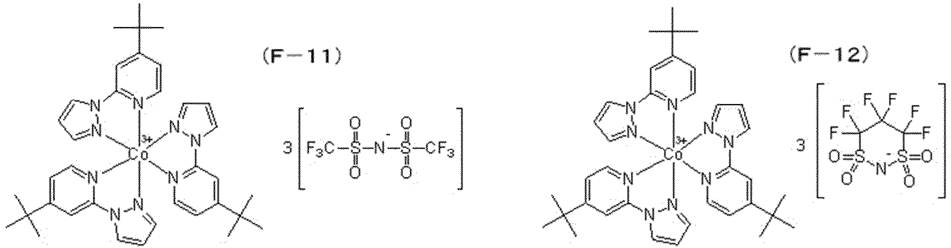

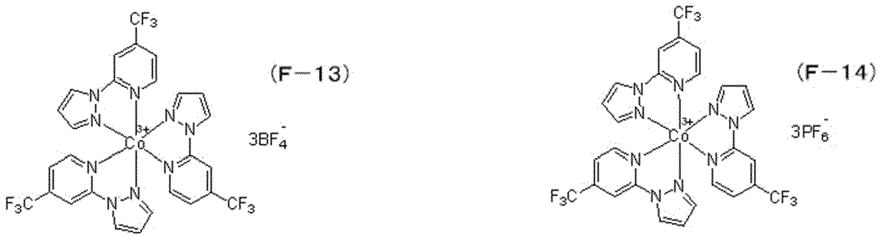

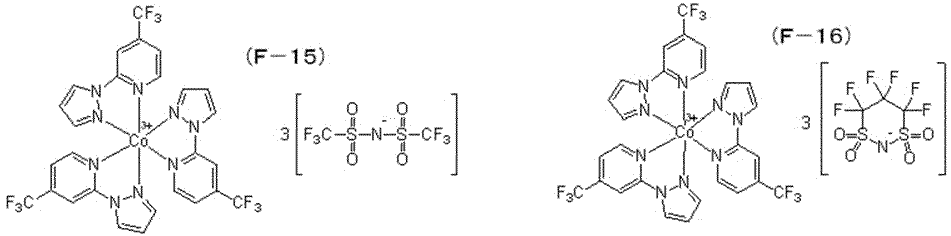

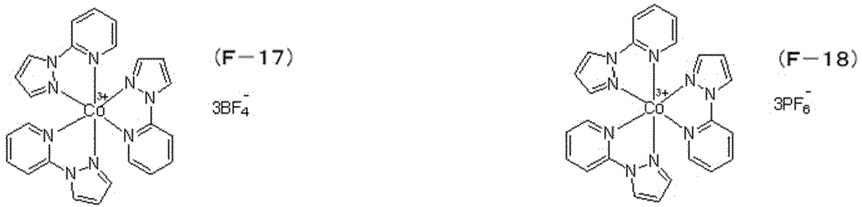

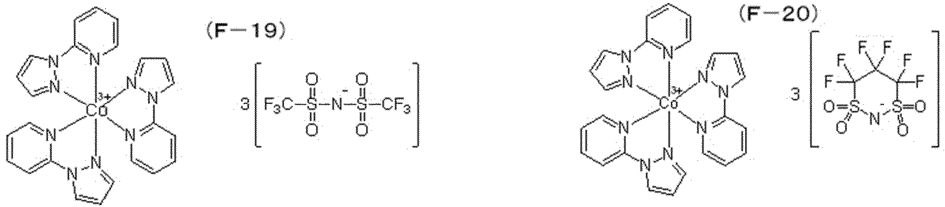

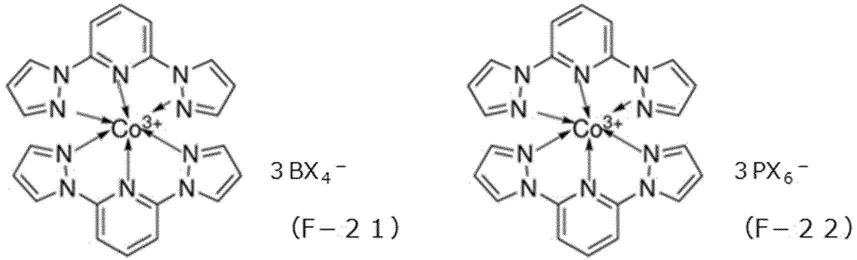

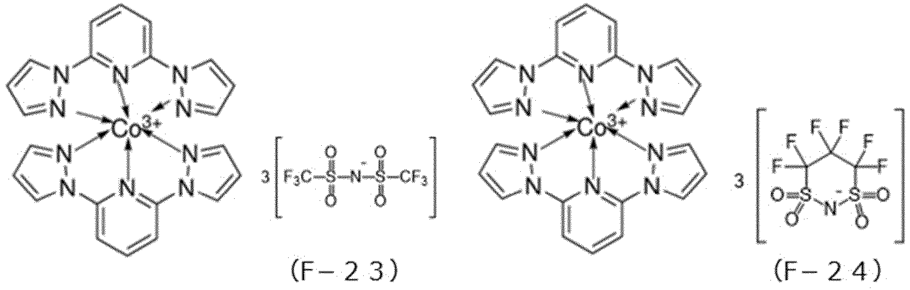

An amount of the oxidant is preferably 0.5 parts by mass or greater but 50 parts by mass or less, and more preferably 5 parts by mass or greater but 30 parts by mass or less, relative to 100 parts by mass of the hole-transporting material. The entire part of the hole-transporting material does not need to be oxidized by addition of the oxidant. The addition of the oxidant is effective as long as at least part of the hole-transporting material is oxidized.

Moreover, the lithium cation of the lithium salt represented by General Formula (1) may be migrated into the electron-transporting layer. For example, a half of the lithium cations or greater may be included in the below-described electron-transporting layer.

The inside area of the below-electron-transporting layer is more preferably filled with the hole-transporting layer for use in the present disclosure because output can be further improved. In this case, the hole-transporting layer disposed inside the electron-transporting layer is also handled as the hole-transporting layer.

### «Electron-transporting layer»

The photoelectric conversion element includes the electron-transporting layer including a photosensitization compound.

The electron-transporting layer is preferably disposed between the first electrode and the photosensitization compound.

The electron-transporting layer is formed for the purpose of transporting electrons generated by the photosensitization compound to the first electrode or the hole-blocking layer. Therefore, the electron-transporting layer is preferably disposed next to the first electrode or the hole-blocking layer.

A structure of the electron-transporting layer is not particularly limited, and may be appropriately selected depending on the intended purpose. When at least two photoelectric conversion elements are disposed next to each other, the electron-transporting layer of one photoelectric conversion element may be extended to the electron-transporting layer of another photoelectric conversion element, but the electron-transporting layer of one photoelectric conversion element is preferably disposed not to be extended from the electron-transporting layer of another photoelectric conversion element. Moreover, the structure of the electron-transporting layer may be a single layer structure, or a multilayer structure where a plurality of layers are laminated.

The electron-transporting layer includes an electron-transporting material, and may further include other materials according to the necessity.

The electron-transporting material is not particularly limited, and may be appropriately selected depending on the intended purpose. The electron-transporting material is preferably a semiconductor material.

The semiconductor material is preferably in the shape of particles, which are joined together to form a porous film. The photosensitization compound is chemically or physically adsorbed on surfaces of the semiconductor particles constituting the porous electron-transporting layer.

The semiconductor material is not particularly limited, and any of semiconductor materials known in the art can be used. Examples thereof include an element semiconductor, a compound semiconductor, and a compound having a perovskite structure.

Examples of the element semiconductor include silicon and germanium.

Examples of the compound semiconductor include chalcogenide of metal. Specific examples thereof include: oxide semiconductors of titanium, tin, zinc, iron, tungsten, zirconium, hafnium, strontium, indium, cerium, yttrium, lanthanum, vanadium, niobium, tantalum, etc.; sulfide semiconductors of cadmium, zinc, lead, silver, antimony, bismuth, etc.; selenide semiconductors of cadmium, lead, etc.; tellurium compound semiconductors of cadmium, etc.; and other compound semiconductors. Examples of the above-mentioned other compound semiconductors include: phosphide semiconductors of zinc, gallium, indium, cadmium, etc.; gallium arsenide; copper-indium-selenide semiconductors; and copper-indium-sulfide semiconductors.

Examples of the compound having the perovskite structure include strontium titanate, calcium titanate, sodium titanate, barium titanate, and potassium niobate.

Among the above-listed examples, oxide semiconductors are preferable, and titanium oxide, zinc oxide, tin oxide, and niobium oxide are more preferable. Use of titanium oxide as the electron-transporting material of the electron-transporting layer is advantageous because high open circuit voltage is obtained due to high conduction band of the titanium oxide, and therefore excellent photoelectric conversion properties can be achieved.

The above-listed examples may be used alone or in combination. Moreover, a crystal type of the semiconductor material is not particularly limited, and may be appropriately selected depending on the intended purpose. The semiconductor material may be monocrystalline, polycrystalline, or amorphous.

The average particle diameter of the primary particles of the semiconductor material is not particularly limited, and may be appropriately selected depending on the intended purpose. The average particle diameter thereof is preferably 1 nm or greater but 100 nm or less, and more preferably 5 nm or greater but 50 nm or less. Moreover, a semiconductor material having the larger particle diameter than the above-mentioned average particle diameter may be blended or laminated, which may lead to improvement of conversion efficiency owing to an effect of scattering incident light. In this case, the number average particle diameter of the semiconductor material having the larger particle diameter is preferably 50 nm or greater but 500 nm or less.

The average thickness of the electron-transporting layer is not particularly limited, and may be appropriately selected depending on the intended purpose. The average thickness thereof is preferably 50 nm or greater but 100 µm or less, more preferably 100 nm or greater but 50 µm or less, and even more preferably 120 nm or greater but 10 µm or less. The average thickness of the electron-transporting layer within the above-mentioned preferable range is advantageous because a sufficient amount of the photosensitization compound per unit projection area can be secured, a high capturing rate of light can be maintained, dispersion distances of injected electrons tend not to be increased, and loss of electric charge due to recombination can be reduced.

A production method of the electron-transporting layer is not particularly limited, and may be appropriately selected depending on the intended purpose. Examples thereof include: a method where a thin film is formed in vacuum, such as sputtering; a wet film forming method; and a wet printing method. Among the above-listed examples, a wet film forming method is preferable, and a method where a paste (a dispersion liquid of a semiconductor material) in which powder or sol of the semiconductor material is dispersed is prepared, and the paste is applied onto the first electrode serving as an electron collector electrode substrate, or onto the hole-blocking layer, is more preferable, considering production cost.

The wet film forming method is not particularly limited, and may be appropriately selected depending on the intended purpose. Examples thereof include dip coating, spray coating, wire bar coating, spin coating, roller coating, blade coating, gravure coating, and die coating.

As the wet printing method, various methods, such as relief printing, offset, gravure printing, intaglio printing, rubber plate printing, and screen printing, may be used.

Examples of a method for producing the dispersion liquid of the semiconductor material include a method where the materials are mechanically pulverized by means of a milling device known in the art. According to the above-described method, a particulate semiconductor material alone, or a mixture of the semiconductor and a resin is dispersed in water or a solvent to produce a dispersion liquid of the semiconductor material.

Examples of the resin include: polymers or copolymers of a vinyl compound (e.g., styrene, vinyl acetate, an acrylic ester, and methacrylic ester), a silicone resin, a phenoxy resin, a polysulfone resin, a polyvinyl butyral resin, a polyvinyl formal resin, a polyester resin, a cellulose ester resin, a cellulose ether resin, an urethane resin, a phenol resin, an epoxy resin, a polycarbonate resin, a polyarylate resin, a polyamide resin, and a polyimide resin. The above-listed examples may be used alone or in combination.

Examples of the solvent include water, an alcohol solvent, a ketone solvent, an ester solvent, an ether solvent, an amide solvent, a halogenated hydrocarbon solvent, and a hydrocarbon solvent.

Examples of the alcohol solvent include methanol, ethanol, isopropyl alcohol, and α-terpineol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

The dispersion liquid including the semiconductor material, or the paste including the semiconductor material, which is obtained by a sol-gel method, may include an acid, a surfactant, or a chelating agent in order to prevent re-aggregation of particles.

Examples of the acid include hydrochloric acid, nitric acid, and acetic acid.

Examples of the surfactant include polyoxyethylene octylphenyl ether.

Examples of the chelating agent include acetyl acetone, 2-aminoethanol, and ethylene diamine.

Moreover, to add a thickening agent is also effective for the purpose of improving film formability.

Examples of the thickening agent include polyethylene glycol, polyvinyl alcohol, and ethyl cellulose.

After applying the semiconductor material, firing or irradiation of microwaves, electron beams or laser light may be performed in order to electrically connect between the particles of the semiconductor material to improve a film strength or adhesion with the substrate. One of the above-mentioned treatments may be performed alone, or two or more of the above-mentioned treatments may be performed in combination.

When the firing of the electron-transporting layer including the semiconductor material is performed, the firing temperature is not particularly limited, and may be appropriately selected depending on the intended purpose. When the firing temperature is too high, resistance of the substrate may be increased or the substrate may be melted. Therefore, the firing temperature is preferably 30°C or higher but 700°C or lower, and more preferably 100°C or higher but 600°C or lower. Moreover, the firing time is not particularly limited, and may be appropriately selected depending on the intended purpose. The firing time is preferably 10 minutes or longer but 10 hours or shorter.

When microwave irradiation is performed on the electron-transporting layer formed of the semiconductor material, the irradiation time is not particularly limited, and may be appropriately selected depending on the intended purpose. The irradiation time is preferably 1 hour or shorter. The irradiation may be performed from the side where the electron-transporting layer is formed, or may be performed from the opposite side where the electron-transporting layer is not formed.

In order to increase a surface area of the electron-transporting layer or improve an electron injection efficiency to the below-described photosensitization compound, for example, chemical plating using an aqueous solution of titanium tetrachloride or a mixed solution with an organic solvent, or electrochemical plating using an aqueous solution of titanium trichloride may be performed after firing the electron-transporting layer formed of the semiconductor material.

A film obtained by firing the particles of the semiconductor material having diameters of several tens nanometers forms a porous state. The film having the porous nano-structure has an extremely large surface area, and the surface area thereof can be represented with a roughness factor. The roughness factor is a numerical value representing an actual area of the inner side of pores relative to an area of the semiconductor particles applied on the first substrate. Accordingly, the larger roughness factor is more preferable. Considering the relationship with the average thickness of the electron-transporting layer, the roughness factor is preferably 20 or greater.

Moreover, the photosensitization compound may be disposed between the electron-transporting layer and the hole-transporting layer.

### <<Photosensitization compound>>

In the present disclosure, the photosensitization compound is preferably adsorbed on a surface of the electron-transporting semiconductor of the electron-transporting layer for the purpose of further improving conversion efficiency.

The photosensitization compound is not particularly limited, as long as the photosensitization compound is a compound that is photoexcited by excitation light to be used, and may be appropriately selected depending on the intended purpose. Examples thereof include: metal complex compounds disclosed in Japanese Translation of PCT International Application Publication No. 07-500630, Japanese Unexamined Patent Application Publication No. 10-233238, Japanese Unexamined Patent Application Publication No. 2000-26487, Japanese Unexamined Patent Application Publication No. 2000-323191, and Japanese Unexamined Patent Application Publication No. 2001-59062; coumarine compounds disclosed in Japanese Unexamined Patent Application Publication No. 10-93118, Japanese Unexamined Patent Application Publication No. 2002-164089, Japanese Unexamined Patent Application Publication No. 2004-95450, and J. Phys. Chem. C, 7224, Vol. 111 (2007); polyene compounds disclosed in Japanese Unexamined Patent Application Publication No. 2004-95450, and Chem. Commun., 4887 (2007); indoline compounds disclosed in Japanese Unexamined Patent Application Publication No. 2003-264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun.,3036 (2003), and Angew. Chem. Int. Ed., 1923, Vol. 47 (2008); thiophene compounds disclosed in J. Am. Chem. Soc., 16701, Vol. 128 (2006), and J. Am. Chem. Soc., 14256, Vol. 128 (2006); cyanine dyes disclosed in Japanese Unexamined Patent Application Publication No. 11-86916, Japanese Unexamined Patent Application Publication No. 11-214730, Japanese Unexamined Patent Application Publication No. 2000-106224, Japanese Unexamined Patent Application Publication No. 2001-76773, and Japanese Unexamined Patent Application Publication No. 2003-7359; merocyanine dyes disclosed in Japanese Unexamined Patent Application Publication No. 11-214731, Japanese Unexamined Patent Application Publication No. 11-238905, Japanese Unexamined Patent Application Publication No. 2001-52766, Japanese Unexamined Patent Application Publication No. 2001-76775, and Japanese Unexamined Patent Application Publication No. 2003-7360; 9-arylxanthene compounds disclosed in Japanese Unexamined Patent Application Publication No. 10-92477, Japanese Unexamined Patent Application Publication No. 11-273754, Japanese Unexamined Patent Application Publication No. 11-273755, and Japanese Unexamined Patent Application Publication No. 2003-31273; triarylmethane compounds disclosed in Japanese Unexamined Patent Application Publication No. 10-93118, and Japanese Unexamined Patent Application Publication No. 2003-31273; phthalocyanine compounds disclosed in Japanese Unexamined Patent Application Publication No. 09-199744, Japanese Unexamined Patent Application Publication No. 10-233238, Japanese Unexamined Patent Application Publication No. 11-204821, Japanese Unexamined Patent Application Publication No. 11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008); and polyphyrin compounds.

Among the above-listed examples, a the metal complex compounds, the coumarine compounds, the polyene compounds, the indoline compounds, and the thiophene compounds are preferable, and compounds represented by Structural Formulae (1), (2), and (3) below, available from MITSUBISHI PAPER MILLS LIMITED are also preferably used.

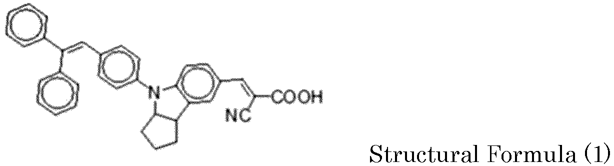

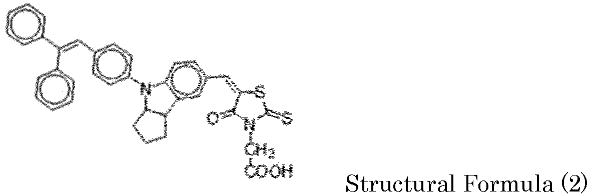

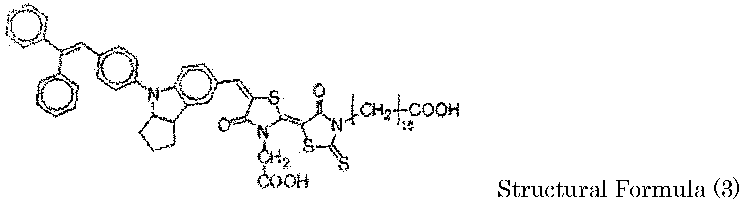

Examples of the photosensitization compound that is more preferably used include a compound represented by General Formula (5) below.

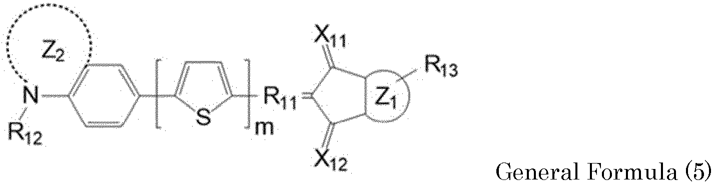

In General Formula (5), X₁₁ and X₁₂ are each independently an oxygen atom, a sulfur atom, or a selenium atom.

R₁₁ is a methane group that may have a substituent. Specific examples of the substituent include an aryl group (e.g., a phenyl group, and a naphthyl group), and a heterocycle (e.g., a thienyl group, and a furyl group).

R₁₂ is an alkyl group, aryl group, or heterocyclic group, which may have a substituent. Examples of the alkyl group include a methyl group, an ethyl group, a 2-propyl group, and a 2-ethylhexyl group. Examples of the aryl group and examples of the heterocyclic group are as described above.

R₁₃ is an acid group, such as carboxylic acid, sulfonic acid, phosphonic acid, boronic acid, and phenols. The number of R₁₃ may be one, or two or more.

Z₁ and Z₂ are each independently a substituent constituting a cyclic structure. Examples of Z₁ include a condensed hydrocarbon compound (e.g., a benzene ring, and a naphthalene ring), and a hetero cycle (e.g., a thiophene ring, and a furan ring), each of which may have a substituent. Specific examples of the substituent include above-described alkyl group, and an alkkoxy group (e.g., a methoxy group, an ethoxy group, and a 2-isopropoxy group). Specific examples of Z₂ include (A-1) to (A-22) below.

Note that, m is an integer of from 0 through 2.

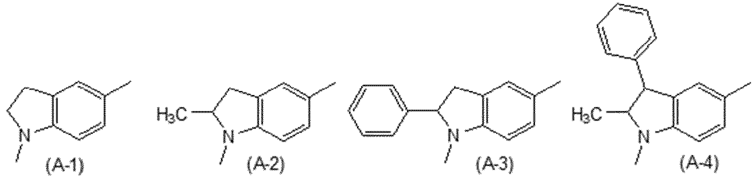

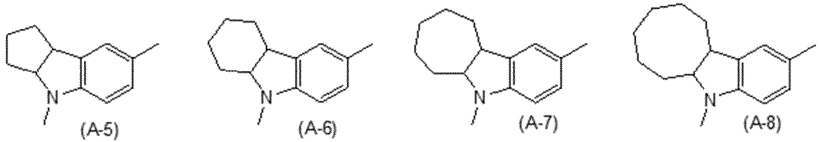

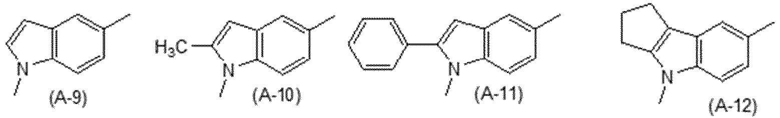

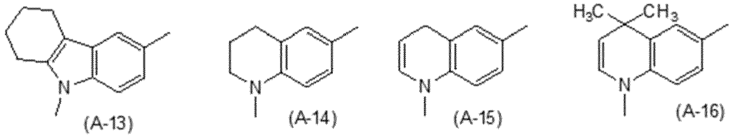

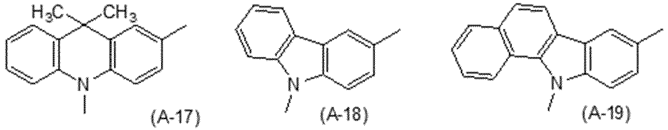

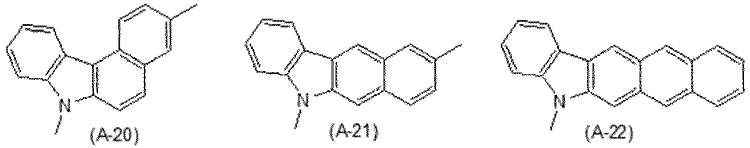

Among the above-listed compounds, a compound represented by General Formula (6) is more preferably used.

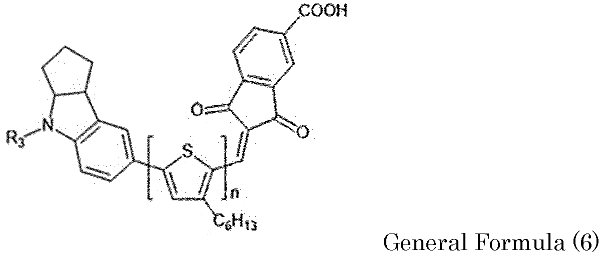

In General Formula (6), n is an integer of 0 or 1; and R₃ is an aryl group that may have a substituent, or a substituent represented by any of the following three structural formulae.

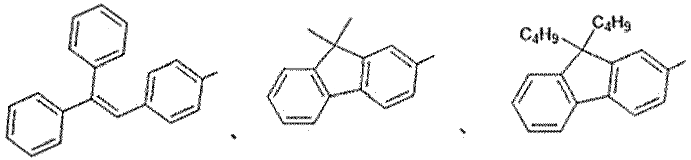

Specific examples of the photosensitization compounds represented by General Formulae (5) and (6) include, but are not limited to, (B-1) to (B-41) below.

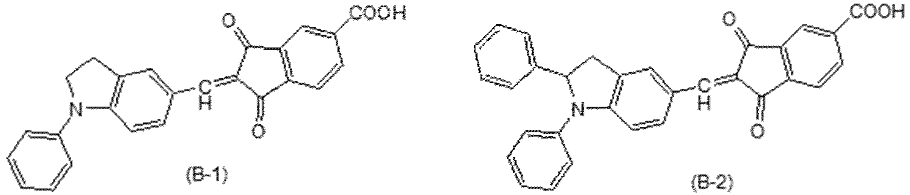

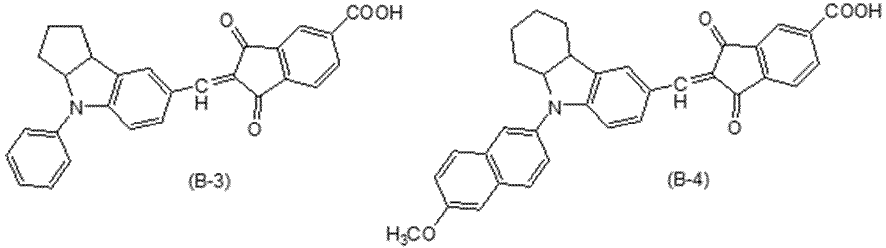

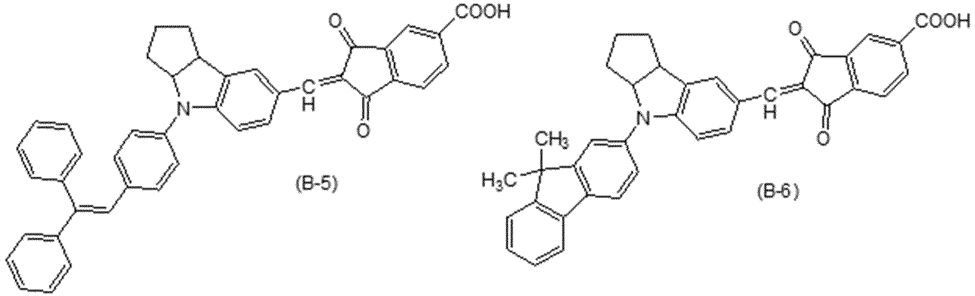

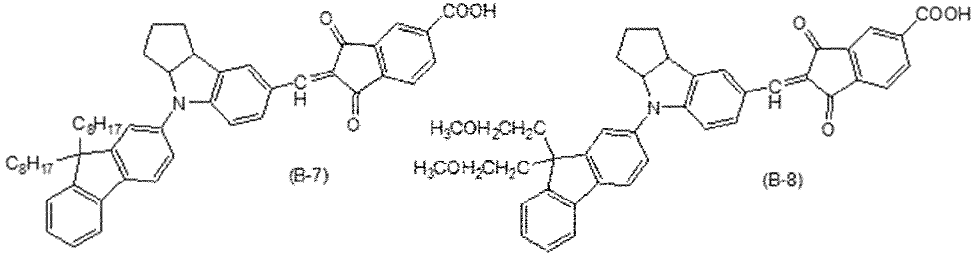

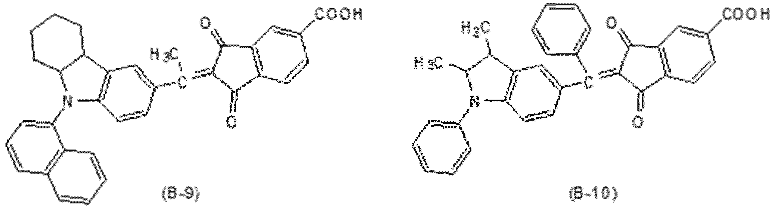

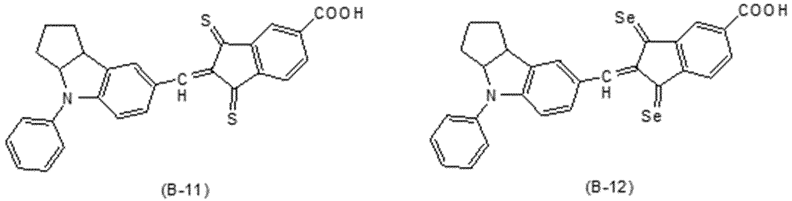

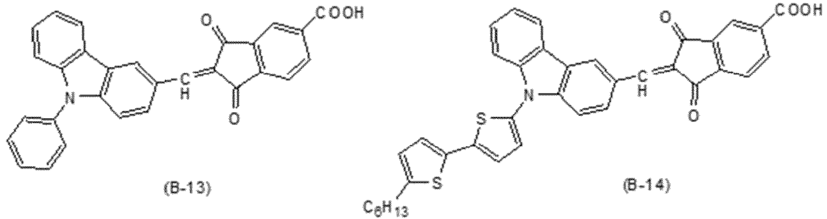

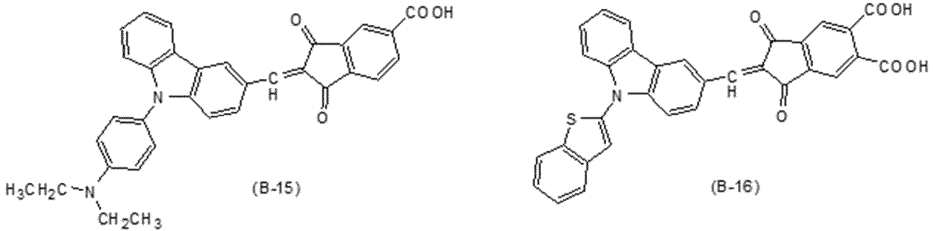

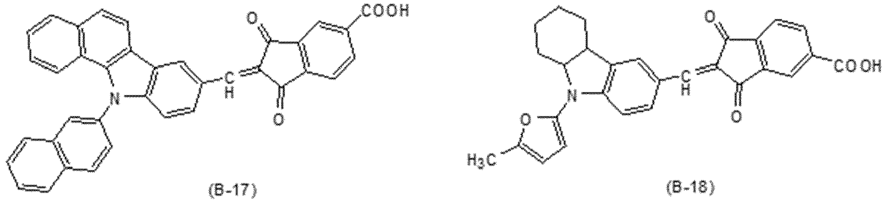

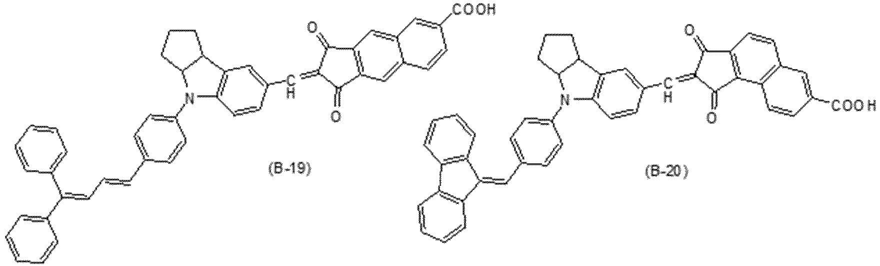

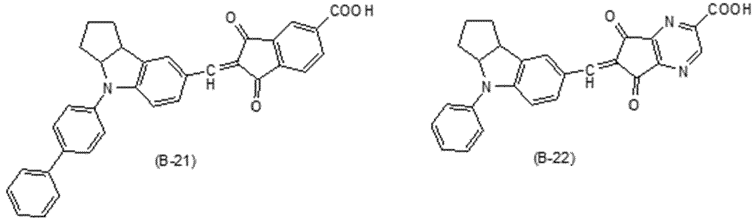

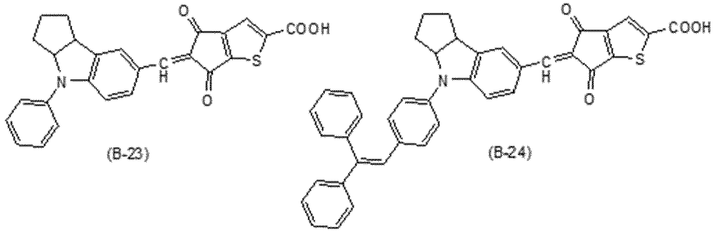

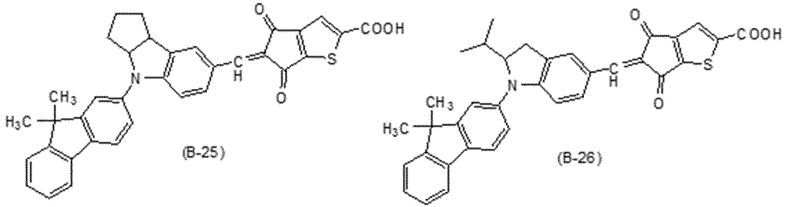

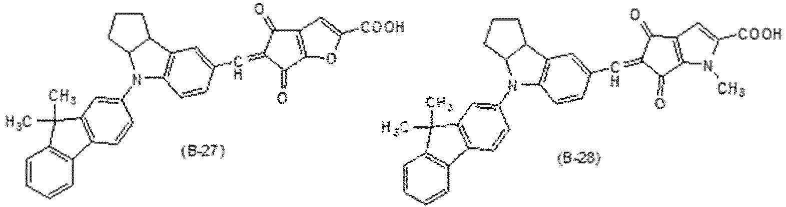

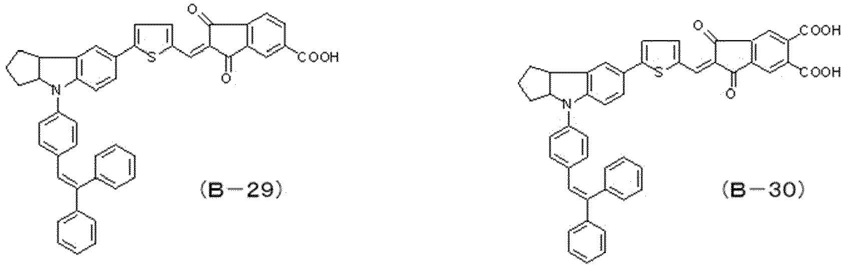

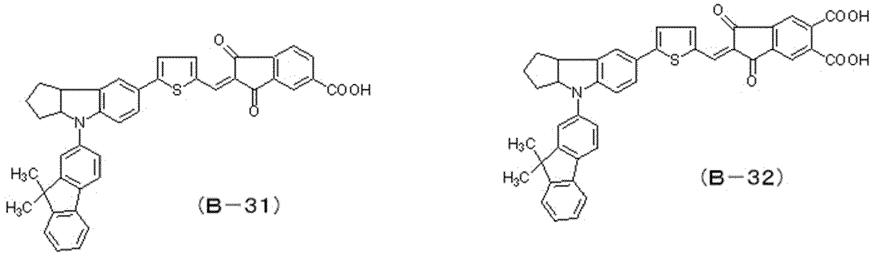

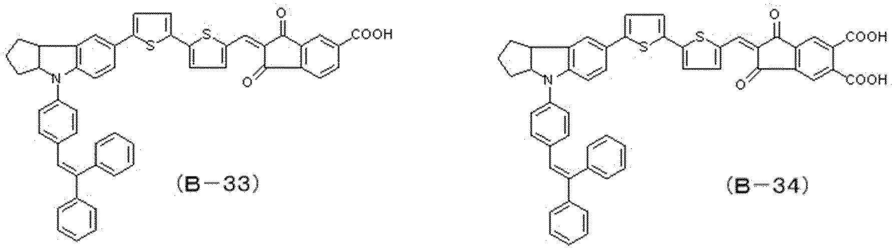

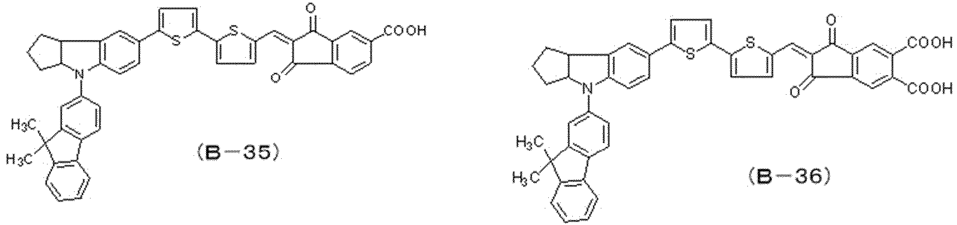

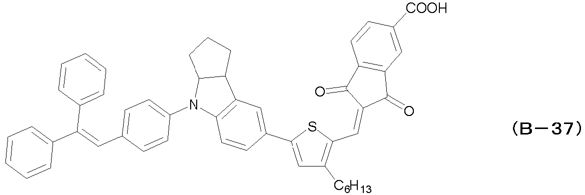

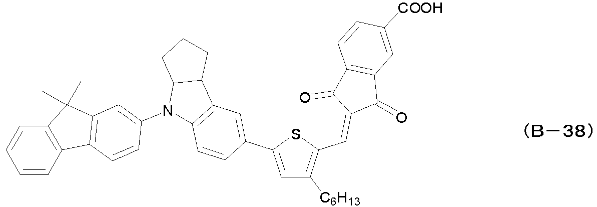

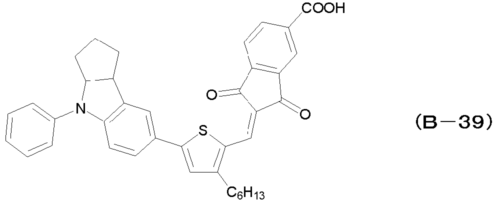

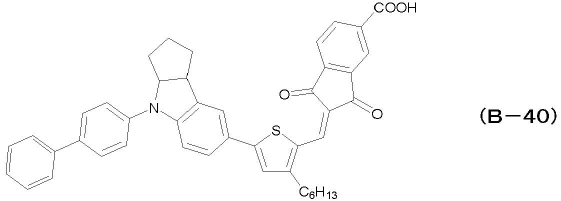

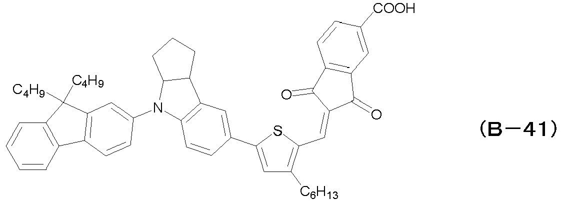

Moreover, examples of the photosensitization compound that is preferably used include a compound represented by General Formula (7).

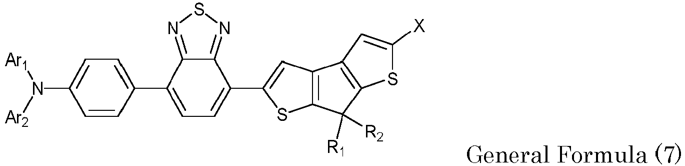

In General Formula (7), Ar₁ and Ar₂ are each an aryl group that may have a substituent; R₁ and R₂ are each a C4-C10 straight-chain or branched-chain alkyl group; and X is a substituent represented by any of the following structural formulae.

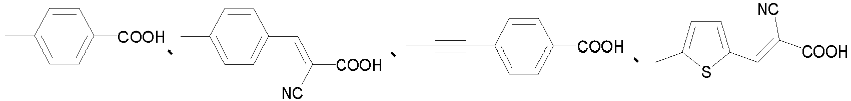

Among the photosensitization compound represented by General Formula (7), a compound represented by General Formula (8) is more preferably used.

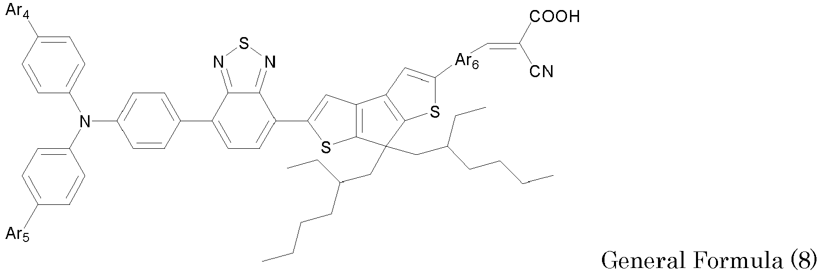

In General Formula (7), Ar₄ and Ar₅ are each a phenyl group that may have a substituent or a naphthyl group that may have a substituent; and Ar₆ are each a phenyl group that may have a substituent or a thiophene group that may have a substituent.

Specific exemplified compounds of the photosensitization compounds represented by General Formulae (7) and (8) will be listed below, but the photosensitization compound for use in the present disclosure is not limited to the following exemplified compounds.

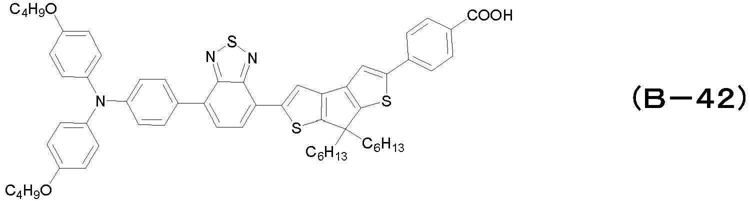

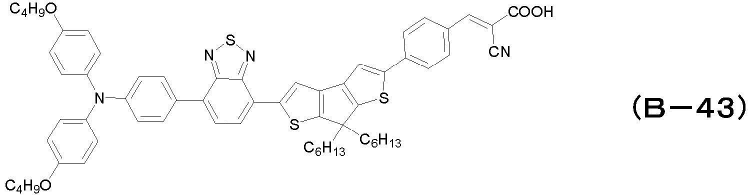

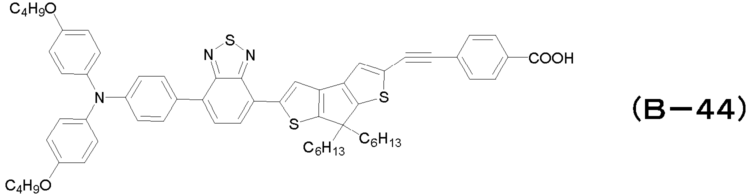

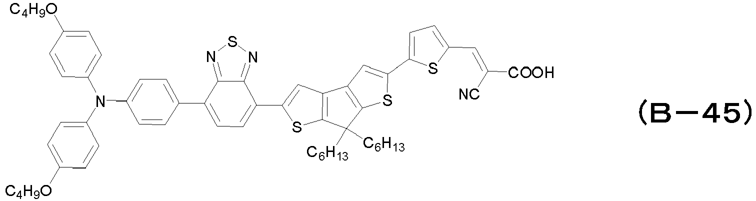

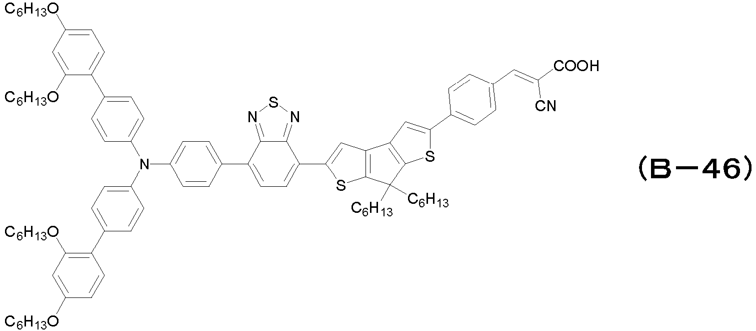

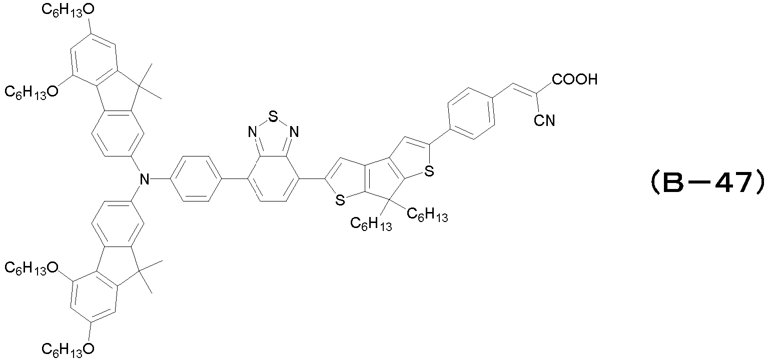

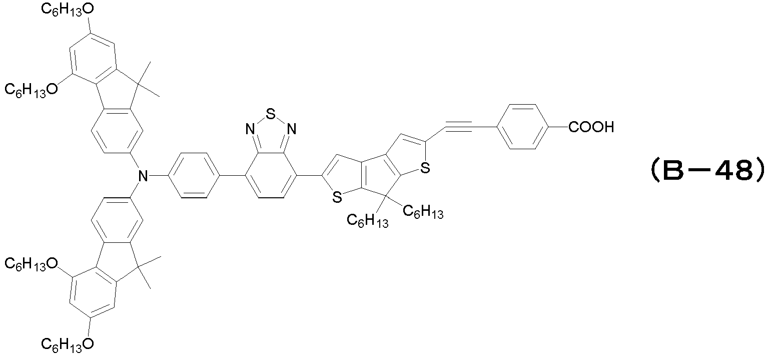

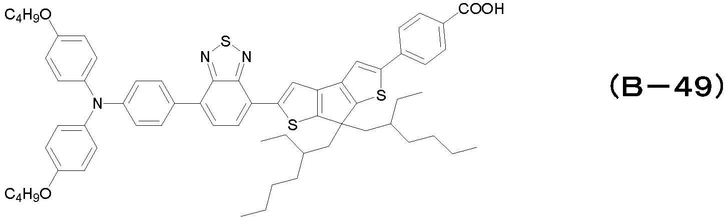

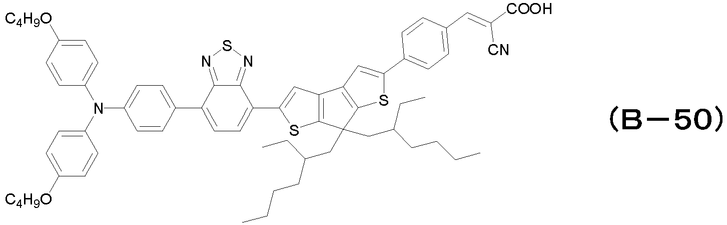

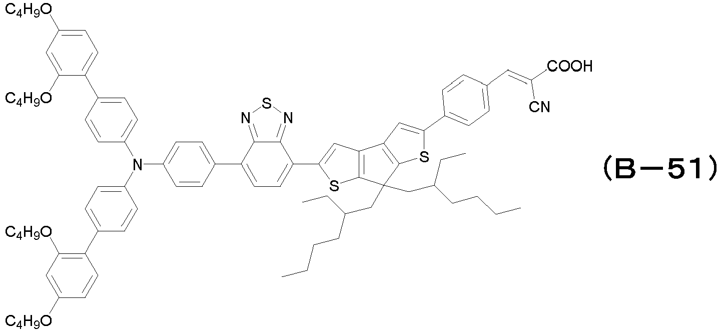

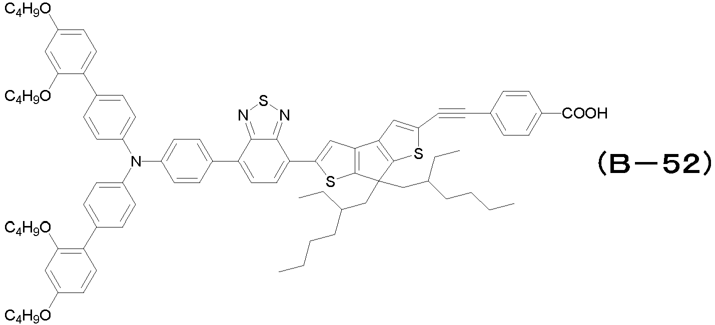

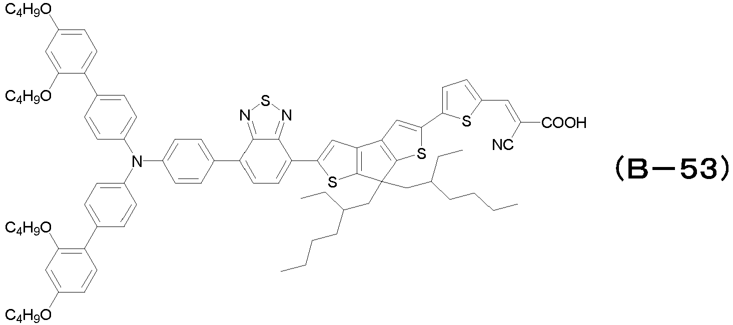

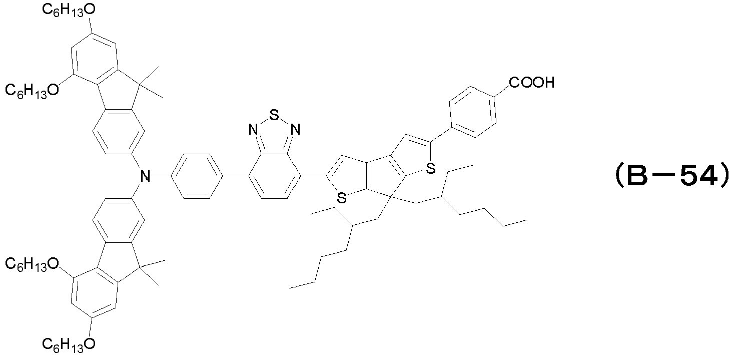

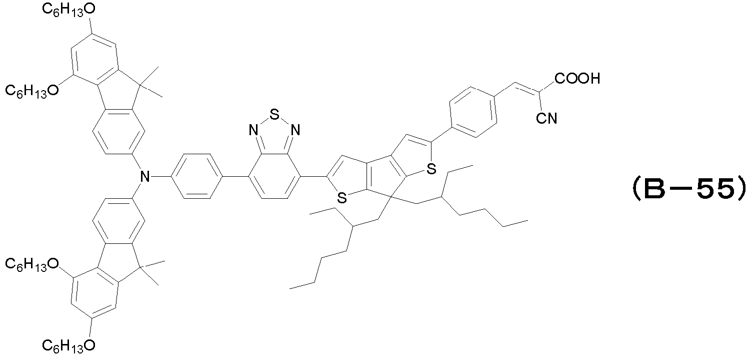

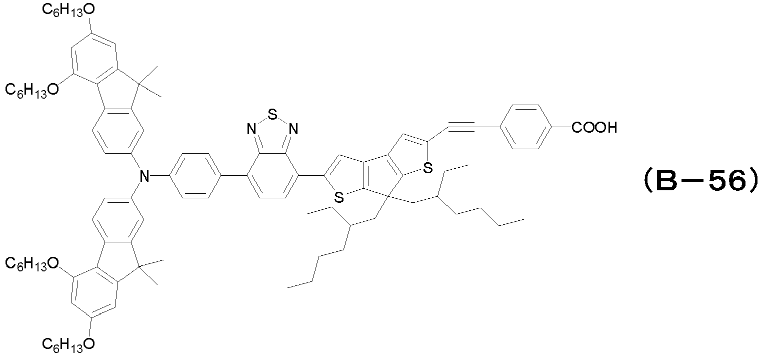

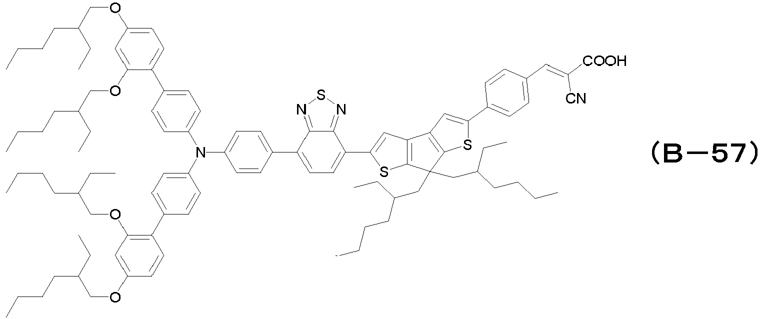

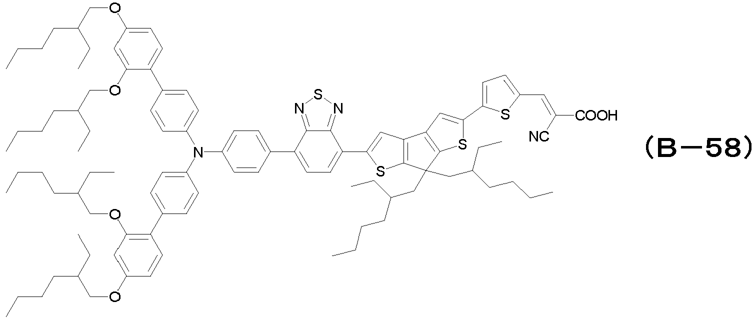

Among the above-listed photosensitization compounds, one of the photosensitization compounds may be used, or two or more of the photosensitization compounds may be used in combination. As a LED light source, light sources of different color tones, such as a warm color, a cold color, and a white color, are used, and spectra thereof are different depending on the color tones. For example, a light source having a color temperature of 3,000 K has a relatively strong tint in the region of 600 nm and emits redish light. A light source having a color temperature of 5,000 K emits light of a day light white color that is balanced over all. A light source having a color temperature of greater than 6,500 K has a relatively strong tint in the region of 450 nm and emits light of a bluish day light color. Accordingly, it is preferred that high output be maintained even when the color temperature of LED for use varies. In this case, mixing different photosensitization compounds is effective because a variation in output due to the color temperature may be reduced.

As a method for adsorbing the first photosensitization compound on the surface of the semiconductor material of the electron-transporting layer, usable methods are a method where the electron-transporting layer including the semiconductor material is immersed in a solution or dispersion liquid of the photosensitization compound, and a method where a solution or dispersion liquid of the photosensitization compound is applied onto the electron-transporting layer to allow the photosensitization compound to be adsorbed thereon. When the electron-transporting layer including the semiconductor material is immersed in a solution or dispersion liquid of the photosensitization compound, immersion, dipping, roller coating, or air knife coating may be used.

When the photosensitization compound is adsorbed on the electron-transporting layer by applying the solution or dispersion liquid of the photosensitization compound onto the electron-transporting layer, wire bar coating, slide hopper coating, extrusion coating, curtain coating, spin coating, or spray coating may be used. Moreover, adsorption may be performed in a supercritical fluid using carbon dioxide etc.

When the photosensitization compound is allowed to be adsorbed on the semiconductor material, a condensing agent may be used.

The condensing agent may be an agent exhibiting a catalytic action to physically or chemically bond the photosensitization compound to the surface of the semiconductor material, or an agent exhibiting stoichiometric action to advantageously sift the chemical equilibrium. Moreover, thiol or a hydroxyl compound may be further added as a condensation aid.

Examples of a solvent for dissolving or dispersing the photosensitization compound include water, an alcohol solvent, a ketone solvent, an ester solvent, an ether solvent, an amide solvent, a halogenated hydrocarbon solvent, and a hydrocarbon solvent.

Examples of the alcohol solvent include methanol, ethanol, and isopropyl alcohol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethylether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

The photosensitization compound may function more effectively when aggregation between particles of each compound is prevented, although it depends on the photosensitization compound for use. Therefore, an aggregation dissociating agent may be used in combination. Examples of the aggregation dissociating agent include steroid compounds (e.g., cholic acid and chenodexycholic acid), long-chain alkyl carboxylic acid, and long-chain alkyl phosphonic acid.

An amount of the aggregation dissociating agent is preferably 0.5 parts by mol or greater but 100 parts by mol or less, and more preferably 10 parts by mol or greater but 50 parts by mol or less, relative to 1 part by mol of the photosensitization compound.

A temperature at which the photosensitization compound or a combination of the photosensitization compound and the aggregation dissociating agent are adsorbed on the surface of the semiconductor material constituting the electron-transporting layer is preferably -50°C or higher but 200°C or lower. The adsorption time is preferably 5 seconds or longer but 1,000 hours or shorter, more preferably 10 seconds or longer but 500 hours or shorter, and even more preferably 1 minute or longer but 150 hours or shorter. The adsorption is preferably performed in the dark. Moreover, the adsorption may be performed with standing still, or with stirring.

A method for the stirring is not particularly limited, and may be appropriately selected depending on the intended purpose. Examples thereof include methods using a stirrer, a ball mill, a paint conditioner, sand mill, Attritor, a disperser, or ultrasonic dispersion.

Moreover, the photoelectric conversion element of the present disclosure may include a perovskite layer. Use of the perovskite layer in the photoelectric conversion element is effective. The perovskite layer is a layer that includes a perovskite and is configured to absorb light to sensitize the electron-transporting layer. Therefore, the perovskite layer is preferably disposed next to the electron-transporting layer.

The perovskite compound is a composite material of an organic compound and an inorganic compound, and is represented by General Formula (9) below.

XαYβMγ General Formula (9)

In General Formula (9), the ratio α:β:γ is 3:1:1, and β and γ are each an integer greater than 1. For example, X may be a halogen ion, Y may be an alkylamine compound ion, and M may be a metal ion.

X in General Formula (9) is not particularly limited, and may be appropriately selected depending on the intended purpose. Examples thereof include halogen ions, such as a chloride ion, a bromine ion, and an iodine ion. The above-listed examples may be used alone or in combination.

Examples of Y in General Formula (9) include alkylamine compound ions (e.g., a methylamine ion, an ethylamine ion, an n-butylamine ion, and a formamidine ion), a cesium, potassium, and rubidium. In case of a perovskite compound of halogenated lead-methyl ammonium, moreover, the peak λmax of the light absorption spectrum is about 350 nm when the halogen ion is Cl, the peak λmax of the light absorption spectrum is about 410 nm when the halogen ion is Br, and the peak λmax of the light absorption spectrum is about 540 nm when the halogen ion is I. Since the peak λmax of the light absorption spectrum sequentially sifts to the longer wavelength side as described, the usable spectrum width (band width) varies.

M in General Formula (9) is not particularly limited, and may be appropriately selected depending on the intended purpose. Examples thereof include metals, such as lead, indium, antimony, tin, copper, and bismuth.

Moreover, the perovskite layer preferably has a layered perovskite structure where layers each formed of halogenated metal and layers each formed by aligning organic cation molecules are alternately laminated.

A method for forming the perovskite layer is not particularly limited, and may be appropriately selected depending on the intended purpose. Examples thereof include a method where halogenated metal or halogenated alkyl amine is dissolved or dispersed to prepare a solution, the solution is applied, and the applied solution is dried.

Moreover, examples of a method for forming the perovskite layer include a two-step precipitation method where a solution obtained by dissolving or dispersing halogenated metal is applied, and dried, and the resultant is immersed in a solution obtained by dissolving halogenated alkyl amine to form a perovskite compound.

Furthermore, examples of the method for forming the perovskite layer include a method where a solution obtained dissolving or dispersing halogenated metal and halogenated alkyl amine is applied with adding a poor solvent of the perovskite compound (a solvent having low dissolution power to the perovskite compound), to precipitate crystals. In addition, examples of the method for forming the perovskite layer include where halogenated metal is deposited through vapor deposition in an atmosphere filled with gas including methyl amine.

Among the above-listed examples, preferable is the method where a solution obtained by dissolving or dispersing halogenated metal and halogenated alkyl amine with adding a poor solvent of the perovskite compound to precipitate crystals.

A method for applying the solution is not particularly limited, and may be appropriately selected depending on the intended purpose. Examples thereof include immersion, spin coating, spray coating, dip coating, roller coating, and air knife coating. Moreover, the method for applying the solution may be a method where precipitation is performed in a supercritical fluid using carbon dioxide etc.

Moreover, the perovskite layer may include a photosensitization compound. The sensitization dye served as the photosensitization compound is not particularly limited, as long as the sensitization dye is a compound that is photoexcited by excitation light for use, and may be appropriately selected depending on the intended purpose. Examples thereof include the above-listed photosensitization compounds.

A method for forming the perovskite layer including the sensitization dye is not particularly limited, and may be appropriately selected depending on the intended purpose. Examples thereof include a method where the perovskite compound and the photosensitization compound are mixed, and a method where the photosensitization compound is adsorbed after forming the perovskite layer.

### <Second electrode>

The second electrode may be formed on the hole-transporting layer, or on the metal oxide of the hole-transporting layer. Moreover, the second electrode may be identical to the first electrode. A second substrate is not necessarily disposed when strength of the resultant photoelectric conversion element is sufficiently maintained.

Examples of a material of the second electrode include metals, carbon compounds, conductive metal oxide, and conductive polymers.

Examples of the metals include platinum, gold, silver, copper, and aluminium.

Examples of the carbon compounds include graphite, fullerene, carbon nanotubes, and graphene.

Examples of the conductive metal oxide include ITO, FTO, and ATO.

Examples of the conductive polymers include polythiophene, and polyaniline.

The above-listed examples may be used alone or in combination.

The second electrode can be formed on the hole-transporting layer by an appropriate method, such as coating, laminating, vapor deposition, CVD, or bonding depending on a material for use or a type of the hole-transporting layer.

In the photoelectric conversion element of the present disclosure, at least one of the first electrode and the second electrode is preferably substantially transparent. A preferable embodiment is that the side of the first electrode is transparent, and incident light is allowed to enter from the side of the first electrode. In this case, a material that reflects light is preferably used for the side of the second electrode. As the material that reflects light, metal, glass or plastic on which conductive oxide is deposited through vapor deposition, or a thin metal film is preferably used. Moreover, it is also effective to dispose an antireflection layer at the side of the incident light.

### <Second substrate>

The second substrate is not particularly limited. Any of substrates known in the art may be used as the second substrate. Examples thereof include substrates, such as glass, a plastic film, and ceramic. In order to improve adhesion at the contact area between the second substrate and the sealing member, the rough surface texture (convex-concave shapes) may be imparted.

A method for imparting the rough surface texture is not particularly limited, and may be appropriately selected depending on the intended purpose. Examples thereof include sand blasting, water blasting, polishing, chemical etching, and laser processing.

As method for improving adhesion between the second substrate and the sealing member, for example, organic matter deposited on the surface of the second substrate may be removed, or hydrophilicity of the surface thereof may be improved. The method for removing the organic matter deposited on the surface of the second substrate is not particularly limited, and may be appropriately selected depending on the intended purpose. Examples thereof include UV ozone washing, and an enzyme plasma treatment.

### <<Sealing member>>

A sealing member can be used for the photoelectric conversion element of the present disclosure and use of the sealing member can be effective. The sealing member is capable of sealing at least the electron-transporting layer and the hole-transporting layer from the external environment of the photoelectric conversion element. In other words, the photoelectric conversion element of the present disclosure preferably further includes a sealing member configured to seal the photoelectric conversion layer from the external environment of the photoelectric conversion element.

Any of members known in the art can be used as the sealing member, as long as the sealing member is a member capable of suppressing entry of an excessive amount of moisture or oxygen into the internal part of the seal from the external environment. Moreover, the sealing member has an effect of preventing mechanical breakage that may be caused when the photoelectric conversion element is pressed from outside. As long as such an effect can be imparted, any of members known in the art can be used as the sealing member.

The sealing system is roughly classified into "frame sealing" where a sealing member is disposed on the peripheral area of the power generation region composed of the photoelectric conversion layer of the photoelectric conversion element photoelectric conversion layer, and is bonded to the second substrate, and "plane sealing" where a sealing member is disposed on the entire plane of the power generation region, and is bonded to the second substrate. The former "frame sealing" can form a hollow section inside the seal, the moisture content or oxygen content inside the seal can be appropriately adjusted. In addition, the second electrode does not come into contact with the sealing member, which leads to an effect that a possibility of the second electrode being peeled off is reduced. Meanwhile, the latter "plane sealing" has an excellent effect of preventing entry of excess water or oxygen from outside, and a large contact area with the sealing member can be secured. Therefore, high sealing strength can be obtained, and the plane sealing is particularly suitable when a flexible substrate is used as the first substrate.

A type of the sealing member is not particularly limited and may be appropriately selected depending on the intended purpose. Examples thereof include a curing resin and a low melting point glass resin. The curing resin is not particularly limited as long as the curing resin is a resin that can be cured with light or heat, and may be appropriately selected depending on the intended purpose. Among the curable resins with light or heat, an acrylic resin and an epoxy resin are preferably used.

As the cured product of the acrylic resin, any of materials known in the art can be used as long as the cured product is a product obtained by curing a monomer or oligomer including an acryl group in a molecule thereof.

As the cured product of the epoxy resin, any of materials known in the art can be used as long as the cured product is a product obtained by curing a monomer or oligomer including an epoxy group in a molecule thereof.

Examples of the epoxy resin include a water-dispersible epoxy resin, a non-solvent epoxy resin, a solid epoxy resin, a heat curable epoxy resin, a curing agent-mixed epoxy resin, and a UV curable epoxy resin. Among the above-listed examples, a heat curable epoxy resin and a UV curable epoxy resin are preferable, and a UV curable epoxy resin is more preferable. Heating may be performed on a UV curable epoxy resin. Heating is preferably performed even after curing the UV curable epoxy resin with UV irradiation.

Examples of the epoxy resin include a bisphenol A epoxy resin, a bisphenol F epoxy resin, a novolac epoxy resin, an alicyclic epoxy resin, a long-chain aliphatic epoxy resin, glycidyl amine epoxy resin, a glycidyl ether epoxy resin, and a glycidyl ester epoxy resin. The above-listed examples may be used alone or in combination.

The epoxy resin is preferably mixed with a curing agent or various additives according to the necessity.

The curing agent is classified into an amine-based curing agent, an acid anhydride-based curing agent, a polyamide-based curing agent, and other curing agents, and may be appropriately selected depending on the intended purpose.

Examples of the amine-based curing agent include: aliphatic polyamine, such as diethylene triamine, and triethylene tetramine; and aromatic polyamine, such as m-phenylene diamine, diaminodiphenylmethane, and diaminodiphenylsulfone.

Examples of the acid anhydride-based curing agent include phthalic anhydride, tetrahydrophthalic anhydride, hexahydrophthalic anhydride, methyltetrahydrophthalic anhydride, methylnadic anhydride, pyromellitic anhydride, HET anhydride, and dodecenylsuccinic anhydride.

Examples of other curing agents include imidazoles and polymercaptan. The above-listed examples may be used alone or in combination.

Examples of the additive include filler, gap agents, polymerization initiators, drying agents (moisture absorbents), curing accelerators, coupling agents, flexibilizers, colorants, flame retardant auxiliaries, antioxidants, and organic solvents. Among the above-listed examples, filler, a gap agent, a curing accelerator, a polymerization initiator, and a drying agent (moisture absorbent) are preferable, and filler and a polymerization initiator are more preferable.

The filler is effective in preventing entry of moisture and oxygen, as well as exhibiting effects of reducing volumetric shrinkage during curing, reducing an amount of outgas generated during curing or heating, improving mechanical strength, controlling thermal conductivity or fluidity, and is very effective in maintaining stable output in various environments. Particularly, output characteristics and durability of the photoelectric conversion element are influenced not only by moisture or oxygen entered but also by outgas generated during curing or heating of the sealing member. The gas generated as outgas during heating significantly affects output characteristics when the photoelectric conversion element is stored in a high temperature environment.

In this case, the filler, the gap agent, or the drying agent are added to the sealing member. As a result, entry of moisture or oxygen can be suppressed by such additives themselves, and an amount of the sealing member to be used can be reduced, and therefore generation of outgas can be reduced. Addition of such additives can be also effective not only for curing, but also when photoelectric conversion element is stored in a high temperature environment.

The filler is not particularly limited, and may be appropriately selected depending on the intended purpose. For example, inorganic filler, such as crystalline or amorphous silica, talc, alumina, aluminum nitride, silicon nitride, calcium silicate, and calcium carbonate, is preferably used. The above-listed examples may be used alone or in combination. The average primary particle diameter of the filler is preferably 0.1 µm or greater but 10 µm or less, and more preferably 1 µm or greater but 5 µm or less. When the average primary particle diameter is within the above-mentioned preferable range, entry of moisture or oxygen can be sufficiently suppressed, appropriate viscosity of the sealing member can be obtained, adhesion to a substrate and defoamability can be improved, a width of sealing can be controlled, and desirable processability is obtained.

An amount of the filler is preferably 10 parts by mass or greater but 90 parts by mass or less, and more preferably 20 parts by mass or greater but 70 parts by mass or less, relative to 100 parts by mass of the entire sealing member. When the amount of the filler is within the above-mentioned range, entry of moisture or oxygen can be sufficiently suppressed, appropriate viscosity of the sealing member can be obtained, and desirable adhesion and processability are obtained.

The gas agent is also called a gap controlling agent or a spacer agent, and can control a gap formed at the sealing area. When the sealing member is applied onto the first substrate or the first electrode, the second substrate is placed thereon, and the stacked structure is sealed, a gap at the sealing area matches with the size of the gap agent as the epoxy resin includes the gap agent. As a result, it is possible to easily control the gap of the sealing area.

Any of materials known in the art can be used as the gap agent, as long as the material is particles having a uniform particle diameter and has high solvent resistance or heat resistance. The material of the gap agent is preferably a material having high affinity to an epoxy resin and being spherical particles. Specific examples thereof include glass beads, silica particles, and organic resin particles. The above-listed examples may be used alone or in combination.

The particle diameter of the gap agent can be selected depending on the gap of the sealing area to be set. The particle diameter thereof is preferably 1 µm or greater but 100 µm or less, more preferably 5 µm or greater but 50 µm or less.

Examples of the polymerization initiator include a thermal polymerization initiator that induces polymerization with heat, and a photopolymerization initiator that incudes polymerization with light.

The thermal polymerization initiator is a compound that generates active species, such as radicals or cations, upon application of heat. Specifically, an azo compound, such as 2,2'-azobisbutyronitrile (AIBN), or peroxide, such as benzoyl peroxide (BPO) is used as the thermal polymerization initiator. As the cationic thermal polymerization initiator, benzenesulfonic acid ester or alkyl sulfonium salt may be used. As the photopolymerization initiator, a cationic photopolymerization initiator is preferably used in case of an epoxy resin. When a cationic photopolymerization initiator is blended in the epoxy resin and light irradiation is performed, the cationic photopolymerization initiator is decomposed to generate strong acid, the acid induces polymerization of the epoxy resin to proceed with a curing reaction. The cationic photopolymerization initiator has advantages that that volumetric shrinkage during curing is small, oxygen inhibition does not occur, and storage stability is high.

Examples of the cationic photopolymerization initiator include aromatic diazonium salt, aromatic iodonium salt, aromatic sulfonium salt, a metallocene compound, and a silanol-aluminum complex

Moreover, a photoacid generator capable of generating acid upon irradiation of light may be used. The photoacid generator functions as acid that initiates a cationic polymerization. Examples thereof include onium salts such as ionic sulfonium salt-based onium salts and ionic iodonium salt-based onium salts including a cation part and an ionic part. The above-listed examples may be used alone or in combination.

An amount of the polymerization initiator may vary depending on materials for use. The amount of the polymerization initiator is preferably 0.5 parts by mass or greater but 10 parts by mass or less, and more preferably 1 part by mass or greater but 5 parts by mass or less, relative to 100 parts by mass of the entire sealing member. The amount of the polymerization initiator within the above-mentioned range is effective because curing is progressed appropriately, an amount of uncured residues can be reduced, and excessive generation of outgas can be prevented.

The drying agent is also called a moisture absorbent and is a material having a function of physically or chemically adsorbing or absorbing moisture. Inclusion of the drying agent in the sealing member is effective because moisture resistance may be further improved and influence of outgassing can be decreased in some cases.

The drying agent is preferably particulate. Examples thereof include inorganic water-absorbing materials such as calcium oxide, barium oxide, magnesium oxide, magnesium sulfate, sodium sulfate, calcium chloride, silica gel, molecular sieve, and zeolite. Among the above-listed examples, zeolite or calcium oxide is preferable because zeolite or calcium oxide absorbs a large amount of moisture. The above-listed examples may be used alone or in combination.

The curing accelerator is also called a curing catalyst and is used for the purpose of accelerating curing speed. The curing accelerator is mainly used for a heat-curable epoxy resin.

Examples of the curing accelerator include: tertiary amine or tertiary amine salt such as 1,8-diazabicyclo(5,4,0)-undecene-7 (DBU) and 1,5-diazabicyclo(4,3,0)-nonene-5 (DBN); imidazole-based compounds such as 1-cyanoethyl-2-ethyl-4-methylimidazole and 2-ethyl-4-methylimidazole; and phosphine or phosphonium salt such as triphenylphosphine and tetraphenylphosphonium-tetraphenyl borate. The above-listed examples may be used alone or in combination.

The coupling agent has an effect of enhancing a bonding force between molecules, and examples thereof include silane coupling agents. Specific examples thereof include: silane coupling agents such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. The above-listed examples may be used alone or in combination.

As the sealing member, resin compositions that are commercially available as sealing materials, seal materials, or adhesives have been known, and can be effectively used in the present disclosure. Among the above-listed examples, there are epoxy resin compositions that are developed and are commercially available to be used in solar battery cells or organic EL elements, and can be particularly effectively used in the present disclosure. Examples of the commercially available products of the epoxy resin include product names: TB3118, TB3114, TB3124, and TB3125F (all of which are available from ThreeBond), World Rock 5910, World Rock 5920, and World Rock 8723 (all available from Kyoritsu Chemical & Co., Ltd.), and WB90US(P) (available from MORESCO).

After applying the low-melting point glass resin, the resin is fired at about 550°C to decompose the resin component, and the resin is melted with infrared laser etc., to adhere to the glass substrate. At this time, the glass component having a low melting temperature is diffused inside the metal oxide layer and is physically joined, to thereby obtain high sealing performance Since the resin component disappears, moreover, outgas as seen with an acryl resin or an epoxy resin is not generated, and therefore deterioration of the photoelectric conversion element is prevented.

In the present disclosure, a sheet-form sealing material may be used as the sealing member. For example, the sheet-form sealing material is a sheet on which an epoxy resin layer has been formed in advance, where the sheet is glass or a film having high gas barrier properties and corresponds to the second substrate of the present disclosure. Formation of the sealing member and the second substrate can be performed at once by bonding the sheet-form sealing material onto the second electrode, followed by curing. Use of the sheet-form sealing material is effective because a structure including a hollow section can be created depending on the formation pattern of the epoxy resin layer formed on the sheet. When the resin layer is formed on the entire area of the sheet, sealing achieves "surface sealing." When a resin layer is formed to include a hollow section inside the photoelectric conversion element according to the formation pattern of the resin layer, sealing achieves "frame sealing."

A formation method of the sealing member is not particularly limited, and the sealing member can be formed by a known method. For example, various methods, such as dispensing, wire bar coating, spin coating, roller coating, blade coating, gravure coating, relief printing, offset printing, intaglio printing, rubber plate printing, and screen printing, may be used.

Moreover, a passivation layer may be disposed between the sealing member and the second electrode. The passivation layer is not particularly limited as long as the passivation layer is disposed so that the sealing member does not come into contact with the second electrode, and may be appropriately selected depending on the intended purpose. As the passivation layer, aluminium oxide, silicon nitride, or silicon oxide is preferably used.

It may be effective for improvement in durability of the photoelectric conversion element to introduce oxygen into the hollow section inside the sealing because a hole-transporting function of the hole-transporting layer can be maintained stably over a long period. In the present disclosure, it is preferable that oxygen is introduced in the hollow section inside the sealing, where the hollow section is created by sealing. The oxygen concentration therein is more preferably 10.0% by volume or greater but 21.0% by volume or less.

The oxygen concentration in the hollow section can be controlled by performing sealing inside the glove box in which the oxygen concentration is adjusted. The adjustment of the oxygen concentration can be performed by a method using a gas cylinder including gas having the predetermined oxygen concentration, or a method using a nitrogen gas generating device. The oxygen concentration inside the glove box can be measured by means of a commercially available oxygen meter or oxygen monitor.

The oxygen concentration inside the hollow section formed by sealing can be measured, for example, by internal vapor analysis (IVA). Specifically, IVA is a method where the photoelectric conversion element is mounted in a highly vacuumed area and a hole is made in the photoelectric conversion element to generate gas or moisture, and mass spectrometry is performed on the generated gas or moisture. According to the above-described method, the concentration of the oxygen included inside the sealed photoelectric conversion element can be determined. As mass spectrometry, there are quadrupole mass spectrometry and time of flight mass spectrometry. The time of flight mass spectrometry enables a measurement with the higher sensitivity.

Gas included inside the sealed photoelectric conversion element other than oxygen is preferably inert gas, and more preferably nitrogen or argon.

When sealing is performed, as well as the oxygen concentration, a dew point inside the glove box is preferably controlled. To adjust the dew point is effective for improving output or durability of the photoelectric conversion element. The dew point is determined as a temperature at which condensation starts when gas including water vapor is cooled.

The dew point is not particularly limited. The dew point is preferably 0°C or lower, and more preferably -20°C or lower. The lower limit of the dew point is preferably -50°C or higher.

### «Hole-blocking layer»

The hole-blocking layer is preferably further formed and is very effective for improving output and improving sustainability of the output. The hole-blocking layer is formed between the first electrode and the electron-transporting layer. In other words, the photoelectric conversion element of the present disclosure preferably further includes the hole-blocking layer disposed between the first electrode and the photoelectric conversion layer.

The hole-blocking layer is capable of transporting electrons generated by the photosensitization compound and transported to the electron-transporting layer to the first electrode, and preventing contact with the hole-transporting layer. As a result, the hole-blocking layer can prevent holes from flowing into the first electrode, and can prevent reduction in output caused by recombination of electrons and holes. The solid photoelectric conversion element, in which the hole-transporting layer is disposed, has the faster speed of recombination between holes in the hole-transporting material and electrons on the surface of the electrode compared to a wet photoelectric conversion element using an electrolytic solution. Therefore, an effect obtained by forming the hole-blocking layer is significant.

A material of the hole-blocking layer is not particularly limited as long as the material is transparent to visible light and has electron-transporting capabilities, and may be appropriately selected depending on the intended purpose. Examples of the material include: an element semiconductor, such as silicon, and germanium; a compound semiconductor, such as chalcogenide of metal; and a compound having a perovskite structure.

Examples of the chalocogenide of metal include: oxides of titanium, tin, zinc, iron, tungsten, zirconium, hafnium, strontium, indium, cerium, yttrium, lanthanum, vanadium, niobium, tantalum, etc.; sulfides of cadmium, zinc, lead, silver, antimony, bismuth, etc.; selenides of cadmium, lead, etc.; and tellurium compounds of cadmium, etc. Examples of other compound semiconductors include: phosphides of zinc, gallium, indium, cadmium, etc.; gallium arsenide; copper-indium-selenide; and copper-indium-sulfide.

Examples of the compound having the perovskite structure include strontium titanate, calcium titanate, sodium titanate, barium titanate, and potassium niobate.

Among the above-listed materials, an oxide semiconductor is preferable, titanium oxide, niobium oxide, magnesium oxide, aluminium oxide, zinc oxide, tungsten oxide, and tin oxide are more preferable, and titanium oxide is more preferable.

The above-listed examples may be used alone or in combination. The hole-blocking layer may be a single layer, or a multiple layer. Moreover, a crystal type of the above-mentioned semiconductor is not particularly limited, and may be appropriately selected depending on the intended purpose. The semiconductor may be monocrystalline, polycrystalline, or amorphous.

A production method of the hole-blocking layer is not particularly limited, and may be appropriately selected depending on the intended purpose. Examples of the production method thereof include a method for forming a thin film in vacuum (a vacuum film formation method), and a wet film formation method.

Examples of the vacuum film formation method include sputtering, pulsed laser deposition (PLD), ion-beam sputtering, ion-assisted deposition, ion plating, vacuum vapor deposition, atomic layer deposition (ALD), and chemical vapor deposition (CVD).

Examples of the wet film formation method include a sol-gel method. According to the sol-gel method, a solution is subjected to a chemical reaction, such as hydrolysis, polymerization, and condensation, to form a gel, followed by performing a heat treatment to accelerate densification of the gel. When the sol-gel method is used, a coating method of the sol solution is not particularly limited, and may be appropriately selected depending on the intended purpose. Examples of the coating method include dip coating, spray coating, wire bar coating, spin coating, roller coating, blade coating, and gravure coating. Moreover, a wet printing method may be used as the coating method. Examples of the wet printing method include relief printing, offset printing, gravure printing, intaglio printing, rubber plate printing, and screen printing. Moreover, a temperature of a heat treatment performed after applying the sol solution is preferably 80°C or higher, and more preferably 100°C or higher.

The average thickness of the hole-blocking layer is not particularly limited, and may be appropriately selected depending on the intended purpose. The average thickness of the hole-blocking layer is preferably 5 nm or greater but 1 µm or less. In case of wet film formation, the average thickness thereof is more preferably 500 nm or greater but 700 nm or less. In case of dry film formation, the average thickness thereof is more preferably 5 nm or greater but 30 nm or less.

Examples of the photoelectric conversion element of the present disclosure will be described with reference to drawings hereinafter. However, the present disclosure is not limited to the following embodiments. For example, the number of the following constitutional members, the positions of the following constitutional members, and the shapes of the following constitutional members, which will not be described in the following embodiments, are also included in the scope of the present disclosure.

### <First embodiment>

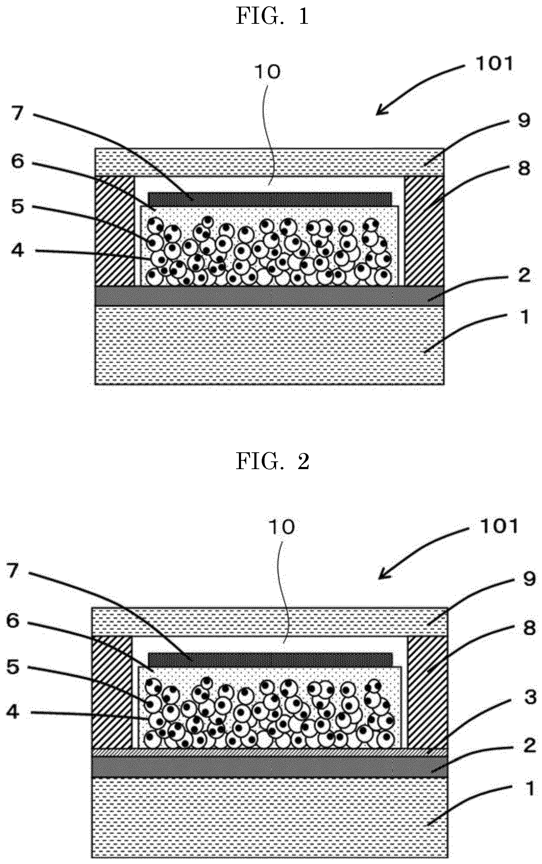

FIG. 1 is a schematic view illustrating an example of the photoelectric element of the first embodiment. The photoelectric conversion element 101 of the first embodiment of FIG. 1 includes a first electrode 2 formed on a first substrate 1. An electron-transporting layer 4 is formed on the first electrode 2, and a photosensitization compound 5 is adsorbed on a surface of an electron-transporting material constituting the electron-transporting layer 4. At the upper part and inner part of the electron-transporting layer 4, a hole-transporting layer 6 is formed. A second electrode 7 is formed on the hole-transporting layer 6. A second substrate 9 is arranged above the second electrode 7. The second substrate 9 is fixed with the first electrode 2 by a sealing member 8. The sealing member 8 can be also adhered to the first substrate 1 not the first electrode 2, which may be effective for enhancing sealability.

The photoelectric conversion element 101 of the first embodiment of FIG. 1 has a hollow section 10 between the second electrode 7 and the second substrate 9. Since the hollow section 10 is arranged, it is possible to control the moisture content or the oxygen concentration inside the hollow section. As a result, the power generation performance or durability of the photoelectric conversion element can be enhanced. Since the second electrode 7 and the second substrate 9 are not in contact with each other, moreover, the detachment or breakage of the second electrode 7 can be prevented. The oxygen concentration inside the hollow section is not particularly limited and can be freely controlled. The oxygen concentration inside the hollow section is preferably 10% or greater but 21% or less.

Although it is not illustrated, each of the first electrode 2 and the second electrode 7 has a conduction path to an electrode extraction terminal.

### <Second embodiment>

FIG. 2 is a schematic view illustrating an example of the photoelectric conversion element of the second embodiment. The photoelectric conversion element 101 of the second embodiment of FIG. 2 includes a hole-blocking layer 3 between a first substrate 1 and an electron-transporting layer 4. Formation of the hole-blocking layer 3 effective for improvement in the power generation performance because recombination between electrons and holes can be prevented. Similarly to FIG. 1, the photoelectric conversion element illustrated in FIG. 2 has a hollow section 10 between a second electrode 7 and a second substrate 9.

### <Third embodiment>

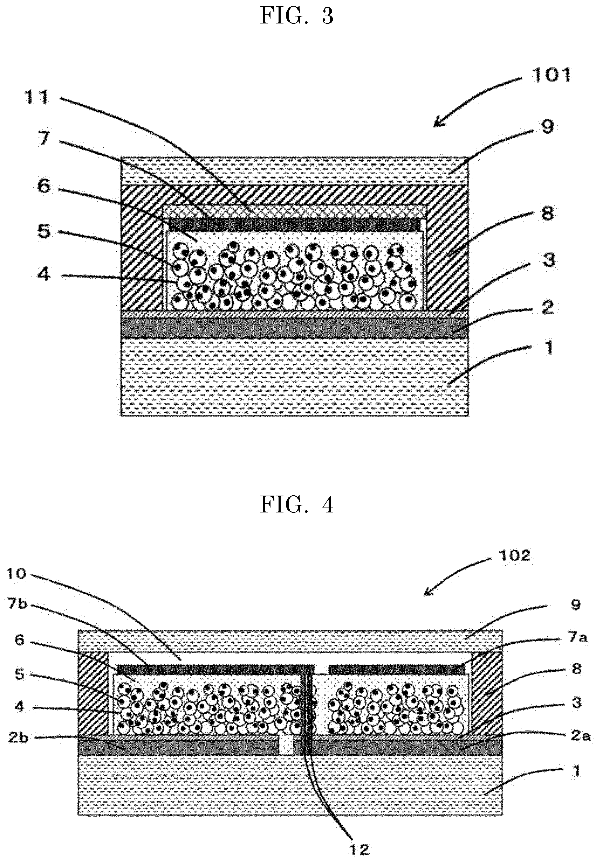

FIG. 3 is a schematic view illustrating an example of the photoelectric conversion element of the third embodiment. The photoelectric conversion element 101 of the third embodiment of FIG. 3 is the photoelectric conversion element of FIG. 2, in which the hollow section 10 is covered with a sealing member 8 to seal the entire surface. For example, the sealing member 8 can be formed by a method where the sealing member 8 is applied onto the entire surface of the second electrode7, followed by disposing the second substrate 9 on the sealing member 8, or a method where the above-described sheet-form sealing material is used. In this case, a passivation layer 11 can be disposed between the second electrode 7 and the sealing member 8, and formation of the passivation layer 11 may be effective for preventing peeling of the second electrode. The mechanical strength of the photoelectric conversion element may be enhanced by coring almost the entire surface with the sealing member as described above.

### (Method for producing photoelectric conversion element)

A method for producing a photoelectric conversion element of the present disclosure includes forming a photoelectric conversion layer including a hole-transporting layer on a first electrode, and controlling an amount of a solvent in the hole-transporting layer. The hole-transporting layer includes lithium salt having an asymmetric structure. An amount of the solvent per unit volume of the hole-transporting layer is adjusted to 5.4 to 30 µg/mm³. The method may further include other steps according to the necessity.

The method for producing a photoelectric conversion element of the present disclosure includes forming a first electrode on a first substrate, forming a photoelectric conversion layer on the first electrode, and forming a second electrode on the photoelectric conversion layer, and may further include a step for forming other members, such as a hole-blocking layer and a sealing member, according to the necessity.

In the method for producing a photoelectric conversion element of the present disclosure, the first electrode, the photoelectric conversion layer, the second electrode, and other members and layers are identical to those described in the photoelectric conversion element of the present disclosure.

### <Photoelectric conversion layer forming step>

The photoelectric conversion layer forming step is a step including forming a photoelectric conversion layer including a hole-transporting layer on a first electrode.

The photoelectric conversion layer forming step is a step including forming the photoelectric conversion layer according to the method described with the photoelectric conversion layer of the photoelectric conversion element of the present disclosure.

### <Solvent amount controlling step>

The solvent amount controlling step is step including controlling an amount of a solvent included in the produced photoelectric conversion element. For example, the solvent amount controlling step includes heating after forming the hole-transporting layer.

As the solvent amount controlling step is performed, the included solvent component is evaporated to adjust the amount of the solvent included in the produced photoelectric conversion element to 5.4 to 30 µg/mm³ per unit volume of the hole-transporting layer.

In the solvent amount controlling step, any of methods used for drying known in the art may be used, such as a method for heating and drying after formation of a layer, a method for natural drying in a room temperature environment, and a method for blowing air. Among the above-listed examples, the method for heating and drying, which enables to control the solvent amount within a short period, is preferably used.

As the drying conditions in the solvent amount controlling step, drying is preferably performed for 10 minutes or longer but 24 hours or shorter at 20°C or higher but 130°C or lower under ambient pressure, and more preferably for 30 minutes or longer but 2 hours or shorter at 50°C or higher but 100°C or lower under ambient pressure.

A method for performing the heating and drying is not particularly limited as long as the above-described heating and drying conditions are achieved, and may be appropriately selected depending on the intended purpose. Examples thereof include the following methods. Specifically, any of methods known in the art can be used as long as the method is a method where the solvent in the hole-transporting layer can be evaporated by heating using an oven, a dryer, a thermostat chamber, or a hotplate.

### (Photoelectric conversion module)

The photoelectric conversion module of the present disclosure includes a plurality of the photoelectric conversion elements of the present disclosure, where the photoelectric conversion elements disposed next to one another are electrically connected in series or parallel.

For example, the photoelectric conversion module of the present disclosure has a photoelectric conversion element arranging region, in which a plurality of the photoelectric conversion elements are disposed next to one another and are connected in series or parallel. The photoelectric conversion module includes the photoelectric conversion elements, in each of which a photoelectric conversion layer including an electron-transporting layer and a hole-transporting layer is formed between a first electrode and a second electrode.

The photoelectric conversion module of the present disclosure includes a plurality of the photoelectric conversion elements. Moreover, the photoelectric conversion elements may be connected in series and/or parallel, or may include the photoelectric conversion element that is independently disposed without being connected to other photoelectric conversion elements.

The structure of each layer of the photoelectric conversion module of the present disclosure may be identical to the structure of each layer of the photoelectric conversion element.

The structure of the photoelectric conversion module of the present disclosure is not particularly limited, and may be appropriately selected depending on the intended purpose. Among at least two photoelectric conversion element disposed next to each other, the first electrode, the electron-transporting layer, and the second electrode of one photoelectric conversion element are separated from the first electrode, the electron-transporting layer, and the second electrode of another photoelectric conversion element. Among at least two photoelectric conversion element disposed next to each other, meanwhile, the hole-transporting layer of one photoelectric conversion element may be separated from the hole-transporting layer or another photoelectric conversion element, or the hole-transporting layer of one photoelectric conversion element and the hole-transporting layer or another photoelectric conversion element may be extended from each other to form a continuous layer.

In the photoelectric conversion module of the present disclosure, which includes at least two photoelectric conversion element disposed next to each other, moreover, the first electrode of one photoelectric conversion element and the second electrode of another photoelectric conversion element are electrically connected via a conduction part penetrating the photoelectric conversion layer.

Moreover, the photoelectric conversion module of the present disclosure may have a structure where a pair of substrates are disposed, a photoelectric conversion element aligned region, where photoelectric conversion elements are connected in series or parallel, is disposed between a pair of the substrates, and the sealing member is disposed between a pair of the substrate. Particularly, the photoelectric conversion module of the present disclosure preferably includes a sealing member configured to seal the photoelectric conversion layers of the photoelectric conversion elements in the photoelectric conversion module from the external environment of the photoelectric conversion module.

Examples of the photoelectric conversion module of the present disclosure will be described with reference to drawings hereinafter. However, the following embodiments shall not be construed as to limit the scope of the present disclosure. For example, the number of the following constitutional members, the positions of the following constitutional members, and the shapes of the following constitutional members, which will not be described in the following embodiments, are also included in the scope of the present disclosure.

### <Fourth embodiment>

FIG. 4 is a schematic view illustrating an example of the photoelectric conversion module of the present disclosure, and an example illustrating a cross-section of part of the photoelectric conversion element where a plurality of the photoelectric conversion elements are included, and the photoelectric conversion elements are connected in series.

As in FIG. 4, a through hole 12 is formed after forming a hole-transporting layer 6, followed by forming a second electrode 7. As a result, the second electrode material is introduced inside the through hole 12 to electrically connect with the first electrode 2b of the adjacent cell. Although it is not illustrated in FIG. 4, the first electrode 2a and the second electrode 7b each have a path electrically connecting with an electrode of the adjacent photoelectric conversion element, or with an output extraction terminal.

The through hole 12 may penetrate through the first electrode 2 to reach the first substrate 1. Alternatively, processing may be stopped when the through hole 12 reaches inside the first electrode 2 so that the through hole 12 does not reach the first substrate 1.

When a shape of the through hole 12 is a pore penetrating through the first electrode 2 to reach the first substrate 1, and a total opening area of the pore is excessively large relative to the area of the through hole 12, the resistance value increases as the cross-sectional film area of the first electrode 2 reduces, which may lower a photoelectric conversion efficiency. Therefore, the total opening area of the pore relative to the area of the through hole 12 is preferably 5/100 or greater but 60/100 or less.

A method for forming the through hole 12 is not particularly limited, and may be appropriately selected depending on the intended purpose. Examples thereof include sand blasting, water blasting, polishing, chemical etching, and laser processing. Among the above-listed examples, laser processing is preferable. According to the laser processing, a fine hole can be formed without using sand, etching, or a resist, and processing can be performed cleanly with excellent reproducibility. When the through hole 12 is formed, moreover, at least one selected from the group consisting of the hole-blocking layer 3, the electron-transporting layer 4, the hole-transporting layer 6, and the second electrode 7 may be removed through impact peeling by laser processing. Therefore, it is not necessary to dispose a mask when layers are laminated, and the removal of the layer and formation of the fine through hole 12 can be easily performed at once.

### <Fifth embodiment>

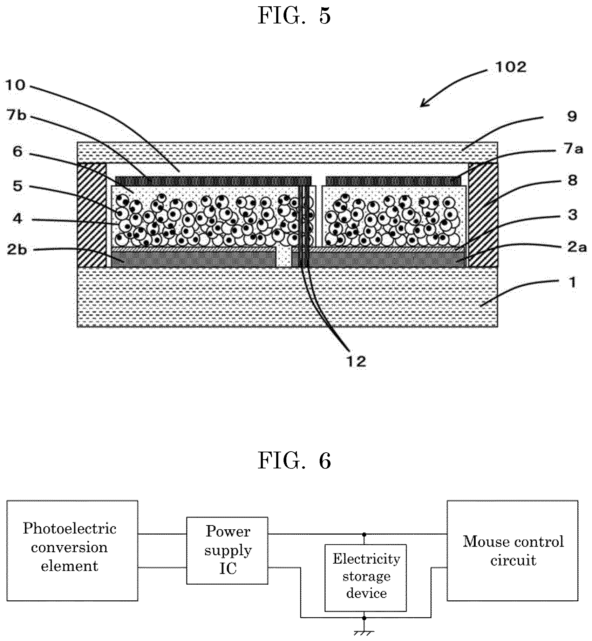

FIG. 5 is a schematic view illustrating an example of the photoelectric conversion module of the present disclosure. Unlike FIG. 4, the hole-transporting layer 6 is separated from the adjacent photoelectric conversion element and the hole-transporting layer of each photoelectric conversion element has an independent layer structure. As a result, diffusion of electrons can be suppressed to reduce leakage of electric current, and therefore durability of the photoelectric conversion module may be improved even more. Accordingly, the photoelectric conversion module having such a layer structure is effective.

### (Electronic device)

The electronic device of the present disclosure includes the photoelectric conversion element of the present disclosure or the photoelectric conversion module of the present disclosure, and a device driven by electric power generated through photoelectric conversion performed by the photoelectric conversion element or the photoelectric conversion module. The electronic device may further include other devices according to the necessity.

Moreover, the electronic device of the present disclosure includes the photoelectric conversion element of the present disclosure or the photoelectric conversion module of the present disclosure, a storage battery cell capable of storing electric power generated through photoelectric conversion performed by the photoelectric conversion element or the photoelectric conversion module, and a device driven by the electric power stored in the storage battery cell. The electronic device may further include other devices according to the necessity.

### (Power supply module)

The power supply module of the present disclosure includes the photoelectric conversion module of the present disclosure, and a power supply integrated circuit (IC). The power supply module may further include other devices according to the necessity.

Next, a specific embodiment of the electronic device including the photoelectric conversion module of the present disclosure and a device driven by the power generated by the photoelectric conversion module will be described.

FIG. 6 is a block diagram illustrating a mouse of a personal computer as an example of the electronic device of the present disclosure.

As illustrated in FIG. 6, the photoelectric conversion module is combined with the power supply IC, and the electricity storage device, and the electric power supplied is connected to the power source of the control circuit of the mouse. As a result, the electricity storage device can be charged when the mouse is not used, and the charged electricity can be used to drive the mouse, and therefore the mouse that does not need wiring or replacement of a battery can be obtained. Moreover, the weight of the mouse can be reduced as it is not necessary to mount a battery. Therefore, the mouse as the electronic device of the present disclosure is effective.

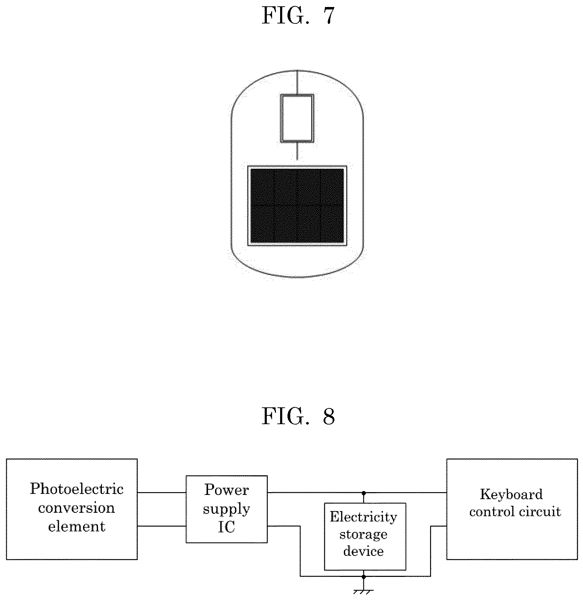

FIG. 7 is a schematic external view illustrating an example of the mouse of FIG. 6.

As illustrated in FIG. 7, the photoelectric conversion module, the power supply IC, and the electricity storage device are mounted inside the mouse, but the upper part of the photoelectric conversion elements is covered with a transparent casing to allow light to reach the photoelectric conversion elements of the photoelectric conversion module. The arrangement of the photoelectric conversion elements is not limited to the arrangement illustrated in FIG. 7. For example, the photoelectric conversion elements may be arranged in a position where the photoelectric conversion elements can be irradiated with light even when the mouse is covered with a hand, and such an arrangement may be preferable in some case.

Next, another embodiment of the electronic device including the photoelectric conversion module of the present disclosure, and a device driven by electric power generated by the photoelectric conversion module will be described.

FIG. 8 is a block view illustrating a keyboard for a personal computer as an example of the electronic device of the present disclosure.

As illustrated in FIG. 8, the photoelectric conversion elements of the photoelectric conversion module are combined with the power supply IC, and the electricity storage device, and the supplied electricity can be transmitted to a power source of the control circuit of the keyboard. As a result, the electricity storage device can be charged when the keyboard is not used, and the charged electricity can be used to drive the keyboard, and therefore the keyboard that does not need wiring or replacement of a battery can be obtained. Moreover, the weight of the keyboard can be reduced as it is not necessary to mount a battery. Therefore, the keyboard as the electronic device of the present disclosure is effective.

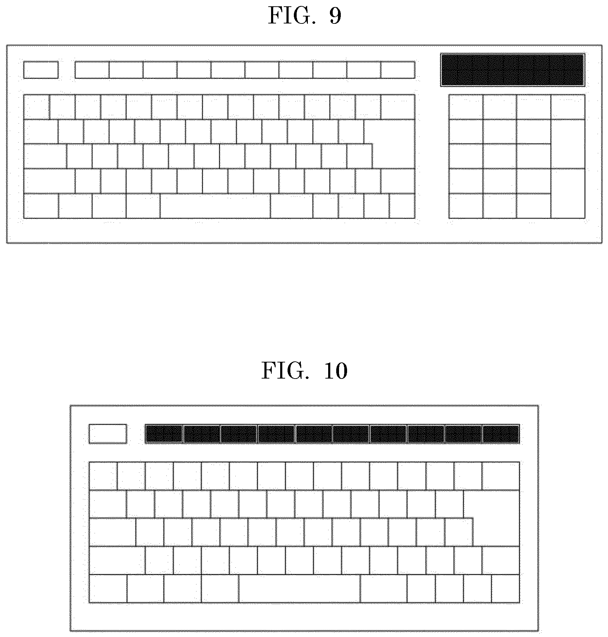

FIG. 9 is a schematic external view illustrating an example of the keyboard illustrated in FIG. 8.

As illustrated in FIG. 9, the photoelectric conversion elements of the photoelectric conversion module, the power supply IC, and the electricity storage device are mounted inside the keyboard, but the upper part of the photoelectric conversion elements is covered with a transparent casing to allow light to reach the photoelectric conversion elements. Moreover, the entire casing of the keyboard may be formed of a transparent resin. The arrangement of the photoelectric conversion elements is not limited to the arrangement illustrated in FIG. 9. In case of a small keyboard having a small space in which the photoelectric conversion element is mounted, as illustrated in FIG. 10, the photoelectric conversion element may be embedded as part of keys, and such an arrangement is effective.

Next, yet another embodiment of the electronic device including the photoelectric conversion module of the present disclosure, and a device driven by electric power generated by the photoelectric conversion module will be described.

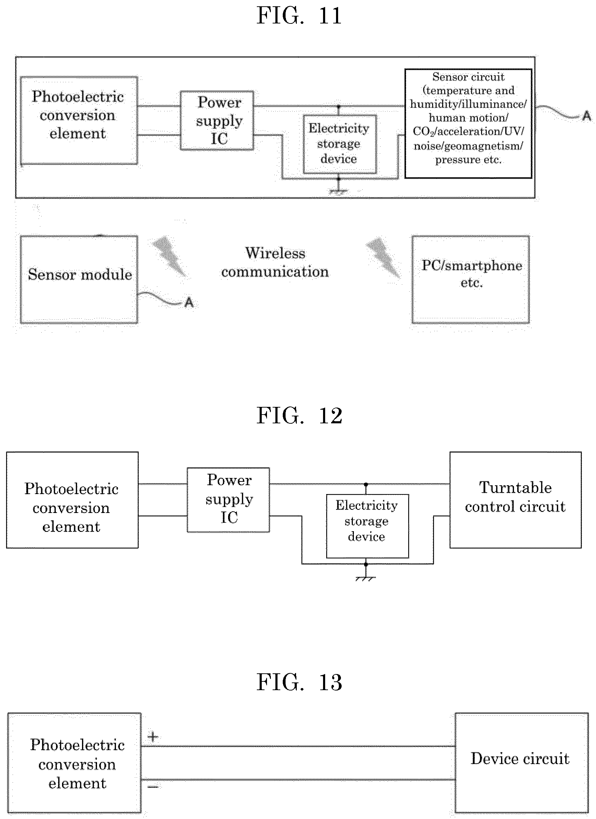

FIG. 11 is a block view illustrating a sensor as an example of the electronic device of the present disclosure.

As illustrated in FIG. 11, the photoelectric conversion elements of the photoelectric conversion module are combined with the power supply IC and the electricity storage device, and the supplied electricity is transmitted to the power source of the sensor circuit. As a result, the sensor module can be composed without connecting to an external power source and without performing replacement of a battery. The sensing target may be a temperature and humidity, illuminance, motions of humans, CO₂, acceleration, UV, noise, geomagnetism, or pressure. The sensor module can be applied for various sensors and is effective. As illustrated in FIG. 12, the sensor module is configured to sense a target to be measured on a regular basis and to transmit the read data to a personal computer (PC) or a smartphone through wireless communication.

It is expected that use of sensors is significantly increased as the internet of things (IoT) society approaches. To replace batteries of numerous sensors one by one is time consuming and is not realistic. Moreover, the fact that a sensor is installed at a position such as a ceiling and a wall where a cell is not easily replaced also makes workability bad. Moreover, supplying electric power by the photoelectric conversion element is also a significantly large advantage. Furthermore, the photoelectric conversion module of the present disclosure has advantages that high output can be obtained with light of low illuminance, a high degree of freedom in installation can be achieved because the output has low dependency to the light incident angle.

Next, yet another embodiment of the electronic device including the photoelectric conversion module of the present disclosure, and a device driven by electric power generated by the photoelectric conversion module will be described.

FIG. 12 is a block view illustrating a turntable as an example of the electronic device of the present disclosure.

As illustrated in FIG. 12, the photoelectric conversion element is combined with the power supply IC and the electricity storage device, and the supplied electricity is transmitted to the power source of the turntable circuit. As a result, the turntable can be composed without connecting to an external power source and without performing replacement of a battery.

The turntable is used, for example, in a display case in which products are displayed. Wiring of a power supply degrades appearance of the display, and moreover displayed products need to be removed at the time of replacing a battery cell, which is time-consuming. Use of the photoelectric conversion module of the present disclosure is effective because the above-mentioned problems can be solved.

The photoelectric conversion module of the present disclosure, the electronic device including a device driven by electric power generated by the photoelectric conversion module, and the power supply module have been described above, but the embodiments described above are only a part of the present disclosure, and use of the photoelectric conversion module of the present disclosure is not limited to the embodiments described above.

### <Use>

The photoelectric conversion module of the present disclosure can function as a self-sustaining power supply, and a device can be driven by the electric power generated through photoelectric conversion performed by the photoelectric conversion module. The photoelectric conversion module of the present disclosure can generate power upon irradiation of light. Therefore, the electronic device does not need to connect with a power source, or perform battery replacement. Therefore, the electronic device can be driven in a place where there is no power supply facility, the electronic device can be worn or carried, and the electronic device can be driven without replacement of a battery cell even in a place where a battery cell is not easily replaced. Moreover, when a dry battery cell is used, the electronic device becomes heavy by a weight of the dry battery cell, or the electronic device becomes large by a size of the dry battery cell. Therefore, there may be a problem in installing the electronic device on a wall or ceiling, or transporting the electronic device. Since the photoelectric conversion module of the present disclosure is light and thin, it can be freely installed, and can be worn and carried, which is advantageous.

As described above, the photoelectric conversion module of the present disclosure can be used as a self-sustaining power supply, and can be used in combination with various electronic devices. For example, the photoelectric conversion module of the present disclosure can be used in combination with a display device (e.g., an electronic desk calculator, a watch, a mobile phone, an electronic organizer, and electronic paper), an accessory device of a personal computer (e.g., a mouse and a keyboard), various sensor devices (e.g., a temperature and humidity sensor and a human detection sensor), transmitters (e.g., a beacon and a global positioning system (GPS)), and numerous electronic devices (e.g., an auxiliary lamp and a remote controller).

The photoelectric conversion module of the present disclosure is widely applied because the photoelectric conversion element can generate electricity particularly with light of low illuminance and can generate electricity indoors and in dimmed or shaded places. Moreover, the photoelectric conversion element is highly safe because liquid leakage found in the case of a dry battery cell does not occur, and accidental ingestion found in the case of a button battery cell does not occur. Furthermore, the photoelectric conversion module can be used as an auxiliary power supply for the purpose of prolonging a continuous operation time of a charge-type or dry cell-type electronic equipment. By using the photoelectric conversion module of the present disclosure and a device driven by the electric power generated by the photoelectric conversion in combination, as described above, an electronic device that is light in weight and easy to use, has a high degree of freedom in installation, does not require replacement of a battery cell, is highly safe, and is effective in decreasing environmental loads can be obtained.

FIG. 13 illustrates a basic structural view of the electronic device in which the photoelectric conversion module of the present disclosure and the device driven by the electric power generated by the photoelectric conversion. The electronic device can generate electricity when the photoelectric conversion module is irradiated with light, and can extract electric power. A circuit of the device can be driven by the generated electric power.

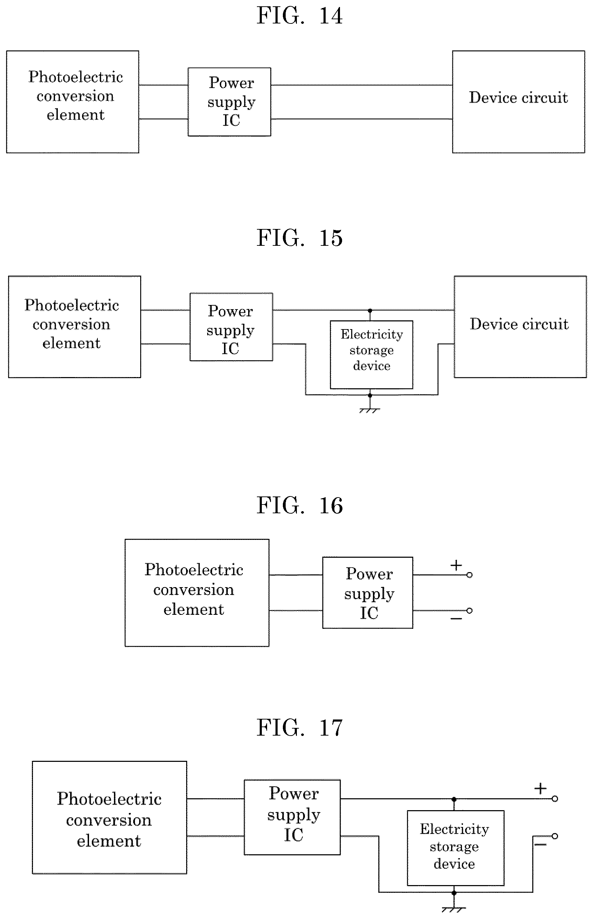

Since the output of the photoelectric conversion element varies depending on circumferential illuminance, the electronic device illustrated in FIG. 13 may not be stably driven in some cases. In this case, as illustrated in FIG. 14, a power supply IC for a photoelectric conversion element can be incorporated between the photoelectric conversion element and the circuit of the device in order to supply stable voltage to a side of the circuit, and such arrangement is effective.

However, the photoelectric conversion element of the photoelectric conversion module has the following problem. That is, desired electric power cannot be obtained when light of sufficient illuminance is not applied, although the photoelectric conversion element can generate electric power as long as light of sufficient illuminance is applied. In this case, as illustrated in FIG. 15, an electricity storage device, such as a capacitor, is mounted between the power supply IC and a device circuit to store the excessive electric power from the photoelectric conversion element in the electricity storage device. As a result, the electricity stored in the electricity storage device can be supplied to the device circuit even when illuminance of light is too low, or light is not applied to the photoelectric conversion element, and the electronic device can be stably driven and the advantages obtained by the photoelectric conversion element can be maximized.

Meanwhile, the photoelectric conversion module of the present disclosure can be also used as a power supply module and use of the photoelectric conversion module as the power supply module is effective. As illustrated in FIG. 16, for example, a DC power supply module capable of supplying electricity generated through photoelectric conversion performed by the photoelectric conversion element of the photoelectric conversion module at a constant voltage level with the power supply IC when the photoelectric conversion module of the present disclosure is connected with the power supply IC for the photoelectric conversion element.

As illustrated in FIG. 17, furthermore, the electricity storage device is combined with the power supply IC. As a result, the electricity generated by the photoelectric conversion element of the photoelectric conversion module can be stored in the electricity storage device, which enables to constitute a power supply module capable of supplying electricity even when illuminance of light is too low, or light is not applied to the photoelectric conversion element.

The power supply module of the present disclosure as illustrated in FIGs. 16 and 17 can be used as a power supply module that does not need to replace a battery cell, unlike a primary battery cell known in the art.

### Examples

The present disclosure will be described below by way of Examples, but should not be construed as being limited to these Examples in any way.

### (Example 1)

### <Production of photoelectric conversion module>

On a glass substrate serving as a first substrate, a film of indium-doped tin oxide (ITO) and a film of niobium-doped tin oxide (NTO) were sequentially formed as a first electrode by sputtering. Subsequently, a dense layer (average thickness: 20 nm) of titanium oxide was formed as a hole-blocking layer on the first electrode by reactive sputtering with oxygen gas.

Next, a titanium oxide paste (18NR-T, available from Greatcell Solar Materials) was applied onto the hole-blocking layer by screen printing to have an average thickness of about 1.2 µm. The applied paste was dried at 120°C, followed by firing in air at 570°C for 30 minutes, to thereby form a porous electron-transporting layer. Thereafter, the ITO/NTO layer, the hole-blocking layer, and the electron-transporting layer were divided into 8 cells by laser processing.

The glass substrate on which the electron-transporting layer was formed was immersed in a solution obtained by adding a acetonitrile/t-butanol mixed liquid (volume ratio: 1:1) to the photosensitization compound (0.2 mM) represented by B-5 above with stirring, followed by leaving to stand in the dark for 1 hour to allow the photosensitization compound to be adsorbed onto the surface of the electron-transporting layer.

Next, to a chlorobenzene solution, 86.9 mM of lithium (fluorosulfonyl)(trifluoromethane sulfonyl)imide (Li-FTFSI)(available from KISHIDA CHEMICAL Co., Ltd.) serving as lithium salt b, 143.1 mM of a pyridine compound a represented by H-1, 159.0 mM of an organic hole-transporting material (HTM) (SHT-263, available from Merck KGaA) represented by D-7, and 12.7 mM of a cobalt complex (available from Greatcell Solar Materials Pty Ltd.) represented by F-11 were added and dissolved, to thereby prepare a hole-transporting layer coating liquid. The molar ratio a/b of the pyridine compound a to the lithium salt b was 1.65.

The molar ratio X/Y of the lithium salt to the organic p-type semiconductor material was 0.55, where X was the molar quantity of the lithium salt in the hole-transporting layer and Y was the molar quantity of the organic p-type semiconductor material in the hole-transporting layer.

Next, the hole-transporting layer coating liquid was applied onto the electron-transporting layer on which the photosensitization compound was adsorbed by die coating to form a hole-transporting layer having a thickness of about 500 nm.

After applying the hole-transporting layer coating liquid onto the electron-transporting layer on which the photosensitization compound was adsorbed, the applied hole-transporting layer coating liquid was heated and dried in an oven for 60 minutes at 60°C under ambient pressure.

Thereafter, the edges of the glass substrate to which a sealing member was to be disposed and the gaps between cells were etched by laser processing, and through holes to connect with the ITO/NTO layer, which were to be terminal extraction parts, were formed by laser processing. Moreover, through holes were formed for connecting the cells in series.

After disposing a mask over the edges of the glass substrate and between cells, silver was deposited by vacuum vapor deposition, to thereby form a second electrode having a thickness of about 70 nm.

A UV curable resin (World Rock No. 5910, available from Kyoritsu Chemical & Co., Ltd.) was applied to the edges of the glass substrate to surround the power generating region by means of a dispenser (2300N, available from SAN-EI TECH Ltd.). Thereafter, the resultant was moved into a glove box, in which a dew point was adjusted to -40°C and a mixed gas of nitrogen and oxygen (oxygen concentration: 10% by volume) was introduced, a cover glass sheet was placed on the UV curable resin as a second substrate, the UV curable resin was cured with UV irradiation, followed by heating for 60 minutes at 80°C. As described above, the power generating region was sealed. Finally, a UV cut film was bonded onto the light-receiving surface, to thereby produce a photoelectric conversion module 102 as illustrated in FIG. 5.

### (Example 2)

A photoelectric conversion module 2 was produced in the same manner as in Example 1, except that after applying the hole-transporting layer coating liquid onto the electron-transporting layer, the hole-transporting layer coating liquid was heated and dried by an oven for 30 minutes at 90°C under ambient pressure.

### (Example 3)

A photoelectric conversion module 3 was produced in the same manner as in Example 1, except that the amount of the lithium salt was changed to 95.6 mM, the amount of the pyridine compound was changed to 141.9 mM, the amount of the organic hole-transporting material was changed to 157.7 mM, and the amount of the cobalt complex was changed to 12.6 mM.

### (Example 4)

A photoelectric conversion module 4 was produced in the same manner as in Example 1, except that the amount of the lithium salt was changed to 84.0 mM, the amount of the pyridine compound was changed to 138.4 mM, the organic hole-transporting material was changed to 153.7 mM of an organic hole-transporting material represented by D-10, and the amount of the cobalt complex was changed to 12.3 mM.

### (Example 5)

A photoelectric conversion module 5 was produced in the same manner as in Example 1, except that the amount of the lithium salt was changed to 103.3 mM, the amount of the pyridine compound was changed to 140.8 mM, the amount of the organic hole-transporting material was changed to 156.5 mM, and the amount of the cobalt complex was changed to 12.5 mM, and the drying conditions were changed to for 90 minutes at 50°C.

### (Comparative Example 1)

A photoelectric conversion module 6 was produced in the same manner as in Example 1, except that after applying the hole-transporting layer coating liquid onto the electron-transporting layer, the production process proceeded with the sequential step without performing heating and drying the hole-transporting layer coating liquid.

### (Comparative Example 2)

A photoelectric conversion module 7 was produced in the same manner as in Example 1, except that after applying the hole-transporting layer coating liquid onto the electron-transporting layer, the applied hole-transporting layer coating liquid was heated and dried by an oven for 15 minutes at 40°C under ambient pressure.

### (Comparative Example 3)

A photoelectric conversion module 8 was produced in the same manner as in Example 1, except that the amount of the lithium salt was changed to 86.9 mM, the amount of the pyridine compound was changed to 143.1 mM, the amount of the organic hole-transporting material was changed to 159.0 mM, and the amount of the cobalt complex was changed to 12.7 mM, and the drying conditions were changed to form 3 minutes at 50°C.

### (Comparative Example 4)

A photoelectric conversion module 9 was produced in the same manner as in Example 1, except that the lithium salt was not added, the amount of the pyridine compound was changed to 155.5 mM, the amount of the organic hole-transporting material was changed to 172.8 mM, and the amount of the cobalt complex was changed to 13.8 mM.

### (Example 6)

A photoelectric conversion module 10 was produced in the same manner as in Example 1, except that the amount of the lithium salt was changed to 80.2 mM, the amount of the pyridine compound was changed to 144.4 mM, the amount of the organic hole-transporting material was changed to 160.4 mM, and the amount of the cobalt complex was changed to 12.5 mM.

### (Example 7)

A photoelectric conversion module 11 was produced in the same manner as in Example 1, except that the amount of the lithium salt was changed to 75.2 mM, the amount of the pyridine compound was changed to 145.1 mM, the amount of the organic hole-transporting material was changed to 161.2 mM, and the amount of the cobalt complex was changed to 12.6 mM.

### (Example 8)

A photoelectric conversion module 12 was produced in the same manner as in Example 1, except that the amount of the lithium salt was changed to 65.1 mM, the amount of the pyridine compound was changed to 146.5 mM, the amount of the organic hole-transporting material was changed to 162.8 mM, and the amount of the cobalt complex was changed to 12.7 mM.

### (Example 9)

A photoelectric conversion module 13 was produced in the same manner as in Example 1, except that the amount of the lithium salt was changed to 54.8 mM, the amount of the pyridine compound was changed to 148.0 mM, the amount of the organic hole-transporting material was changed to 164.4 mM, and the amount of the cobalt complex was changed to 12.8 mM.

### (Example 10)

A photoelectric conversion module 14 was produced in the same manner as in Example 1, except that the photosensitization compound was changed to the photosensitization compound represented by B-51, the lithium salt was changed to 86.7 mM of lithium(fluorosulfonyl)(pentafluoroethanesulfonyl)imide (Li-FPFSI), the amount of the pyridine compound was changed to 142.8 mM, the amount of the organic hole-transporting material was changed to 158.6 mM, and the oxidant was changed to 11.6 mM of the oxidant represented by F-23.

### (Example 11)

A photoelectric conversion module 15 was produced in the same manner as in Example 10, except that the drying conditions were changed to 75°C for 45 minutes.

### (Example 12)

A photoelectric conversion module 16 was produced in the same manner as in Example 1, except that the photosensitization compound was changed to the photosensitization compound represented by B-51, the lithium salt was changed to 85.3 mM of lithium(pentafluoroethanesulfonyl)(trifluoromethanesulfonyl)imide (Li-PFTFSI), the amount of the pyridine compound was changed to 140.4 mM, the amount of the organic hole-transporting material was changed to 156.0 mM, and the oxidant was changed to 11.4 mM of the oxidant represented by F-23.

### (Example 13)

A photoelectric conversion module 17 was produced in the same manner as in Example 12, except that the drying conditions were changed to 75°C for 45 minutes.

### (Example 14)

A photoelectric conversion module 18 was produced in the same manner as in Example 1, except that the photosensitization compound was changed to the photosensitization compound represented by B-51, the amount of the lithium salt was changed to 94.3 mM, the organic hole-transporting material was changed to 146.6 mM of the organic hole-transporting material represented by D-10, the pyridine compound was changed to 141.4 mM of the pyridine compound represented by H-3, and the oxidant was changed to 15.7 mM of the oxidant represented by F-23.

### (Example 15)

A photoelectric conversion module 19 was produced in the same manner as in Example 14, except that the drying conditions were changed to 75°C for 45 minutes.

### (Comparative Example 5)

A photoelectric conversion module 20 was produced in the same manner as in Example 1, except that the lithium salt was changed to 70.1 mM of lithium bis(trifluoromethanesulfonyl) imide (Li-TFSI), the amount of the pyridine compound was changed to 145.7 mM, the amount of the organic hole-transporting material was changed to 161.9 mM, and the oxidant was changed to 11.9 mM of the oxidant represented by F-23.

### (Comparative Example 6)

A photoelectric conversion module 21 was produced in the same manner as in Example 1, except that the lithium salt was changed to 89.6 mM of lithium bis(trifluoromethanesulfonyl) imide (Li-TFSI), the amount of the pyridine compound was changed to 142.3 mM, the amount of the organic hole-transporting material was changed to 158.1 mM, and the oxidant was changed to 11.6 mM of the oxidant represented by F-23.

### (Comparative Example 7)

A photoelectric conversion module 22 was produced in the same manner as in Example 1, except that the lithium salt was changed to 72.1 mM of lithium bis(fluorosulfonyl) imide (Li-FSI), the amount of the pyridine compound was changed to 149.7 mM, the amount of the organic hole-transporting material was changed to 166.4 mM, and the oxidant was changed to 12.2 mM of the oxidant represented by F-23.

### (Comparative Example 8)

A photoelectric conversion module 23 was produced in the same manner as in Example 1, except that the lithium salt was changed to 68.3 mM of lithium bis(fpentafluoroethanesulfonyl) imide (Li-BETI), the amount of the pyridine compound was changed to 141.8 mM, the amount of the organic hole-transporting material was changed to 157.6 mM, and the oxidant was changed to 11.6 mM of the oxidant represented by F-23.

Next, each of the produced photoelectric conversion modules was subjected to measurements of the sealed oxygen concentration, valency of the cobalt complex, and the amount of chlorobenzene, and evaluations of the performance of the photoelectric conversion module (initial maximum output power Pmax1, and Pmax retention rate). The results are presented in Table 1.

### <Sealed oxygen concentration>

The oxygen concentration inside the sealed photoelectric conversion module was measured according to IVA by opening the sealed section of the photoelectric conversion module, which was a sample, in a highly vacuumed atmosphere, and quantifying the released moisture or gas by means of a flight mass spectrometer (IVA: semiconductor internal gas analyzer, available from Oki Engineering Co., Ltd. (OEG), detector: a quadruple mass spectrometer (QM1422/QMA-125) available from PFEIFFER VACUUM) to perform mass spectrometry.

As a result, it was confirmed that the oxygen concentration in the sealed section of each of the produced photoelectric conversion modules was almost identical to the set oxygen concentration (10% by volume).

### <Valence of cobalt complex>

The valence of the cobalt complex included in each of the photoelectric conversion modules was analyzed by X-ray absorption fine structure spectroscopy (XAFS). The valence of the cobalt complex within the photoelectric conversion module was measured by opening the sealing of the photoelectric conversion module, and maintaining the state where the counter electrodes were disposed. Moreover, an XAFS spectrum of the divalent cobalt complex powder and an XAFS spectrum of trivalent cobalt complex powder were separately measured.

Then, the valence of the cobalt complex included in the hole-transporting layer was determined by comparing the XAFS spectrum of the cobalt complex included in the hole-transporting layer with the XAFS spectra of the samples. The XAFS analysis result of the photoelectric conversion module of Example 1 is presented in FIG. 18.

In FIG. 18, the spectrum of the photoelectric conversion module of Example 1 was almost matched with the spectrum of the divalent cobalt complex powder sample. It was confirmed from the result as mentioned that the trivalent cobalt complex was added when the photoelectric conversion element and photoelectric conversion module of the present disclosure were produced, but the majority of the cobalt complex included in the produced photoelectric conversion element and photoelectric conversion module was turned into the divalent cobalt complex.

### <Measurement of chlorobenzene amount>

After immersing the produced photoelectric conversion element in liquid nitrogen, the photoelectric conversion element was finely crushed by a hummer, and the crushed photoelectric conversion element was transferred into a vial.

The sample collected in the vial was heated for 1 hour on a hot plate heated to 150°C, and the gas inside the vial was collected. From the collected gas, 100 µL of the gas was sampled and subjected to an analysis according gas chromatograph mass spectroscopy.

The gas chromatograph mass spectroscopy was performed under the following conditions.

### -Device-

SION-TQ (GCMS), available from BRUKER
UNITY2 (TD), available from MARKES
-Measuring conditions-
Column: SGE GC column
   SOLGEL-WAX
   L = 30.0 m
   ID = 0.25 mm ID
   Film = 0.25 µm
Heating of column: 40°C (retained for 5 min) to <20°C/min> to 260°C (retained for 5 min)
Carrier gas: He
Injector: 200°C
Column Flow: 1.00 mL/min (constant)
Ionization method: electron ionization (EI) (70 eV)
Injection mode: split 1:10
Measuring mode: total ion chromatogram (TIC) (m/z = 33 to 600)
Injected amount: 100 µL (gas)

The same sample was measured at 3 points (N = 3), and the average value thereof was provided as a measured value. The area value of each component was calculated from the specific spectrum. In Example, the measurement was performed with m/z = 112 because chlorobenzene was used as the solvent for the hole-transporting layer.

The measurement value obtained by GCMS was compared with the calibration curves above to determine a quantitative value on the calibration curve, and the quantitative value was converted with the volume of the hole-transporting layer according to the following formula to thereby calculate a quantitative value of chlorobenzene per unit volume of the hole-transporting layer. The hole-transporting layer mentioned above means an area of a film with a thickness, which is independently present as a layer, and the hole-transporting layer does not include a region penetrating the porous layer of the electron-transporting layer. Quantitative value (µg/mm3) = quantitative value on calibration curve (µg)/area of hole-transporting layer × film thickness (mm3)

A solvent for forming calibration curves, which was used for creating calibration curves, was prepared in the following manner.

### -Preparation of solution for forming calibration curves and formation of calibration curves-

Standard chlorobenzene was diluted with methanol.

The obtained solution (1 µL) was transferred into a vial, the vial was heated on a hot plate of 150°C, 100 µL of gas collected from the gas generated in the vial was introduced into the above-described GCMS device, and an amount of chlorobenzene was measured in the same manner as the above-described method.

### <Performance evaluations of photoelectric conversion module>

The obtained photoelectric conversion module was installed inside a thermostat chamber with a hatch disposed at the top, light emitted from white LED of 5,000K was applied from the hatch towards inside the thermostat chamber to adjust the illuminance of light on the photoelectric conversion module to be 200 lux. Moreover, the wiring connected with the terminal of the photoelectric conversion module was extended outside the thermostat chamber so that IV characteristics could be measured in the state that the photoelectric conversion module was disposed inside the thermostat chamber.

Thereafter, the thermostat chamber was set to 60°C, and IV characteristics at 60°C were measured by means of a solar cell test system (As-510-PV03, available from NF CORPORATION) to determine initial maximum output power Pmax1 (µW). After leaving to stand for 750 hours in the same state, IV characteristics were measured again to determine the maximum output power Pmax 2 (µW) and the Pmax retention rate at 60°C was determined according to the formula: [(Pmax2/Pmax1)×100] (%). The results are presented in Table 1.

The thermostat chamber was set to -30°C, Pmax retention rate at -30°C was determined according to the formula: [(Pmax2/Pmax1)×100] (%). in the same manner as the measurement of Pmax retention rate at 60°C. The results are presented in Table 1.

**Table 1-1**

| | Photo sensitization compound | | Lithium salt | | Hole-transporting material | |
|---|---|---|---|---|---|---|
| | No. | Amount (mM) | Compound name | Amount (mM) | No. | Amount (mM) |
| Ex. 1 | B-5 | 0.2 | LiFTFSI (asymmetric) | 86.9 | D-7 | 159 |
| Ex. 2 | B-5 | 0.2 | LiFTFSI (asymmetric) | 86.9 | D-7 | 159 |
| Ex. 3 | B-5 | 0.2 | LiFTFSI (asymmetric) | 95.6 | D-7 | 157.7 |
| Ex. 4 | B-5 | 0.2 | LiFTFSI (asymmetric) | 84 | D-10 | 153.7 |
| Ex. 5 | B-5 | 0.2 | LiFTFSI (asymmetric) | 103.3 | D-7 | 156.5 |
| Comp. Ex. 1 | B-5 | 0.2 | LiFTFSI (asymmetric) | 86.9 | D-7 | 159 |
| Comp. Ex. 2 | B-5 | 0.2 | LiFTFSI (asymmetric) | 86.9 | D-7 | 159 |
| Comp. Ex. 3 | B-5 | 0.2 | LiFTFSI (asymmetric) | 86.9 | D-7 | 159 |
| Comp. Ex. 4 | B-5 | 0.2 | NA | NA | D-7 | 172.8 |
| Ex. 6 | B-5 | 0.2 | LiFTFSI (asymmetric) | 80.2 | D-7 | 160.4 |
| Ex. 7 | B-5 | 0.2 | LiFTFSI (asymmetric) | 75.2 | D-7 | 161.2 |
| Ex. 8 | B-5 | 0.2 | LiFTFSI (asymmetric) | 65.1 | D-7 | 162.8 |
| Ex. 9 | B-5 | 0.2 | LiFTFSI (asymmetric) | 54.8 | D-7 | 164.4 |
| Ex. 10 | B-51 | 0.2 | Li-FPFSI (asymmetric) | 86.7 | D-7 | 158.6 |
| Ex. 11 | B-51 | 0.2 | Li-FPFSI (asymmetric) | 86.7 | D-7 | 158.6 |
| Ex. 12 | B-51 | 0.2 | Li-PFTFSI (asymmetric) | 85.3 | D-7 | 156 |
| Ex. 13 | B-51 | 0.2 | Li-PFTFSI (asymmetric) | 85.3 | D-7 | 156 |
| Ex. 14 | B-51 | 0.2 | Li-FTFSI (asymmetric) | 94.3 | D-10 | 146.6 |
| Ex. 15 | B-51 | 0.2 | Li-FTFSI (asymmetric) | 94.3 | D-10 | 146.6 |
| Comp. Ex. 5 | B-5 | 0.2 | Li-TFSI (symmetric) | 70.1 | D-7 | 161.9 |
| Comp. Ex. 6 | B-5 | 0.2 | Li-TFSI (symmetric) | 89.6 | D-7 | 158.1 |
| Comp. Ex. 7 | B-5 | 0.2 | Li-FSI (symmetric) | 72.1 | D-7 | 166.4 |
| Comp. Ex. 8 | B-5 | 0.2 | Li-BETI (symmetric) | 68.3 | D-7 | 157.6 |

**Table 1-2**

| | X/Y | Pyridine compound | | a/b | Oxidant | |
|---|---|---|---|---|---|---|
| | | No. | Amount (mM) | | No. | Amount (mM) |
| Ex. 1 | 0.55 | H-1 | 143.1 | 1.65 | F-11 | 12.7 |
| Ex. 2 | 0.55 | H-1 | 143.1 | 1.65 | F-11 | 12.7 |
| Ex. 3 | 0.61 | H-1 | 141.9 | 1.48 | F-11 | 12.6 |
| Ex. 4 | 0.55 | H-1 | 138.4 | 1.65 | F-11 | 12.3 |
| Ex. 5 | 0.66 | H-1 | 140.8 | 1.36 | F-11 | 12.5 |
| Comp. Ex. 1 | 0.55 | H-1 | 143.1 | 1.65 | F-11 | 12.7 |
| Comp. Ex. 2 | 0.55 | H-1 | 143.1 | 1.65 | F-11 | 12.7 |
| Comp. Ex. 3 | 0.55 | H-1 | 143.1 | 1.65 | F-11 | 12.7 |
| Comp. Ex. 4 | 0 | H-1 | 155.5 | NA | F-11 | 13.8 |
| Ex. 6 | 0.5 | H-1 | 144.4 | 1.8 | F-11 | 12.5 |
| Ex. 7 | 0.47 | H-1 | 145.1 | 1.93 | F-11 | 12.6 |
| Ex. 8 | 0.4 | H-1 | 146.5 | 2.25 | F-11 | 12.7 |
| Ex. 9 | 0.33 | H-1 | 148 | 2.7 | F-11 | 12.8 |
| Ex. 10 | 0.55 | H-1 | 142.8 | 1.65 | F-23 | 11.6 |
| Ex. 11 | 0.55 | H-1 | 142.8 | 1.65 | F-23 | 11.6 |
| Ex. 12 | 0.55 | H-1 | 140.4 | 1.65 | F-23 | 11.4 |
| Ex. 13 | 0.55 | H-1 | 140.4 | 1.65 | F-23 | 11.4 |
| Ex. 14 | 0.64 | H-3 | 141.4 | 1.5 | F-23 | 15.7 |
| Ex. 15 | 0.64 | H-3 | 141.4 | 1.5 | F-23 | 15.7 |
| Comp. Ex. 5 | 0.43 | H-1 | 145.7 | 2.08 | F-23 | 11.9 |
| Comp. Ex. 6 | 0.57 | H-1 | 142.3 | 1.59 | F-23 | 11.6 |
| Comp. Ex. 7 | 0.43 | H-1 | 149.7 | 2.08 | F-23 | 12.2 |
| Comp. Ex. 8 | 0.43 | H-1 | 141.8 | 2.08 | F-23 | 11.6 |

**Table 1-3**

| | Heating temperature after coating HTL (°C) | Heating time after coating HTL (min) | Solvent amount (µg/mm3) | Initial Pmax1 (µW) | Pmax retention rate in 60°C environment (%) | Pmax retention rate in -30°C environment (%) |
|---|---|---|---|---|---|---|
| Ex. 1 | 60 | 60 | 21.1 | 46.6 | 93 | 84 |
| Ex. 2 | 90 | 30 | 5.4 | 46.3 | 95 | 82 |
| Ex. 3 | 60 | 60 | 19.7 | 44.8 | 92 | 87 |
| Ex. 4 | 60 | 30 | 24.6 | 45.7 | 90 | 85 |
| Ex. 5 | 50 | 90 | 29.2 | 42.5 | 86 | 89 |
| Comp. Ex. 1 | NA | NA | 58.2 | 44.2 | 54 | 86 |
| Comp. Ex. 2 | 40 | 15 | 32.9 | 44.6 | 68 | 84 |
| Comp. Ex. 3 | 50 | 3 | 34.0 | 43.8 | 63 | 84 |
| Comp. Ex. 4 | 60 | 60 | 20.3 | 10.2 | NA | NA |
| Ex. 6 | 60 | 60 | 20.8 | 48.1 | 91 | 83 |
| Ex. 7 | 60 | 60 | 20.4 | 48.9 | 88 | 81 |
| Ex. 8 | 60 | 60 | 20.2 | 48.8 | 81 | 78 |
| Ex. 9 | 60 | 60 | 20.5 | 47.5 | 74 | 73 |
| Ex. 10 | 60 | 60 | 21.0 | 48.3 | 85 | 83 |
| Ex. 11 | 75 | 45 | 12.6 | 48.5 | 88 | 81 |
| Ex. 12 | 60 | 60 | 20.6 | 47.7 | 82 | 82 |
| Ex. 13 | 75 | 45 | 13.0 | 47.8 | 86 | 81 |
| Ex. 14 | 60 | 60 | 20.7 | 49.6 | 91 | 86 |
| Ex. 15 | 75 | 45 | 12.7 | 50.2 | 94 | 85 |
| Comp. Ex. 5 | 60 | 60 | 20.9 | 45.3 | 64 | 70 |
| Comp. Ex. 6 | 60 | 60 | 20.5 | NA | NA | NA |
| Comp. Ex. 7 | 60 | 60 | 21.0 | 42.2 | 58 | 64 |
| Comp. Ex. 8 | 60 | 60 | 20.9 | 40.6 | 56 | 67 |

It was clear from Examples of the present disclosure that the initial Pmax was high even in the different temperature environments of 60°C and -30°C and stably maintained, and excellent durability was obtained as the lithium salt having an assymetric structure was included in the hole-transporting layer, and the amount of the solvent included in the photoelectric conversion element was controlled to 5.4 to 30 µg/mm³ or less per unit volume of the hole-transporting layer. The durability test of Comparative Example 4 was suspended because the initial Pmax was low, and the tests of Comparative Example 6 were suspended because the materials were not dissolved in the composition of Comparative Example 6, and a photoelectric conversion element could not be produced.

## Claims

1. A photoelectric conversion element (101), comprising:
a first electrode (2);
a photoelectric conversion layer; and
a second electrode (7),
wherein the photoelectric conversion layer includes a hole-transporting layer (6),
the hole-transporting layer (6) includes lithium salt having an asymmetric structure, and **characterized in that** an amount of a solvent per unit volume of the hole-transporting layer (6) is 5.4 to 30 µg/mm³.

2. The photoelectric conversion element (101) according to claim 1,
wherein the amount of the solvent per unit volume of the hole-transporting layer (6) is 5.4 to 25 µg/mm³.

3. The photoelectric conversion element (101) according to claim 1 or 2,
wherein the lithium salt having an asymmetric structure is represented by General Formula (1) below, 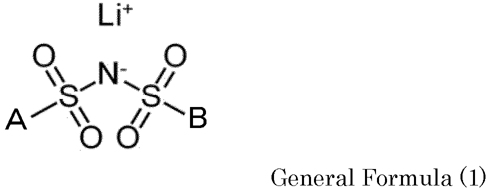
where, in General Formula (1), A and B are each a substituent selected from F, CF₃, C₂F₅, C₃F₇, and C₄F₉, and A and B are mutually different substituents.

4. The photoelectric conversion element (101) according to any one of claims 1 to 3, wherein the lithium salt is lithium(fluorosulfonyl)(trifluoromethane sulfonyl)imide.

5. The photoelectric conversion element (101) according to any one of claims 1 to 4, wherein the hole-transporting layer (6) further includes an organic p-type semiconductor material, and
the organic p-type semiconductor material is a compound represented by General Formula (4) below, 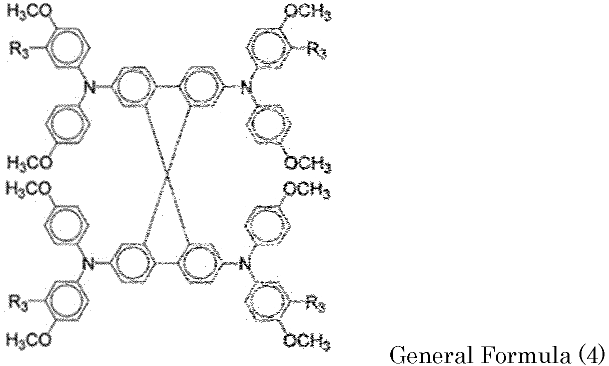
where, in General Formula (4), R₃ is a hydrogen atom or an alkyl group.

6. The photoelectric conversion element (101) according to claim 5,
wherein the organic p-type semiconductor material is a compound represented by any one of (D-1) to (D-6), (D-8) to (D-9) and (D-11) to (D-20) below:

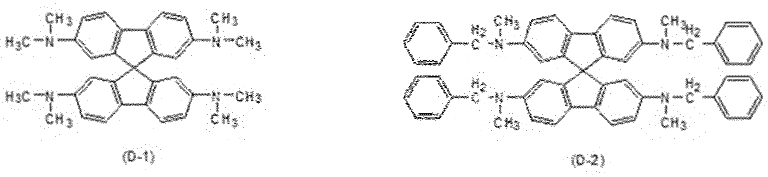

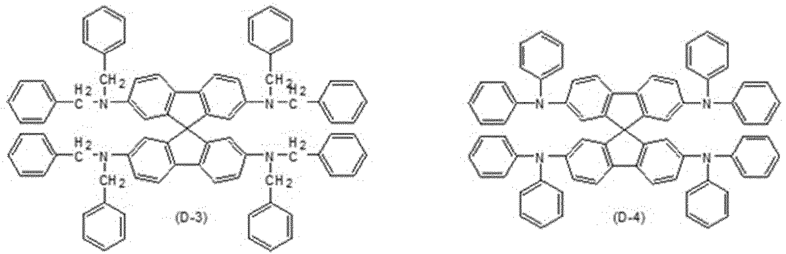

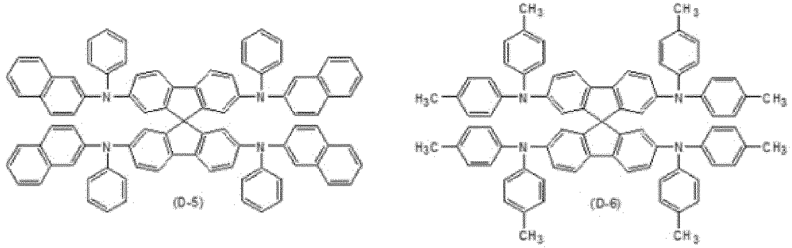

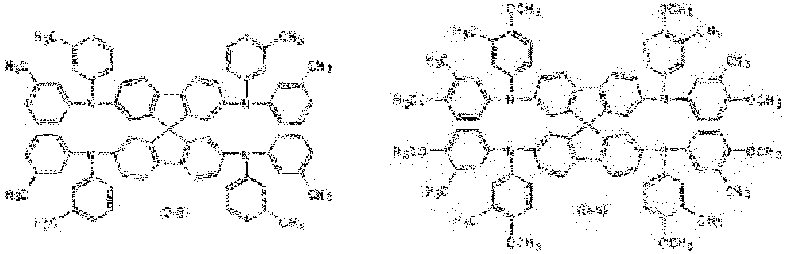

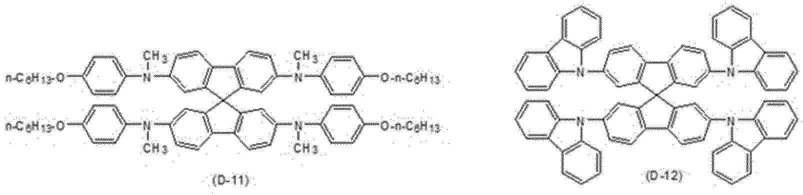

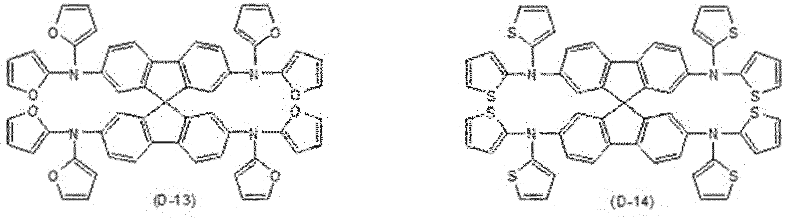

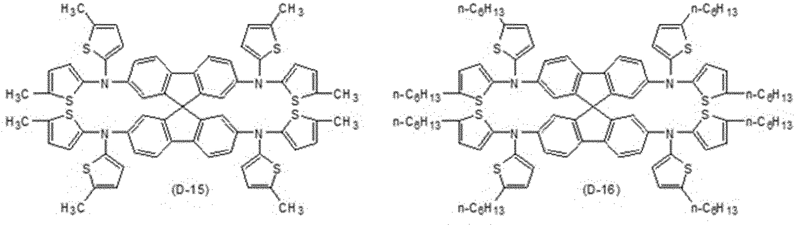

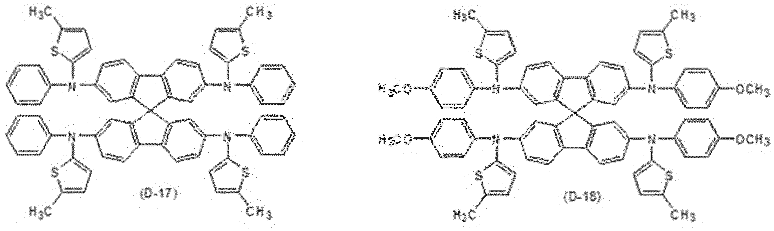

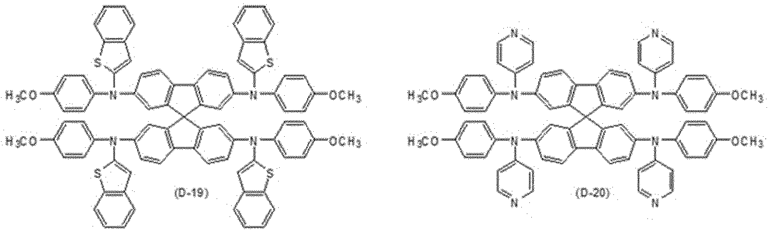

7. The photoelectric conversion element (101) according to claim 5 or 6,
wherein a molar ratio X/Y of the lithium salt to the organic p-type semiconductor material is 0.35 or greater but 0.65 or less, where X is a molar quantity of the lithium salt in the hole-transporting layer (6) and Y is a molar quantity of the organic p-type semiconductor material in the hole-transporting layer (6).

8. The photoelectric conversion element (101) according to any one of claims 1 to 7, wherein the hole-transporting layer (6) further includes a pyridine compound.

9. The photoelectric conversion element (101) according to claim 8,
wherein a molar ratio a/b of the pyridine compound to the lithium salt is less than 2.0.

10. The photoelectric conversion element (101) according to any one of claims 1 to 9, wherein the hole-transporting layer (6) further includes a divalent cobalt complex.

11. The photoelectric conversion element (101) according to any one of claims 1 to 10, further comprising
a hole-blocking layer (3),
wherein the first electrode (2), the photoelectric conversion layer, and the second electrode (7) are disposed in this order, and
the hole-blocking layer (3) is disposed between the first electrode (2) and the photoelectric conversion layer.

12. The photoelectric conversion element (101) according to any one of claims 1 to 11, further comprising
a sealing member configured to seal the photoelectric conversion layer from an external environment of the photoelectric conversion element.

13. The photoelectric conversion element (101) according to any one of claims 1 to 12, wherein the solvent is chlorobenzene.

14. A photoelectric conversion module, comprising
a plurality of the photoelectric conversion elements (101) according to any one of claims 1 to 13,
wherein the photoelectric conversion elements (101) disposed next to one another are electrically connected in series or parallel.

15. An electronic device, comprising:
the photoelectric conversion element (101) according to any one of claims 1 to 13, or the photoelectric conversion module according to claim 14; and
a device driven by electricity generated through photoelectric conversion performed by the photoelectric conversion element (101) or the photoelectric conversion module.

16. An electronic device, comprising:
the photoelectric conversion element (101) according to any one of claims 1 to 13, or the photoelectric conversion module according to claim 14;
a battery cell capable of storing electricity generated through photoelectric conversion performed by the photoelectric conversion element (101) or the photoelectric conversion module; and
a device driven by the power stored in the storage battery cell.

17. A method for producing a photoelectric conversion element (101), the method comprising:
forming a photoelectric conversion layer including a hole-transporting layer (6) on a first electrode (2); and
controlling an amount of a solvent in the hole-transporting layer (6),
wherein the hole-transporting layer (6) includes lithium salt having an asymmetric structure and **characterized in that** the amount of the solvent per unit volume of the hole-transporting layer (6) is 5.4 to 30 µg/mm³.

## Patentansprüche

1. Fotoelektrisches Wandlungselement (101), umfassend:
eine erste Elektrode (2);
eine fotoelektrische Wandlungsschicht; und
eine zweite Elektrode (7),
wobei die fotoelektrische Wandlungsschicht eine Löchertransportschicht (6) einschließt,
wobei die Löchertransportschicht (6) ein Lithiumsalz mit asymmetrischer Struktur einschließt,
**dadurch gekennzeichnet, dass**:
eine Menge eines Lösungsmittels pro Volumeneinheit der Löchertransportschicht (6) 5,4 bis 30 µg/mm³ beträgt.

2. Fotoelektrisches Wandlungselement (101) nach Anspruch 1,
wobei die Menge des Lösungsmittels pro Volumeneinheit der Löchertransportschicht (6) 5,4 bis 25 µg/mm³ beträgt.

3. Fotoelektrisches Wandlungselement (101) nach Anspruch 1 oder 2,
wobei das Lithiumsalz mit asymmetrischer Struktur durch die nachstehende allgemeine Formel (1) dargestellt wird, 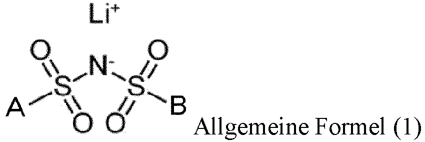
wobei in der allgemeinen Formel (1) A und B jeweils ein Substituent sind, der aus F, CF₃, C₂F₅, C₃F₇ und C₄F₉ ausgewählt ist, und A und B voneinander verschiedene Substituenten sind.

4. Fotoelektrisches Wandlungselement (101) nach einem der Ansprüche 1 bis 3, wobei das Lithiumsalz Lithium(fluorsulfonyl)(trifluormethansulfonyl)imid ist.

5. Fotoelektrisches Wandlungselement (101) nach einem der Ansprüche 1 bis 4, wobei die Löchertransportschicht (6) ferner ein organisches p-Halbleitermaterial einschließt, und
das organische p-Halbleitermaterial eine Verbindung ist, die durch die nachstehende allgemeine Formel (4) dargestellt wird, 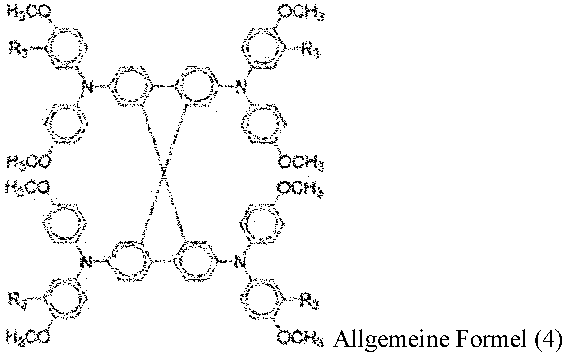
wobei in der allgemeinen Formel (4) R₃ ein Wasserstoffatom oder eine Alkylgruppe ist.

6. Fotoelektrisches Wandlungselement (101) nach Anspruch 5,
wobei das organische p-Halbleitermaterial eine Verbindung ist, die durch eine der nachstehenden Formeln (D-1) bis (D-6), (D-8) bis (D-9) und (D-11) bis (D-20) dargestellt wird:

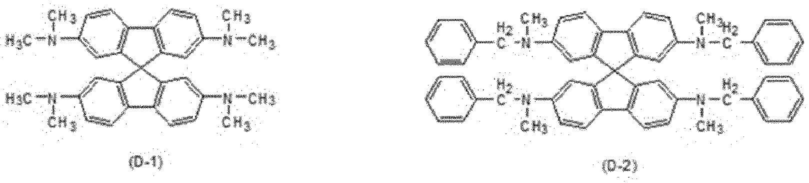

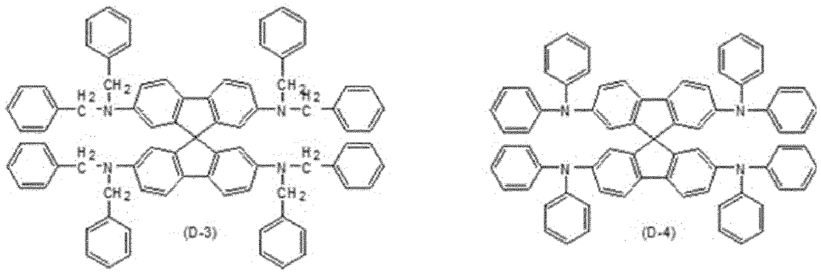

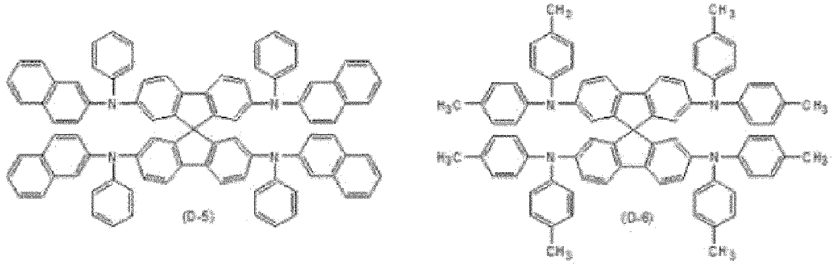

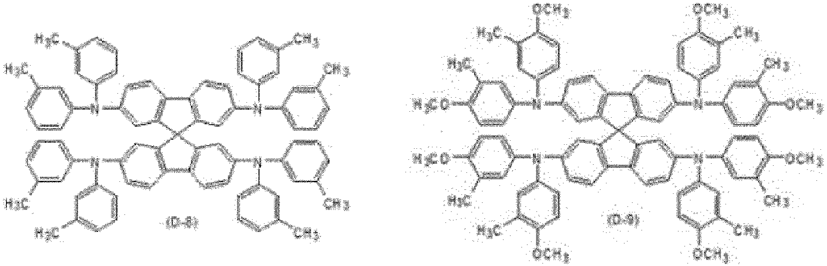

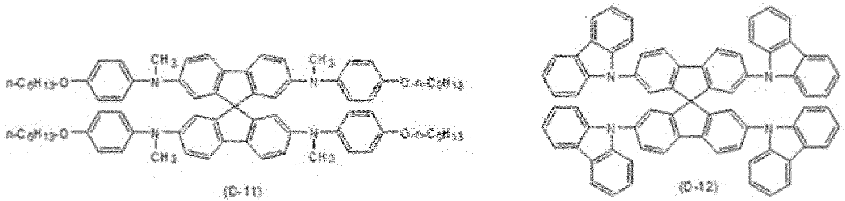

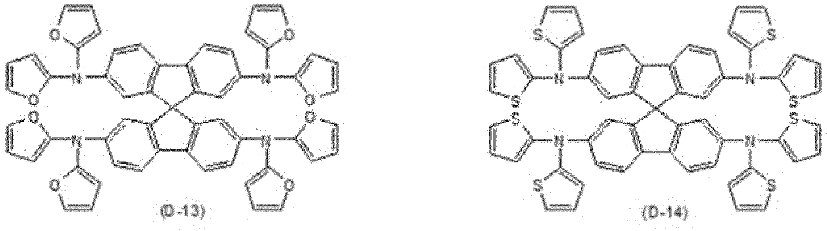

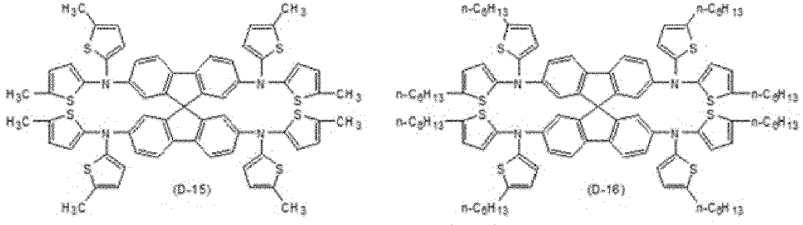

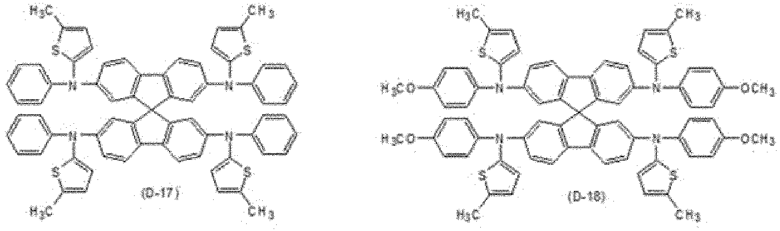

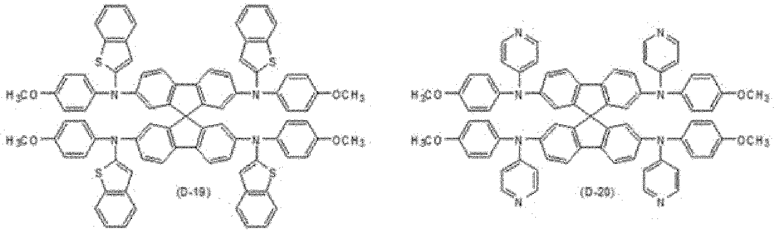

7. Fotoelektrisches Wandlungselement (101) nach Anspruch 5 oder 6,
wobei ein Stoffmengenverhältnis X/Y des Lithiumsalzes zu dem organischen p-Halbleitermaterial 0,35 oder größer, aber 0,65 oder weniger beträgt, wobei X eine molare Menge des Lithiumsalzes in der Löchertransportschicht (6) und Y eine molare Menge des organischen p-Halbleitermaterials in der Löchertransportschicht (6) ist.

8. Fotoelektrisches Wandlungselement (101) nach einem der Ansprüche 1 bis 7, wobei die Löchertransportschicht (6) ferner eine Pyridinverbindung einschließt.

9. Fotoelektrisches Wandlungselement (101) nach Anspruch 8,
wobei ein Stoffmengenverhältnis a/b der Pyridinverbindung zu dem Lithiumsalz weniger als 2,0 beträgt.

10. Fotoelektrisches Wandlungselement (101) nach einem der Ansprüche 1 bis 9, wobei die Löchertransportschicht (6) ferner einen zweiwertigen Kobaltkomplex einschließt.

11. Fotoelektrisches Wandlungselement (101) nach einem der Ansprüche 1 bis 10, ferner
eine Löchersperrschicht (3) umfassend,
wobei die erste Elektrode (2), die fotoelektrische Wandlungsschicht und die zweite Elektrode (7) in dieser Reihenfolge angeordnet sind, und
die Löchersperrschicht (3) zwischen der ersten Elektrode (2) und der fotoelektrischen Wandlungsschicht angeordnet ist.

12. Fotoelektrisches Wandlungselement (101) nach einem der Ansprüche 1 bis 11, ferner umfassend:
ein Dichtungselement, das dafür konfiguriert ist, die fotoelektrische Wandlungsschicht gegenüber einer äußeren Umgebung des fotoelektrischen Wandlungselements abzudichten.

13. Fotoelektrisches Wandlungselement (101) nach einem der Ansprüche 1 bis 12, wobei das Lösungsmittel Chlorbenzol ist.

14. Fotoelektrisches Wandlungsmodul, umfassend:
eine Vielzahl der fotoelektrischen Wandlungselemente (101) nach einem der Ansprüche 1 bis 13,
wobei die nebeneinander angeordneten fotoelektrischen Wandlungselemente (101) elektrisch in Reihe oder parallel geschaltet sind.

15. Elektronische Vorrichtung, umfassend:
das fotoelektrische Wandlungselement (101) nach einem der Ansprüche 1 bis 13 oder das fotoelektrische Wandlungsmodul nach Anspruch 14; und
eine Vorrichtung, die durch Elektrizität betrieben wird, die durch fotoelektrische Wandlung erzeugt wird, die durch das fotoelektrische Wandlungselement (101) oder das fotoelektrische Wandlungsmodul durchgeführt wird.

16. Elektronische Vorrichtung, umfassend:
das fotoelektrische Wandlungselement (101) nach einem der Ansprüche 1 bis 13 oder das fotoelektrische Wandlungsmodul nach Anspruch 14;
eine Batteriezelle, die zum Speichern von Elektrizität imstande ist, die durch fotoelektrische Wandlung erzeugt wird, die durch das fotoelektrische Wandlungselement (101) oder das fotoelektrische Wandlungsmodul durchgeführt wird; und
eine Vorrichtung, die durch die in der Speicherbatteriezelle gespeicherte Energie betrieben wird.

17. Verfahren zur Herstellung eines fotoelektrischen Wandlungselements (101), wobei das Verfahren umfasst:
Ausbilden einer fotoelektrischen Wandlungsschicht, die eine Löchertransportschicht (6) einschließt, auf einer ersten Elektrode (2); und
Steuern einer Menge eines Lösungsmittels in der Löchertransportschicht (6),
wobei die Löchertransportschicht (6) ein Lithiumsalz mit asymmetrischer Struktur einschließt und **dadurch gekennzeichnet ist, dass**:
die Menge des Lösungsmittels pro Volumeneinheit der Löchertransportschicht (6) 5,4 bis 30 µg/mm³ beträgt.

## Revendications

1. Élément de conversion photoélectrique (101), comprenant :
une première électrode (2),
une couche de conversion photoélectrique, et
une deuxième électrode (7) ;
ladite couche de conversion photoélectrique incluant une couche de transport de trous (6),
ladite couche de transport de trous (6) incluant du sel de lithium de structure asymétrique ;
**caractérisé en ce que**
la quantité d'un solvant par unité de volume de la couche de transport de trous (6) va de 5,4 à 30 µg/mm³.

2. Élément de conversion photoélectrique (101) selon la revendication 1,
dans lequel la quantité de solvant par unité de volume de la couche de transport de trous (6) va de 5,4 à 25 µg/mm³.

3. Élément de conversion photoélectrique (101) selon la revendication 1 ou 2,
dans lequel le sel de lithium de structure asymétrique est représenté par la formule générale (1) ci-dessous, 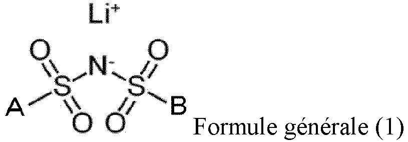
où, dans la formule générale (1) A et B représentent chacun un substituant choisi parmi F, CF₃, C₂F₅, C₃F₇ et C₄F₉, et A et B représentent des substituants différents l'un de l'autre.

4. Élément de conversion photoélectrique (101) selon l'une quelconque des revendications 1 à 3, dans lequel le sel de lithium est du lithium(fluorosulfonyl)(trifluorométhanesulfonyl)imide.

5. Élément de conversion photoélectrique (101) selon l'une quelconque des revendications 1 à 4, dans lequel la couche de transport de trous (6) inclut en outre un matériau semi-conducteur organique de type p, et
le matériau organique semi-conducteur de type p est un composé représenté par la formule générale (4) ci-dessous, 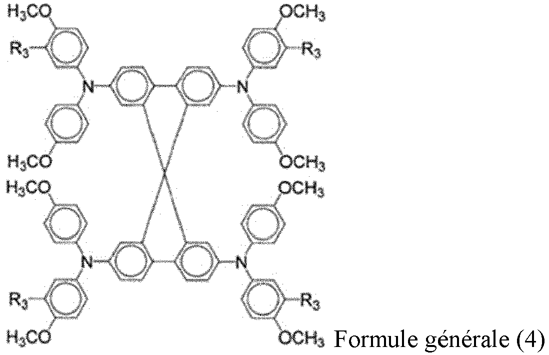
où, dans la formule générale (4) R₃ représente un atome d'hydrogène ou un groupe alkyle.

6. Élément de conversion photoélectrique (101) selon la revendication 5,
dans lequel le matériau organique semi-conducteur de type p est un composé représenté par l'une quelconque des formules (D-1) à (D-6), (D-8) et (D-9), et (D-11) à (D-20) ci-dessous :

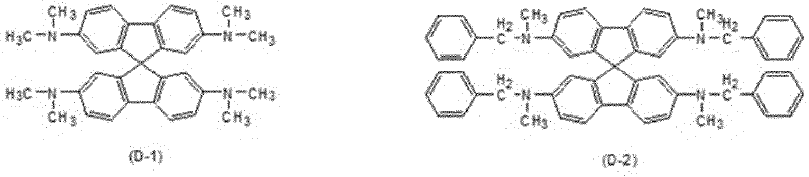

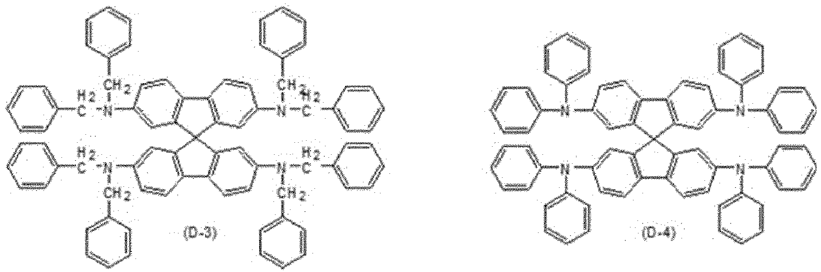

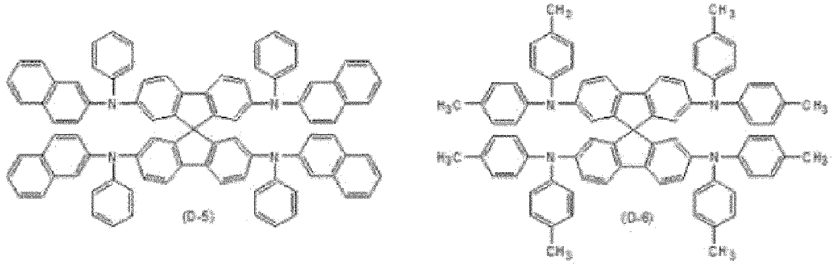

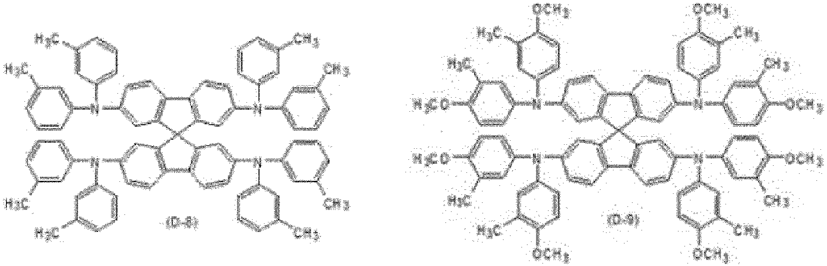

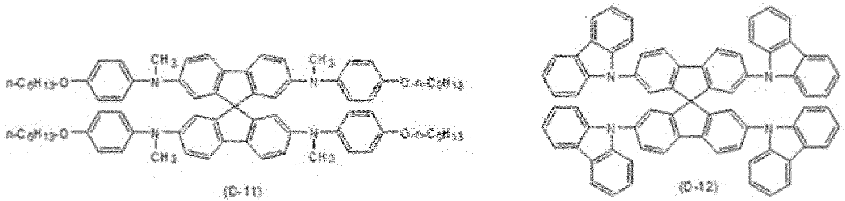

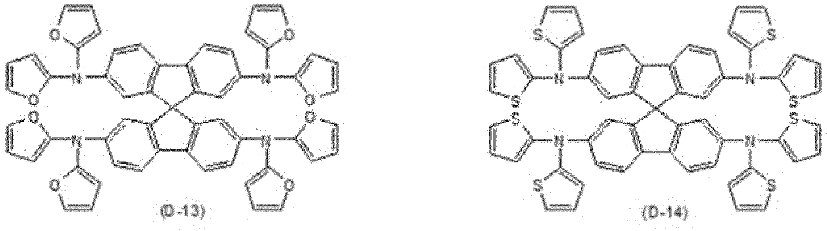

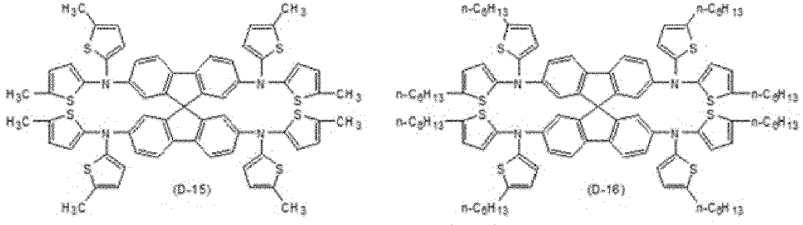

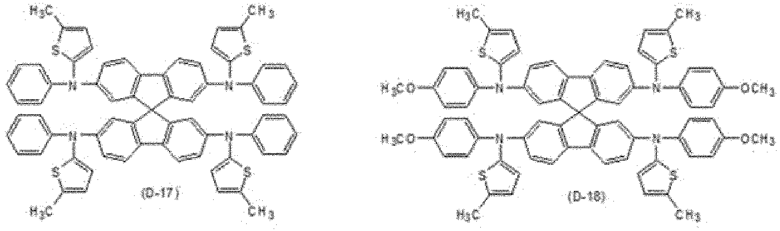

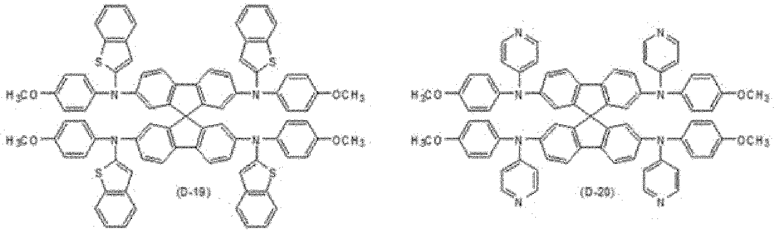

7. Élément de conversion photoélectrique (101) selon la revendication 5 ou 6,
dans lequel un rapport molaire X/Y du sel de lithium au matériau organique semi-conducteur de type p est de 0,35 ou plus, mais de 0,65 ou moins, X étant une quantité molaire du sel de lithium dans la couche de transport de trous (6) et Y une quantité molaire du matériau organique semi-conducteur de type p dans la couche de transport de trous (6).

8. Élément de conversion photoélectrique (101) selon l'une quelconque des revendications 1 à 7, dans lequel la couche de transport de trous (6) inclut en outre un composé pyridine.

9. Élément de conversion photoélectrique (101) selon la revendication 8,
dans lequel un rapport molaire a/b du composé pyridine au sel de lithium est inférieur à 2,0.

10. Élément de conversion photoélectrique (101) selon l'une quelconque des revendications 1 à 9, dans lequel la couche de transport de trous (6) inclut en outre un complexe de cobalt divalent.

11. Élément de conversion photoélectrique (101) selon l'une quelconque des revendications 1 à 10, comprenant en outre :
une couche de blocage de trous (3) ;
ladite première électrode (2), ladite couche de conversion photoélectrique et ladite deuxième électrode (7) étant disposées dans cet ordre, et
ladite couche de blocage de trous (3) étant disposée entre la première électrode (2) et la couche de conversion photoélectrique.

12. Élément de conversion photoélectrique (101) selon l'une quelconque des revendications 1 à 11, comprenant en outre :
un élément d'étanchéité configuré pour étanchéifier la couche de conversion photoélectrique d'un environnement extérieur à l'élément de conversion photoélectrique.

13. Élément de conversion photoélectrique (101) selon l'une quelconque des revendications 1 à 12, dans lequel le solvant est le chlorobenzène.

14. Module de conversion photoélectrique, comprenant :
une pluralité des éléments de conversion photoélectrique (101) selon l'une quelconque des revendications 1 à 13 ;
lesdits éléments de conversion photoélectrique (101) disposés les uns à côté des autres étant branchés électriquement en série ou en parallèle.

15. Dispositif électronique, comprenant :
l'élément de conversion photoélectrique (101) selon l'une quelconque des revendications 1 à 13, ou le module de conversion photoélectrique selon la revendication 14, et
un dispositif fonctionnant à l'électricité générée par la conversion photoélectrique effectuée par l'élément de conversion photoélectrique (101) ou le module de conversion photoélectrique.

16. Dispositif électronique, comprenant :
l'élément de conversion photoélectrique (101) selon l'une quelconque des revendications 1 à 13, ou le module de conversion photoélectrique selon la revendication 14,
une cellule de batterie capable de stocker l'électricité générée par la conversion photoélectrique effectuée par l'élément de conversion photoélectrique (101) ou le module de conversion photoélectrique, et
un dispositif fonctionnant à l'énergie stockée dans la cellule de batterie de stockage.

17. Procédé de production d'un élément de conversion photoélectrique (101), le procédé comprenant :
la formation d'une couche de conversion photoélectrique incluant une couche de transport de trous (6) sur une première électrode (2), et
le réglage d'une quantité d'un solvant dans la couche de transport de trous (6) ;
ladite couche de transport de trous (6) incluant du sel de lithium de structure asymétrique ; et **caractérisé en ce que**
la quantité de solvant par unité de volume de la couche de transport de trous (6) va de 5,4 à 30 µg/mm³.
